(19) Europäisches Patentamt
European Patent Office
Office européen des brevets

(11) EP 2 101 218 B1

(12) **EUROPEAN PATENT SPECIFICATION**

(45) Date of publication and mention of the grant of the patent:
**25.11.2015 Bulletin 2015/48**

(21) Application number: **09003388.7**

(22) Date of filing: **09.03.2009**

(51) Int Cl.:
***G03F 7/40*** (2006.01) ***G03F 7/38*** (2006.01)
***B41C 1/10*** (2006.01) ***G03F 7/031*** (2006.01)
*G03F 7/004* (2006.01)

(54) **Method for preparing a lithographic printing plate**

Verfahren zur Herstellung einer lithografischen Druckplatte

Procédé de préparation de plaque d’impression lithographique

(84) Designated Contracting States:
**AT BE BG CH CY CZ DE DK EE ES FI FR GB GR HR HU IE IS IT LI LT LU LV MC MK MT NL NO PL PT RO SE SI SK TR**

(30) Priority: **10.03.2008 JP 2008059975**

(43) Date of publication of application:
**16.09.2009 Bulletin 2009/38**

(73) Proprietor: **FUJIFILM Corporation**
**Minato-ku**
**Tokyo (JP)**

(72) Inventor: **Oohashi, Hidekazu**
**Shizuoka (JP)**

(74) Representative: **Hoffmann Eitle**
**Patent- und Rechtsanwälte PartmbB**
**Arabellastraße 30**
**81925 München (DE)**

(56) References cited:
**EP-A- 1 157 829**
**EP-A- 1 281 516**
**EP-A- 1 582 347**
**EP-A- 1 630 618**
**EP-A- 1 661 696**
**WO-A-2006/026229**
**JP-A- 2007 283 656**
**US-A1- 2002 051 931**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 101 218 B1

## Description

FIELD OF THE INVENTION

The present invention relates to a lithographic printing plate precursor which is capable of undergoing a so-called direct plate making, in which the plate making is directly conducted based on digital signals, for example, from a computer using various kinds of lasers, particularly, to a lithographic printing plate precursor suitable for a simple processing, and a method of preparing a lithographic printing plate.

BACKGROUND OF THE INVENTION

A solid laser, semiconductor laser and gas laser having a large output and a small size, which radiate an ultraviolet ray, visible light or infrared ray having a wavelength of 300 to 1,200 nm, have become easily available, and these lasers are very useful for recording light sources used in the direct plate making based on digital data, for example, from a computer. Various investigations on recording materials sensitive to such various laser beams have been made. Typical examples thereof include firstly recording materials capable of being recorded with an infrared laser having a wavelength of not less than 760 nm, for example, positive type recording materiaLs described in U.S. Patent 4,708,925 and acid catalyst crosslinking type negative type recording materials described in JP-A-8-276558 (the term "JP-A" as used herein means an "unexamined published Japanese patent application"), and secondly recording materials responsive to an ultraviolet ray or visible light laser having a wavelength of 300 to 700 nm, for example, radical polymerization type negative type recording materials described in U.S. Patent 2,850,445 and JP-B-44-20189 (the term "JP-B" as used herein means an "examined Japanese patent publication").

Further, with respect to hitherto known lithographic printing plate precursors (hereinafter, also referred to as PS plates), a step of removing the non-image area by dissolution (development processing) after imagewise exposure is indispensable and a post-processing step, for example, washing the printing plate after the development processing with water, treatment of the printing plate after the development processing with a rinse solution containing a surfactant or treatment of the printing plate after the development processing with an oil-desensitizing solution containing gum arabic or a starch derivative, is also necessary. The point that such additional wet treatments are indispensable is a large subject of investigation in hitherto known PS plates. Even when the first half (image-forming process) of plate making process is simplified by the above-described digital processing, the effects due to the simplification is still insufficient as long as the last half (development processing) is the troublesome wet treatment.

Particularly, the consideration for global environment has become a great concern throughout the field of industry in recent years. In view of the consideration for global environment, a treatment with a developer closer to a neutral range and a small amount of waste liquid are subjects of further investigations. Further, it is desirable that the wet type post-processing is simplified or changed to a dry processing.

From this viewpoint, as one method for eliminating the processing step, a method referred to as on-press development wherein an exposed printing plate precursor is mounted on a cylinder of a printing machine and the non-image area of the printing plate precursor is removed by supplying dampening water and ink while rotating the cylinder is known. Specifically, according to the method, the printing plate precursor is exposed and mounted on a printing machine as it is to complete development processing in a conventional process of printing.

A lithographic printing plate precursor suitable for the on-press development is required to have an image-forming layer soluble in dampening water or an ink solvent and a bright room handling property suitable for development on a printing machine placed in a bright room. However, it is substantially impossible for hitherto known PS plates to fulfill such requirements.

In order to fulfill such requirements, a lithographic printing plate precursor having provided on a hydrophilic support an image-forming layer in which fine particles of thermoplastic hydrophobic polymer are dispersed in a hydrophilic binder polymer is proposed (see, for example, Japanese Patent 2,938,397). In the plate-making, the lithographic printing plate precursor is exposed to an infrared laser to agglomerate (fuse) the fine particles of thermoplastic hydrophobic polymer by heat generated by light-to-heat conversion thereby forming an image, and mounted on a cylinder of a printing machine to carry out on-press development by supplying at least any one of dampening water and ink. Since the lithographic printing plate precursor has the sensitive zone in an infrared region, it has also the handling property in a bright room.

However, the image formed by the agglomeration (fusion) of the fine particles of thermoplastic hydrophobic polymer is insufficient in strength and has a problem of printing durability as a printing plate.

Lithographic printing plate precursors including microcapsules containing a polymerizable compound incorporated therein in stead of the thermoplastic fine particles are also proposed (see, for example, JP-A-2000-211262, JP-A-2001-277740, JP-A-2002-29162, JP-A-2002-46361, JP-A-2002-137562 and JP-A-2002-326470). In the lithographic printing plate precursors according to such a proposal, it is advantageous that the polymer image formed by a reaction

of the polymerizable compound is excellent in the strength in comparison with the image formed by the fusion of the fine particles.

Also, since the polymerizable compound has high reactivity, many proposals for isolation of the polymerizable compound using microcapsules have been made. Further, it has been proposed to use a thermally degradable polymer in a shell of the microcapsule.

However, in the hitherto known lithographic printing plate precursors described in Japanese Patent 2,938,397, JP-A-2000-211262, JP-A-2001-277740, JP-A-2002-29162, JP-A-2002-46361, JP-A-2002-137562 and JP-A-2002-326470, printing durability of the image formed by laser exposure is insufficient and further improvements have been requested. Specifically, in such a lithographic printing plate precursor of a simple processing type, a support having a surface of high hydrophilicity is used in order to make possible development with an aqueous solution having pH of 10 or less or dampening water (ordinarily nearly neutral) on a printing machine and as a result, the image area is apt to be removed from the support by dampening water during printing so that sufficient printing durability can not be obtained. On the contrary, when the surface of support renders hydrophobic, ink also adheres on the non-image area during printing to cause printing stain. Thus, it is extremely difficult to achieve a good balance between the printing durability and the stain resistance and a lithographic printing plate precursor of a simple processing type which provides good stain resistance and sufficient printing durability has not yet been known.

WO 2006/026229 A aims at providing a development system for lithographic printing plate precursors using a neutral developer, capable of preventing the non-image area of the resulting printing plates from being stained. In developing a lithographic printing plate precursor with a neutral developer having a pH of from 5.8 to 8.6, ultrasonic waves and/or an electric current are imparted to the neutral developer.

US 2002/051931 relates to a supports for a printing plate, comprising a substrate having thereon at least one component layer that contains porous particles. The component layer further contains a flaky inorganic particles or a material having the function of converting light to heat. A printing plate comprising the support is also disclosed, having on the support an image forming layer containing a thermally fusible particles.

EP 1 630 618 describes a lithographic printing method, which is a method for producing a lithographic printing plate, comprising: imagewise exposing a lithographic printing plate precursor comprising a support, an image recording layer and a protective layer, and rubbing the plate surface by a rubbing member of an automatic processor in the presence of a developer at a pH of 2 to 10 to remove the protective layer and the image recording layer in the unexposed area. Also described is a lithographic printing plate precursor comprising a support, an image recording layer removable with a printing ink and/or a fountain solution, and a protective layer containing a polyvinyl alcohol having a carboxyl group and/or a sulfonic acid group within the molecule, as well as a lithographic printing method comprising on-press development.

EP 1 582 347 relates to a lithographic printing plate precursor capable of forming an image without undergoing alkali development, which comprises a hydrophilic support and a laser-sensitive photopolymerizing layer, wherein the photopolymerizing layer contains a polymer compound having at least one of an ether group, an ester group and an amido group in its molecule, particularly, in its side chain.

JP-A-2007-283656 discloses a plate making method of a lithographic printing plate according to the preamble of claim 1.

## SUMMARY OF THE INVENTION

Therefore, an object of the present invention is to provide a lithographic printing plate precursor capable of being subjected to a direct plate making based on digital data, for example, from a computer, by image-recording using a solid laser or semiconductor laser radiating an ultraviolet ray or visible light, particularly, a lithographic printing plate precursor which can be developed with an aqueous solution having pH of 10 or less, is excellent in developing property, has high sensitivity and can provide a lithographic printing plate exhibiting high printing durability and good stain resistance, and a method of preparing a lithographic printing plate using the lithographic printing plate precursor.

As a result of the intensive investigations, the inventors have found that the above-described object can be achieved by using a plate making method described below.

Specifically, the present invention includes the following items.

<1> A plate making method of a lithographic printing plate comprising exposing imagewise a lithographic printing plate precursor comprising a support having thereon at least an image-forming layer containing a binder polymer, a radical polymerizable compound, a polymerization initiator, a sensitizing dye and a fine beat-fusible resin particle, developing the exposed lithographic printing plate precursor to remove a non-image area and drying the developed lithographic printing plate precursor at heat fusion temperature of the fine heat-fusible resin particle or higher.

<2> The plate making method of a lithographic printing plate as described in <1> above, which comprises between the imagewise exposure and the development, heating the exposed lithographic printing plate precursor at temperature lower than the heat fusion temperature of the fine heat-fusible resin particle.

<3> The plate making method of a lithographic printing plate as described in <2> above, which comprises between the imagewise exposure and the development, heating the exposed lithogaphic printing plate precursor at temperature at least 5°C lower than the heat fusion temperature of the fine heat-fusible resin particle.

<4> The plate making method of a lithographic printing plate as described in any one of <1> to <3> above, which comprises after the development of the exposed lithographic printing plate precursor to remove a non-image area, drying the developed lithographic printing plate precursor at temperature at least 10°C higher than the heat fusion température of the fine heat-fusible resin particle.

<5> The plate making method of a lithographic printing plate as described in any one of <1> to <4> above, wherein the development is conducted in an aqueous salution having pH of2 to 10.

<6> The plate making method of a lithographic printing plate as described in any one of <1> to <5> above, wherein the fine heat-fusible resin particle has an average particle size of 10 to 2,000 nm.

<7> The plate making method of a lithographic printing plate as described in any one of <1> to <6> above, wherein the fine heat-fusible resin particle has the heat fusion temperature of 70°C or higher.

<8> The plate making method of a lithographic printing plate as described in any one of <1> to <7> above, wherein the fine heat-fusible resin particle has a functional group reacting with the binder polymer.

<9> The plate making method of a lithographic printing plate as described in any oae of <1> to <8> above, wherein the binder polymer has a hydrophilic group.

<10> The plate making method of a lithographic pointing plate as described in <9> above, wherein the hydrophilic group is at least one member selected from an amido group, a hydroxy group, a salt formed by neutralization of an acid group with an amino group, a tertiary amino group, a salt formed by neutralization of an amino group with an acid and a quaternary ammonium group.

<11> The plate making method of a Lithographic printing plate as described in any one of <1> to <10> above, wherein the sensitizing dye absorbs light of 350 to 450 nm.

The function of the invention is presumed as follows. Specifically, by using a hydrophilic image-forming layer incorporating a fine heat-fusible resin particle and controlling drying temperature after development, a hydrophobic heat-fused film is formed in the image area. Thus, hydrophobicity of the image-forming layer increases and penetration of dampening water into the image-forming layer during printing is prevented to achieve high printing durability. In the non-image area, on the other hand, since the fine heat-fusible resin particle is maintained in its particle morphology, it can be easily removed at the development and does not remain in the non-image area to achieve high stain resistance in the non-image area.

According to the present invention, a lithographic printing plate precursor which is capable of undergoing a so-called direct plate making, in which the plate making is directly conducted based on digital signals, for example, from a computer using various kinds of lasers and exhibits high productivity, particularly, a lithographic printing plate precursor of a simple processing type which provides good printing durability and good stain resistance can be provided.

## BRIEF DESCRIPTION OF THE DRAWINGS

Fig. 1 is an illustration for showing a method of determining a heat fusion temperature of a fine resin particle.
Fig. 2 is an illustration for showing a structure of an automatic development processor.

[Description of reference numerals and signs]

1: Transport roller pair
2: Transport roller pair
3: Rotating brush roller
4: Transport roller pair
5: Transport roller pair
6: Rotating brush roller
7: Rotating brush roller
8: Transport roller pair
9: Transport roller pair
10: Backing roller

11: Transport roller pair
12: Transport roller pair
13: Transport roller pair

DETAILED DESCRIPTION OF THE INVENTION

In the specification, with respect to the description of a group in a compound represented by a formula, when the group is not indicated whether substituted or unsubstituted, unless otherwise indicated specifically, the group includes not only the unsubstituted group but also the substituted group, if the group is able to have a substituent. For example, the description "R represents an alkyl group, an aryl group or a heterocyclic group" in a formula means that "R represents an unsubstituted alkyl group, a substituted alkyl group, an unsubstituted aryl group, a substituted aryl group, an unsubstituted heterocyclic group or a substituted heterocyclic group".

The plate making method of a lithographic printing plate according to the invention will be described in detail below.

The lithographic printing plate precursor for use in the plate making method according to the invention is a lithographic printing plate precursor comprising at least an image-forming layer containing a binder polymer, a radical polymerizable compound, a polymerization initiator, a sensitizing dye and a fine heat-fusible resin particle. The lithographic printing plate precursor is described in more detail below.

[Image-forming layer]

<Binder polymer>

The binder polymer for use in the lithographic printing plate precursor according to the invention is not particularly restricted and is preferably a polymer compound with high affinity for water. In particular, solubility in distilled water at 25°C is preferably 0.1 g/l or more, more preferably 0.5 g/l or more, and particularly preferably 1.0 g/l or more.

Also, from the standpoint of compatibility with the fine heat-fusible resin particle and developing property, a binder polymer having a hydrophilic group is preferable. The hydrophilic group is selected from monovalent and divalent or more valent hydrophilic groups, and preferably includes, for example, a hydroxy group, a sulfonic acid group, an alkylene oxy group (for example, an ethylene oxy group or a propylene oxy group), a primary amino group, a secondary amino group, a tertiary amino group, a salt formed by neutralization of each of these amino groups with an acid, a quaternary ammonium group, an amido group, an ether group, a salt formed by neutralization of an acid, for example, carboxylic acid, sulfonic acid or phosphoric acid and a heterocyclic group containing a positively charged nitrogen atom. A primary amino group, a secondary amino group, a tertiary amino group, a salt formed by neutralization of each of these amino groups with an acid, a quaternary ammonium group, an amido group, a hydroxy group, a repeating unit of $-CH_2CH_2O-$, a repeating unit of $-CH_2CH_2NH-$ and a pyridinium group are more preferable, and an amido group, a hydroxy group, a salt formed by neutralization of an acid with an amine, a tertiary amino group, a salt formed by neutralization of an amino group with an acid and a quaternary ammonium group are most preferable.

As the skeleton of the binder polymer, a polymer selected from an acrylic resin, a vinyl resin, a urethane resin, an amide resin, an epoxy resin, a methacrylic resin, a styrene resin and an ester resin is preferable. Among them, a vinyl copolymer, for example, an acrylic resin, a methacrylic resin or a styrene resin, a urethane resin, an amide resin and an ester resin are particularly preferable.

From the standpoint of developing property and printing durability, the binder polymer for use in the invention preferably has a weight average molecular weight of 600 to 200,000, and more preferably has an acid value of 0.5 to 20 mmol/g or a hydroxy group value of 0.1 to 22 mmol/g.

It is preferred that the binder polymer used in the lithographic printing plate precursor for use in the plate making method according to the invention further has a radical polymerizable functional group. Examples of the radical polymerizable functional group include an ethylenically unsaturated double bond, for example, an acrylic acid group, a methacrylic acid group, a styrene group, an allyl group, an itaconic acid group, a fumaric acid group, a maleic acid group or a maleimido group and a chain transferable group, for example, a thiol group or an aminoacetic acid group.

The amount of the binder polymer added to the image-forming layer is preferably from 20 to 80% by weight, more preferably from 25 to 75% by weight, particularly preferably from 30 to 70% by weight, based on the total solid content of the image-forming layer.

<Fine heat-fusible resin particle>

The fine heat-fusible resin particle for use in the invention is a fine particle of hydrophobic resin and any fine particles capable of being fused to each other by heat can be preferably used. As the hydrophobic resin, any water-insoluble resin can be preferably used. Examples of the hydrophobic resin include an acrylic resin, a methacrylic resin, a styrene resin, a vinyl resin, an ester resin, a urethane resin, a urea resin, an amide resin, an ether resin, a novolac resin and a carbonate resin. Of these resins, an acrylic resin, a methacrylic resin, a styrene resin, a vinyl resin, a urethane resin and a novolac resin are preferable, and an acrylic resin, a methacrylic resin, a styrene resin and a novolac resin are more preferable. It is preferred that the resin has a functional group (hereinafter also abbreviated as a reactive group) capable of reacting with other component or other fine heat-fusible resin particle in the image-forming layer. Specific examples of the reactive group include an active ester group (for example, an N-hydroxyphthalimide ester group, an N-hydroxysuccinimide ester, a p-nitrophenyl ester group, a p-chlorophenyl ester group, a p-methoxycarbonylphenyl ester group, a p-sulfoniumphenyl ester group or a HCH(OMe)COOMe group), a functional group having an active hydrogen atom (for example, a hydroxy group, an amino group having at least one hydrogen atom, a thiol group, a hydrazine group, a hydrazide group or an amido group), an acid anhydride group, an acid halide group, a leaving group for causing a nucleophilic substitution reaction (for example, a halogen group, an alkylsulfonyloxy group, an arylsulfonyloxy group or an azide group), a nucleophilic group (for example, a hydroxy group, an amino group, a thiol group, a hydrazine group, a hydrazide group, an amido group, a sulfide group or a phosphino group), a reactive group undergoing dehydration condensation [for example, a heterocyclic group having an unsaturated bong in its ring (for example, an N-alkylindole group, an N-alkylpyrrole group, N-alkylimidazole group, a furan group or an oxazole group), a carbonyl group, a heterocyclic group having an unsaturated bong in its ring and an acetal group, a phenol group having an active hydrogen atom in its ortho position, a phenol group having a hydroxymethyl group in its ortho position, an aniline group having a hydroxymethyl group in its ortho position, a carboxyl group, an N-methylol group, an N-alkoxymethyl group, a functional group having an active hydrogen atom, a hydrazide group, a primary amino group, a hydrazine group, a ketimine group or an ester group], a diazo group and an active methylene group, but the invention should not be construed as being limited thereto.

The fine heat-fusible resin particle for use in the invention is the hydrophobic resin as described above having the particle morphology. As for a method of microparticulation of the hydrophobic resin, the fine particle can be obtained by emulsion polymerization of suspension polymerization of a monomer or can be obtained by dissolving the hydrophobic resin in an organic solvent, emulsifying or dispersing together with an emulsifying agent or dispersing agent in water, and evaporating the organic solvent

The solvent used for preparation of the hydrophobic resin or fine particle thereof according to the invention includes, for example, tetrahydrofuran, ethylene dichloride, cyclohexanone, methyl ethyl ketone, acetone, methanol, ethanol, ethylene glycol monomethyl ether, ethylene glycol monoethyl ether, 2-methoxyethyl acetate, diethylene glycol dimethyl ether, 1-methoxy-2-propanol, 1-methoxy-2-propyl acetate, N,N-dimethylformamide, N,N-dimethylacetamide, toluene, ethyl acetate, ethyl lactate, methyl lactate, dimethylsulfoxide and water. The solvents may be used individually or as a mixture of two or more thereof.

The average particle size of the fine heat-fusible resin particle is preferably from 10 to 2,000 nm, more preferably from 30 to 1,000 nm, and particularly preferably from 40 to 700 nm.

The heat fusion temperature of the fine heat-fusible resin particle is preferably 70°C or higher, more preferably from 70 to 200°C, particularly preferably from 75 to 175°C, and most preferably from 80 to 150°C.

The method of measuring the heat fusion temperature of the fine resin particle is described below.

(a) Fine resin particles (solid) are put on a copper plate placed on a heater and a cover glass is put over the fine resin particles. (b) On the glass plate, a stylus of pressure detector (small capacity bending beam type UL-100GR, produced by Minebea Co., Ltd.) is placed and an appropriate pressure (about 100gf) is applied. (c) Heating of the heater is initiated (temperature rise rate: 10°C/min) and variations of temperature and a pressure value for passage of time are recorded (Fig. 1). (d) Heat fusion temperature (Ts) is calculated by data processing of a time variation curve of the pressure value.

An intersection of a tangent line of the time-pressure curve at a point (D/2) indicating a half value of the variation of pressure (D) on the time-pressure curve with a line indicating an initial pressure ($D_0$) is determined and temperature of a point where a line drawn down from the intersection crosses with the time-temperature curve is designated as the heat fusion temperature (Ts).

In case of a dispersion of fine resin particles, the fine particles are flocculated by salting out, subjected repeatedly to centrifugation, removal of supernatant and cleaning and drying at room temperature to form fine resin particles which are used for the measurement of heat fusion temperature.

The amount of the fine heat-fusible resin particle added to the image-forming layer is preferably from 5 to 80% by weight, more preferably from 10 to 75% by weight, particularly preferably from 15 to 60% by weight, based on the total solid content of the image-forming layer.

(Sensitizing dye)

The sensitizing dye for use in the image-forming layer according to the invention can be appropriately selected according to the wavelength of light source used for the image exposure, the use or the like and is not particularly restricted. For instance, an infrared absorbing agent and a sensitizing dye absorbing light of 350 to 450 nm are preferably exemplified.

<Infrared absorbing agent>

The infrared absorbing agent is a component used for increasing sensitivity to an infrared laser. The infrared absorbing agent has a function of converting an infrared ray absorbed to heat. It is preferred that the infrared absorbing agent for use in the invention is a dye or pigment having an absorption maximum in a wavelength range of 760 to 1,200 nm.

As the dye, commercially available dyes and known dyes described in literatures, for example, Senryo Binran (Dye Handbook) compiled by The Society of Synthetic Organic Chemistry, Japan (1970) can be used. Specifically, the dyes includes azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts and metal thiolate complexes.

Examples of preferable dye include cyanine dyes described, for example, in JP-A-58-125246, JP-A-59-84356 and JP-A-60-78787, methine dyes described, for example, in JP-A-58-173696, JP-A-58-181690 and JP-A-58-194595, naphthoquinone dyes described, for example, in JP-A-58-112793, JP-A-58-224793, JP-A-59-48187, JP-A-59-73996, JP-A-60-52940 and JP-A-60-63744, squarylium dyes described, for example, in JP-A-58-112792, and cyanine dyes described, for example, in British Patent 434,875.

Also, near infrared absorbing sensitizers described in U.S. Patent 5,156,938 are preferably used. Further, substituted arylbenzo(thio)pyrylium salts described in U.S. Patent 3,881,924, trimethinethiapyrylium salts described in JP-A-57-142645 (corresponding to U.S. Patent 4,327,169), pyrylium compounds described in JP-A-58-181051, JP-A-59-220143, JP-A-59-41363, JP-A-59-84248, JP-A-59-84249, JP-A-59-146063 and JP-A-59-146061, cyanine dyes described in JP-A-59-216146, pentamethinethiopyrylium salts described in U.S. Patent 4,283,475, and pyrylium compounds described in JP-B-5-13514 and JP-B-5-19702 are also preferably used. Other preferable examples of the dye include near infrared absorbing dyes represented by formulae (I) and (II) in U.S. Patent 4,756,993.

Other preferable examples of the infrared absorbing dye include specific indolenine cyanine dyes described in JP-A-2002-278057 as illustrated below,

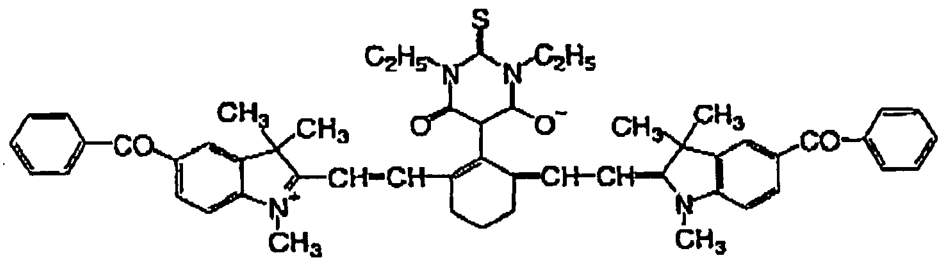

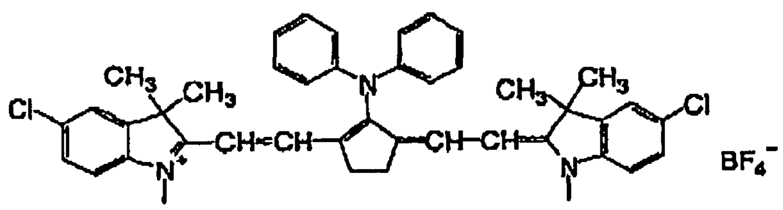

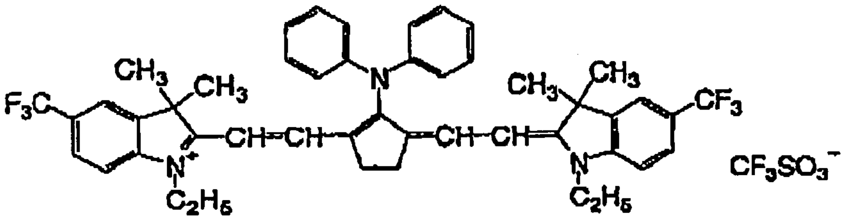

Of the dyes, cyanine dyes, squarylium dyes, pyrylium dyes, nickel thiolate complexes and indolenine cyanine dyes are particularly preferred. Further, cyanine dyes and indolenine cyanine dyes are more preferred. As a particularly preferable example of the dye, a cyanine dye represented by the following formula (A) is exemplified.

Formula (A):

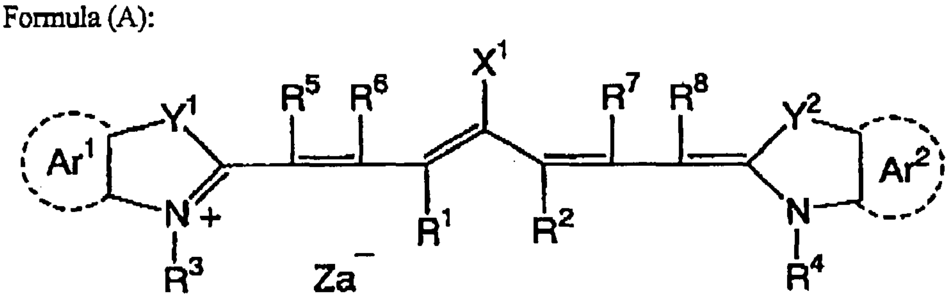

In formula (A), $X^1$ represents a hydrogen atom, a halogen atom, $-NPh_2$, $X^2-L^1$ or a group represented by formula (Ia) below. $X^2$ represents an oxygen atom, a nitrogen atom or a sulfur atom, $L^1$ represents a hydrocarbon group having from 1 to 12 carbon atoms, an aromatic cyclic group containing a hetero atom or a hydrocarbon group having from 1 to 12 carbon atoms and containing a hetero atom. The hetero atom indicates herein a nitrogen atom, a sulfur atom, an oxygen atom, a halogen atom or a selenium atom. $Xa^-$ has the same meaning as $Za^-$ defined hereinafter. $R^a$ represents a hydrogen atom, an alkyl group, an aryl group, an amino group or a halogen atom.

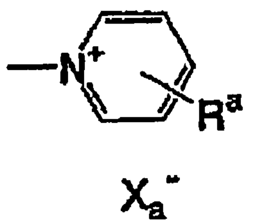

(Ia)

In formula (A), $R^1$ and $R^2$ each independently represents a hydrocarbon group having from 1 to 12 carbon atoms. In view of the preservation stability of a coating solution for image-forming layer, it is preferred that $R^1$ and $R^2$ each represents a hydrocarbon group having two or more carbon atoms, and it is particularly preferred that $R^1$ and $R^2$ are combined with each other to form a 5-membered or 6-membered ring.

$Ar^1$ and $Ar^2$, which may be the same or different, each represents an aromatic hydrocarbon group. Preferable examples of the aromatic hydrocarbon group include a benzene ring group and a naphthalene ring group. Also, preferable examples of the substituent for the aromatic hydrocarbon group include a hydrocarbon group having 12 or less carbon atoms, a halogen atom and an alkoxy group having 12 or less carbon atoms. $Y^1$ and $Y^2$, which may be the same or different, each represents a sulfur atom or a dialkylmethylene group having 12 or less carbon atoms. $R^3$ and $R^4$, which may be the same or different, each represents a hydrocarbon group having 20 or less carbon atoms. Preferable examples of the substituent for the hydrocarbon group include an alkoxy group having 12 or less carbon atoms, a carboxyl group and a sulfo group. $R^5$, $R^6$, $R^7$ and $R^8$, which may be the same or different, each represents a hydrogen atom or a hydrocarbon group having 12 or less carbon atoms. In view of the availability of raw materials, a hydrogen atom is preferred. $Za^-$ represents a counter anion. However, $Za^-$ is not necessary when the cyanine dye represented by formula (A) has an anionic substituent in the structure thereof and neutralization of charge is not needed. In view of the preservation stability of a coating solution for image-forming layer, preferable examples of the counter ion for $Za^-$ include a halogen ion, a perchlorate ion, a tetrafluoroborate ion, a hexafluorophosphate ion and a sulfonate ion, and particularly preferable examples thereof include a perchlorate ion, a hexafluorophosphate ion and an arylsulfonate ion.

Specific examples of the cyanine dye represented by formula (A), which can be preferably used in the invention, include those described in Paragraph Nos. [0017] to [0019] of JP-A-2001-133969.

Further, other particularly preferable examples include specific indolenine cyanine dyes described in JP-A-2002-278057 described above.

Examples of the pigment for use in the invention include commercially available pigments and pigments described in Colour Index (C.I.), Saishin Ganyo Binran (Handbook of the Newest Pigments) compiled by Pigment Technology Society of Japan (1977), Saishin Ganryo Oyou Giiutsu (Newest Application on Technologies for Pigments), CMC Publishing Co., Ltd. (1986) and Insatsu Ink Gijutsu (Printing Ink Technology), CMC Publishing Co., Ltd. (1984).

Examples of the pigment include black pigments, yellow pigments, orange pigments, brown pigments, red

pigments, purple pigments, blue pigments, green pigments, fluorescent pigments, metal powder pigments and polymer-bonded dyes. Specific examples of usable pigment include insoluble azo pigments, azo lake pigments, condensed azo pigments, chelated azo pigments, phthalocyanine pigments, anthraquinone pigments, perylene and perynone pigments, thioindigo pigments, quinacridone pigments, dioxazine pigments, isoindolinone pigments, quinophthalone pigments, dying lake pigments, azine pigments, nitroso pigments, nitro pigments, natural pigments, fluorescent pigments, inorganic pigments and carbon black. Of the pigments, carbon black is preferred.

The pigment may be used without undergoing surface treatment or may be used after the surface treatment. For the surface treatment, a method of coating a resin or wax on the surface, a method of attaching a surfactant and a method of bonding a reactive substance (for example, a silane coupling agent, an epoxy compound or polyisocyanate) to the pigment surface. The surface treatment methods are described in Kinzoku Sekken no Seishitsu to Oyo (Properties and Applications of Metal Soap), Saiwai Shobo, Insatsu Ink Gijutsu (Printing Ink Technology), CMC Publishing Co., Ltd. (1984), and Saishin Ganryo Oyo Gijutsu (Newest Application on Technologies for Pigments). CMC Publishing Co., Ltd. (1986).

The pigment has a particle size of preferably from 0.01 to 10 μm, more preferably from 0.05 to 1 μm, particularly preferably from 0.1 to 1 μm. In the above-described range, good stability and good uniformity of the pigment dispersion in the image-forming layer can be obtained.

For dispersing the pigment, a known dispersion technique for use in the production of ink or toner may be used. Examples of the dispersing machine include an ultrasonic dispersing machine, a sand mill, an attritor, a pearl mill, a super-mill, a ball mill, an impeller, a disperser, a KD mill, a colloid mill, a dynatron, a three roll mill and a pressure kneader. The dispersing machines are described in detail in Saishin Ganryo Oyo Gijutsu (Newest Application on Technologies for Pigments), CMC Publishing Co., Ltd. (1986). The infrared absorbing agent may be added to the image-forming layer by being incorporated into a microcapsule.

The amount of the infrared absorbing agent added is so controlled that absorbance of the image-forming layer at the maximum absorption wavelength in the wavelength region of 760 to 1,200 nm measured by reflection measurement is preferably in a range of 0.1 to 1.5, more preferably in a range of 0.2 to 12, still more preferably in a range of 0.3 to 1.0. In the above-described range, the polymerization reaction proceeds uniformly in the thickness direction of the image-forming layer and good film strength of the image area and good adhesion property of the image area to a support are achieved.

The absorbance of the image-forming layer can be controlled depending on the amount of the infrared absorbing agent added to the image-forming layer and the thickness of the image-forming layer. The measurement of the absorbance can be carried out in a conventional manner. The method for measurement includes, for example, a method of forming an image-forming layer having a thickness determined appropriately in the range necessary for a lithographic printing plate on a reflective support, for example, an aluminum plate, and measuring reflection density of the image-forming layer by an optical densitometer or a spectrophotometer according to a reflection method using an integrating sphere.

<Sensitizing dye absorbing light of 350 to 450 nm>

It is preferred that the sensitizing dye absorbing light of 350 to 450 nm is a sensitizing dye having an absorption maximum in a wavelength range of 350 to 450 nm. Such sensitizing dyes include, for example, merocyanine dyes represented by formula (I) shown below, benzopyranes or coumarins represented by formula (II) shown below, aromatic ketones represented by formula (III) shown below and anthracenes represented by formula (IV) shown below.

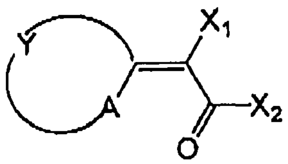

(I)

In formula (I), A represents a sulfur atom or $NR_6$, $R_6$ represents a monovalent non-metallic atomic group, Y represents a non-metallic atomic group necessary for forming a basic nucleus of the dye together with adjacent A and the adjacent carbon atom, and $X_1$ and $X_2$ each independently represents a monovalent non-metallic atomic group or $X_1$ and $X_2$ may be combined with each other to form an acidic nucleus of the dye.

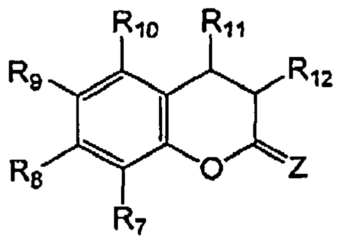

(II)

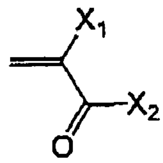

(I')

In formula (II), =Z represents an oxo group, a thioxo group, an imino group or an alkylydene group represented by partial structural formula (I') described above, $X_1$ and $X_2$ have the same meanings as defined in formula (I) respectively, and $R_7$ to $R_{12}$ each independently represents a monovalent non-metallic atomic group.

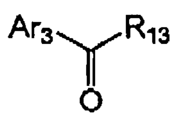

(III)

In formula (III), $Ar_3$ represents an aromatic goup or a heteroaromatic goup, and $R_{13}$ represents a monovalent non-metallic atomic group. $R_{13}$ preferably represents an aromatic group or a beteroaromatic group. Alternatively, $Ar_3$ and $R_{13}$ may be combined with each other to form a ring.

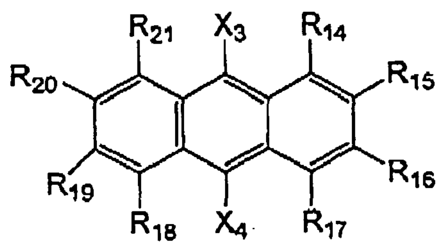

(IV)

In formula (IV), $X_3$, $X_4$ and $R_{14}$ to $R_{21}$ each independently represents a monovalent non-metallic atomic group. Preferably, $X_3$ and $X_4$ each independently represents an electron-donating group having a negative Hammett substituent constant.

In formulae (I) to (IV), preferable examples of the monovalent non-metallic atomic group represented by any one of $X_1$ to $X_4$ and $R_6$ to $R_{21}$ include a hydrogen atom, an alkyl group (for example, a methyl group, an ethyl group, a propyl group, a tert-butyl group or a cyclohexyl group), an aryl group (for example, a phenyl group or a biphenyl group), a heteroaryl group (for example, a group derived from thiophene, pyrrole or furan), an alkenyl group (for example, a vinyl group or a 1-propenyl group), an alkynyl goup (for example, an ethynyl group or a 1-propynyl group), a halogen atom (for example, -F, -Br, -Cl or -I), a hydroxy group, an alkoxy group, an aryloxy group, an acyl group, a nitrogen atom-containing group (for example, an amino group, a cyano group, a nitro group, an N-alkylamino group or an N,N-diarylamino group), a sulfur atom-containing group (for example, a mercapto group, an alkylthio group, an arylthio group, an alkyldithio group, an aryldithio group, an alkylsulfinyl group, a sulfo group ($-SO_3H$) and its conjugated base group (a sulfonato group) or an alkoxysulfonyl group) and a phosphorus atom-containing group (for example, a phosphono group ($-PO_3H_2$) and its conjugated base group (a phosphonato group) or a dialkylphosphono group ($-PO_3(alkyl)_2$). Of the monovalent non-metallic atomic groups, a hydrogen atom, an alkyl group, an aryl group, a halogen atom, an alkoxy group and an acyl group are particularly preferred

The basic nucleus of the dye formed by Y together with the adjacent A and the adjacent carbon atom in formula (I) includes, for example, a 5-membered, 6-membered or 7-membered, nitrogen-containing or sulfur-containing heterocyclic ring, and is preferably the 5-membered or 6-membered heterocyclic ring.

As the nitrogen-containing heterocyclic ring, those which are known to constitute basic nuclei in merocyanine dyes described in L.G. Brooker et al, J. Am. Chem. Soc., Vol. 73, pp. 5326 to 5358 (1951) and references cited therein can be preferably used. Specific examples thereof include thiazoles, benzothiazoles, naphthothiazoles, thianaphtheno-7',6',4,5-thiazoles, oxazoles, benzoxazoles, naphthoxazoles, selenazoles, benzoselenazoles, naphthoselenazoles, thiaxolines, 2-quinolines, 4-quinolines, 1-isoquinolines, 3-isoquinolines, benzimidazoles, 3,3-dialkylindolenines, 2-pyridines and 4-pyridines.

Examples of the sulfur-containing heterocyclic ring include dithiol partial structures in dyes described in JP-A-3-296759. Specific examples thereof include benzodithiols, naphthodithiols and dithiols.

In the description with respect to the heterocyclic ring above, for convenience and by convention, the names of heterocyclic mother skeletons are used. In the case of constituting the basic nucleus partial structure in the sensitizing dye, the heterocyclic ring is introduced in the form of a substituent of alkylydene type where a degree of unsaturation is decreased one step. For example, a benzothiazole skeleton is introduced as a 3-substituted-2(3H)-benzothiazolylidene group.

Further, sensitizing dyes represented by formulae (V) to (XI) can also be used.

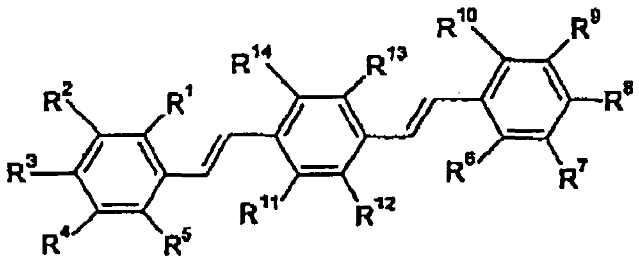

(V)

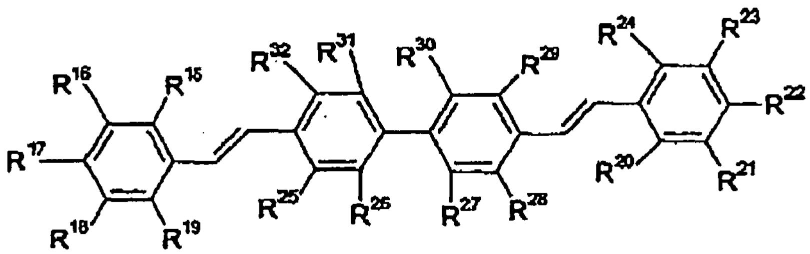

(VI)

In formula (V), $R^1$ to $R^{14}$ each independently represents a hydrogen atom, an alkyl group, an alkoxy group, a cyano group or a halogen atom, provided that at least one of $R^1$ to $R^{10}$ represents an alkoxy group having 2 or more carbon atoms.

In formula (VI), $R^{15}$ to $R^{32}$ each independently represents a hydrogen atom, an alkyl group, an alkoxy group, a cyano group or a halogen atom, provided that at least one of $R^{15}$ to $R^{24}$ represents an alkoxy group having 2 or more carbon atoms.

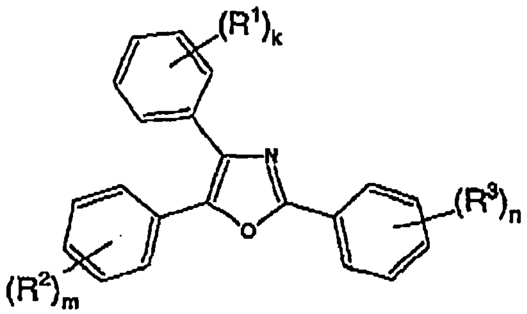

(VII)

In formula (VII), $R^1$, $R^2$ and $R^3$ each independently represents a halogen atom, an alkyl group, an aryl group, an aralkyl group, an $-NR^4R^5$ group or an $-OR^6$ group, $R^4$, $R^5$ and $R^6$ each independently represents a hydrogen atom, an alkyl group, an aryl group or an aralkyl group, and k, m and n each represents an integer of 0 to 5.

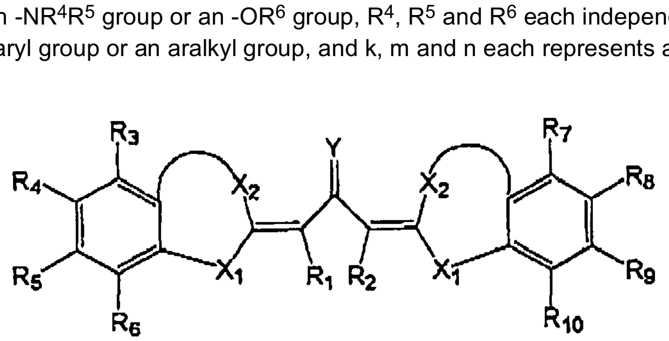

(VIII)

In formula (VIII), $X_1$ and $X_2$ each independently represents an oxygen atom, a sulfur atom, $-CR_{11}R_{12}-$ or $NR_{13}-$, provided that at least one of $X_1$ and $X_2$ represents an oxygen atom, a sulfur atom or $-NR_{13}-$. Y represents an oxygen atom, a sulfur atom or $=NR_{14}$. $R_1$ to $R_{14}$ each independently represents a hydrogen atom or a monovalent non-metallic atomic group. Alternatively, $R_1$ to $R_{14}$ may be combined with each other to from an aliphatic or aromatic ring.

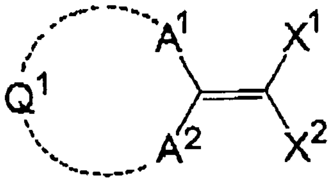

(IX)

In formula (IX), $A^1$ and $A^2$ each represents a carbon atom or a hetero atom $Q^1$ represents a non-metallic atomic group necessary for forming a hetero ring together with $A^1$, $A^2$ and the carbon atom adjacent thereto. $X^1$ and $X^2$ each independently represents a cyano group or a substituted carbonyl group, or $X^1$ and $X^2$ may be combined with each other to form a ring.

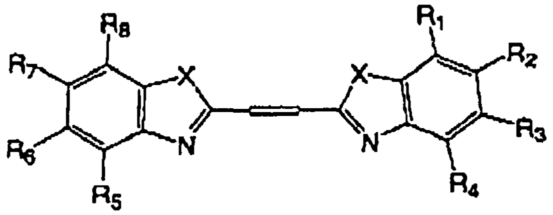

(X)

In formula (X), X each represents an oxygen atom or a sulfur atom, and $R_1$, $R_{25}$ $R_3$, $R_4$, $R_5$, $R_6$, $R_7$ and $R_8$ each independently represents a hydrogen atom or a monovalent non-metallic atomic group.

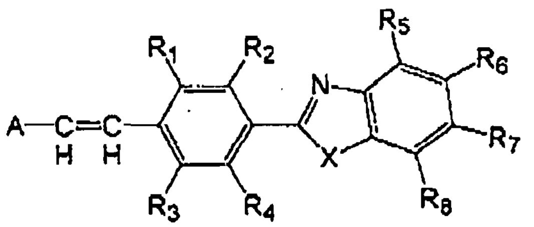

(XI)

In formula (XI), X represents an oxygen atom or a sulfur atom, $R_1$, $R_2$, $R_3$, $R_4$, $R_5$, $R_6$, $R_7$ and $R_8$ each independently represents a hydrogen atom or a monovalent non-metallic atomic group, and A represents an aryl group or heteroaryl group having 20 or less carbon atoms.

Of the sensitizing dyes having an absorption maximum in a wavelength range of 350 to 450 nm, dyes represented by formula (XII) shown below are more preferable in view of high sensitivity.

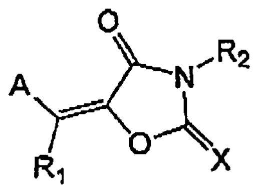

(XII)

In formula (XII), A represents an aromatic cyclic group or a heterocyclic group, X represents an oxygen atom, a sulfur atom or $=N-R_3$, and $R_1$, $R_2$ and $R_3$ each independently represents a monovalent non-metallic atomic group, or A and $R_1$ or $R_2$ and $R_3$ may be combined with each other to form an aliphatic or aromatic ring.

The formula (XII) will be described in more detail below. $R_1$, $R_2$ and $R_3$ each independently represents a monovalent non-metallic atomic group, preferably an alkyl group, an alkenyl group, an aryl group, an aromatic heterocyclic residue, an alkoxy group, an alkylthio group, a hydroxy group or a halogen atom.

Preferable examples of $R_1$, $R_2$ and $R_3$ are specifically described below.

The alkyl group preferably represented by any one of $R_1$, $R_2$ and $R_3$ includes, for example, a straight chain,

branched or cyclic alkyl group having 20 or less carbon atoms, and specific examples thereof include a methyl group, an ethyl group, a propyl group, a tert-butyl group and an isopentyl group. Among them, a straight chain alkyl group having from 1 to 12 carbon atoms, a branched alkyl group having from 3 to 12 carbon atoms and a cyclic alkyl group having from 5 to 10 carbon atoms are more preferable.

As the substituent for the substituted alkyl group preferably represented by any one of $R_1$, $R_2$ and $R_3$, a monovalent non-metallic atomic group exclusive of a hydrogen atom is used. Preferable examples thereof include a halogen atom (for example, -F, -Br, -Cl or -I), a hydroxy group, an alkoxy group, an aryloxy group, an acyl group, a nitrogen atom-containing group (for example, a cyano group, a nitro group, an amino group, an N-alkylamino group or an N,N-diarylamino group), a sulfur atom-containing group (for example, a mercapto group, an alkylthio group, an arylthio group, an alkyldithio group, an aryldithio group, an alkylsulfinyl group, a sulfo group ($-SO_3H$) and its conjugated base group (a sulfonato group) or an alkoxysulfonyl group), a phosphorus atom-containing group (for example, a phosphono group ($-PO_3H_2$) and its conjugated base group (a phosphonato group) or a dialkylphosphono group ($-PO_3(alkyl)_2$), an aryl group, a heteroaryl group, an alkenyl group and an alkynyl group.

Examples of the alkyl group in the substituent include those described for the alkyl group above. Specific examples of the aryl group in the substituent include a phenyl group, a methoxyphenyl group and a chlorophenyl group.

Examples of the heteroaryl group in the substituent include a monocyclic or polycyclic aromatic cyclic group containing at least one of a nitrogen atom, an oxygen atom and a sulfur atom. Preferable examples of the heteroaryl group include a thienyl group, a furyl group, a pyranyl group, a carbazolyl group and an acridyl group. The heteroaryl group may be benzo-fused or may have a substituent

Examples of the alkenyl group in the substituent include a vinyl group and a 1-propenyl group. Examples of the alkynyl group in the substituent include an ethynyl group, a 1-propynyl group and a 1-butynyl group. Examples of $G_1$ in the acyl group ($G_1CO-$) include a hydrogen atom, the above-described alkyl group and the aryl group described below.

Of the substituents for the substituted alkyl group, a halogen atom (for example, -F, -Br, -Cl or -I), an alkoxy group, an aryloxy group, an alkylthio group, an arylthio group, an aryl group, an alkenyl group, a nitrogen atom-containing group (for example, an N-alkylamino group or an N,N-diarylamino group), a sulfur atom-containing group (for example, an alkylsulfinyl group, a sulfo group ($-SO_3H$) and its conjugated base group (a sulfonato group) or an alkoxysulfonyl group) and a phosphorus atom-containing group (for example, a phosphono group ($-PO_3H_2$) and its conjugated base group (a phosphonato group) or a dialkylphosphono group ($-PO_3(alkyl)_2$).

On the other hand, as an alkylene group in the substituted alkyl group, a divalent residue resulting from elimination of any one of hydrogen atoms on the above-described alkyl group having 20 or less carbon atoms can be enumerated. Preferable examples of the alkylene group include a straight chain alkylene group having from 1 to 12 carbon atoms, a branched alkylene group having from 3 to 12 carbon atoms and a cyclic alkylene group having from 5 to 10 carbon atoms.

Specific examples of the preferable substituted alkyl group represented by any one of $R_1$, $R_2$ and $R_3$, which is obtained by combining the above-described substituent with the alkylene group, include a chloromethyl group, a trifluoromethyl group, a methoxymethyl group, a phenoxymethyl group, a methylthiomethyl group, a diethylaminopropyl group, a morpholinopropyl group, an acetyloxymethyl group, an N-cyclohexylcarbamoyloxyethyl group, a 2-oxoethyl group, a carboxypropyl group, a methoxycarbonylethyl group, a chlorophenoxycarbonylmethyl group, a carbamoylmethyl group, an N-methylcarbamoylethyl group, a phosphonobutyl group and a benzyl group.

The alkenyl group preferably represented by any one of $R_1$, $R_2$ and $R_3$ includes, for example, a straight chain, branched or cyclic alkenyl group having 20 or less carbon atoms, and specific examples thereof include a vinyl group, a 1-propenyl group and 2-propenyl group.

The substituted alkenyl group preferably represented by any one of $R_1$, $R_2$ and $R_3$ includes alkenyl groups having a monovalent non-metallic atomic group exclusive of a hydrogen atom as a substituent on the carbon atom of the alkenyl group described above. Preferable examples of the substituent include the above-described alkyl groups, substituted alkyl groups and the substituents described for the substituted alkyl group. Specific examples of the preferable substituted alkenyl group include a styryl group and a cinnamyl group.

The aryl group preferably represented by any one of $R_1$, $R_2$ and $R_3$ includes, for example, a fused ring formed from one to three benzene rings and a fused ring formed from a benzene ring and a 5-membered unsaturated ring. Specific examples thereof include a phenyl group, a naphthyl group, an anthryl group, a phenanthryl group, an indenyl group, an acenaphthenyl group and a fluorenyl group, and a phenyl group and a naphthyl group are preferable.

The substituted aryl group preferably represented by any one of $R_1$, $R_2$ and $R_3$ include aryl groups having a monovalent non-metallic atomic group exclusive of a hydrogen atom as a substituent on the ring-forming carbon atom of the aryl group described above. Preferable examples of the substituent include the above-described alkyl groups, substituted alkyl groups and the substituents described for the substituted alkyl group. Specific examples of the preferable substituted aryl group include a biphenyl group, a tolyl group, a chlorophenyl group, a hydroxyphenyl group, a methoxyphenyl group, a methylthiophenyl, an ethylaminophenyl, a benzoyloxyphenyl group, an acetylaminophenyl group, a

carboxyphenyl group, a sulfophenyl group, a sulfonatophenyl group, a phosphonophenyl group and a phosphonatophenyl group.

The aromatic heterocyclic residue preferably represented by any one of $R_1$, $R_2$ and $R_3$ include a monocyclic or polycyclic aromatic heterocyclic group containing at least one of a nitrogen atom, an oxygen atom and a sulfur atom. Examples of the aromatic heterocyclic residue include groups derived from hetero rings, for example, thiophene, thiathrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indole, indazole, purine, quinolizine, isoquinoline, phthalazine, naphthylidine, quinazoline, cinnoline, pteridine, carbazole, carboline, phenanthrene, acridine, perimidine, phenanthroline, phthalazine, phenarsazine, phenoxazine, furazane or phenoxazine. The aromatic heterocyclic residue may be benzo-fused.

The substituted aromatic heterocyclic residue preferably represented by any one of $R_1$, $R_2$ and $R_3$ include aromatic heterocyclic residues having a monovalent non-metallic atomic group exclusive of a hydrogen atom as a substituent on the ring-forming atom of the aromatic heterocyclic residue described above. Preferable examples of the substituent include the above-described alkyl groups, substituted alkyl groups and the substituents described for the substituted alkyl group.

The alkyl groups in the alkoxy group and alkylthio group preferably represented by any one of $R_1$, $R_2$ and $R_3$ are same as those described above with respect to the alkyl group preferably represented by any one of $R_1$, $R_2$ and $R_3$.

The substituted alkyl group in the substituted alkoxy group and substituted alkylthio group preferably represented by any one of $R_1$, $R_2$ and $R_3$ are same as those described above with respect to the substituted alkyl group preferably represented by any one of $R_1$, $R_2$ and $R_3$.

The aromatic cyclic group and heterocyclic group represented by A in formula (XII) include those described above with respect to the aryl group and aromatic heterocyclic residue represented by any one of $R_1$, $R_2$ and $R_3$, respectively.

The sensitizing dye represented by formula (XII) is obtained by a condensation reaction of the above-described acidic nucleus or an active methyl group-containing acidic nucleus with an aromatic ring or hetero ring. Specifically, it can be synthesized with reference to the description of JP-B-59-28329.

Preferable specific examples of the compound represented by formula (XII) are set forth below, but the invention should not be construed as being limited thereto. Further, when isomers with respect to a double bond connecting an acidic nucleus and a basic nucleus are present in each of the compounds, the invention should not be construed as being limited to any one of the isomers.

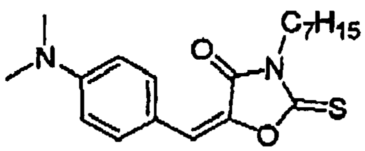

(D1)

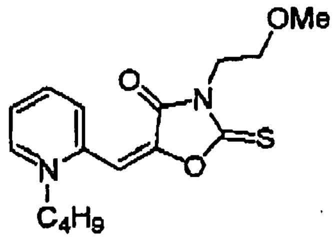

(D2)

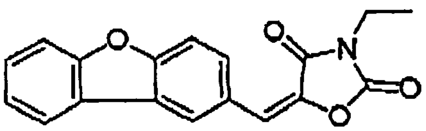

(D3)

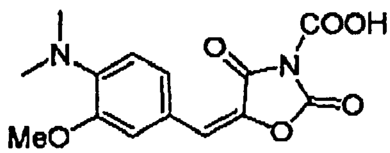

(D4)

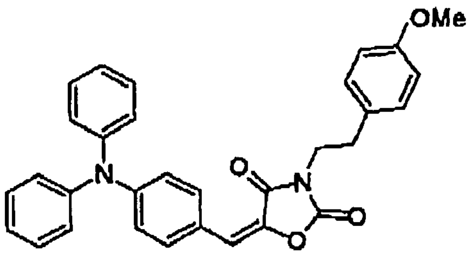

(D5)

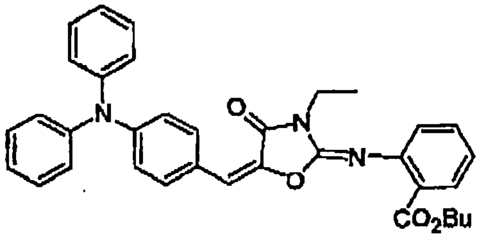

(D6)

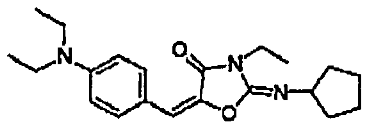

(D7)

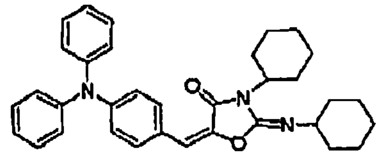

(D8)

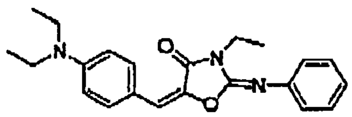

(D9)

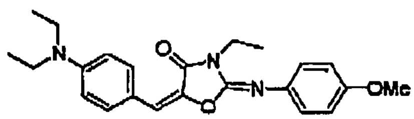

(D10)

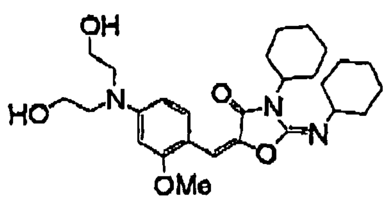

(D11)

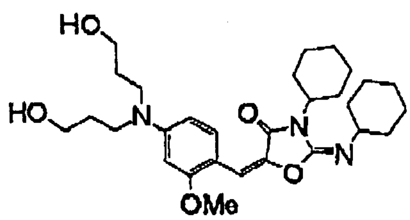

(D12)

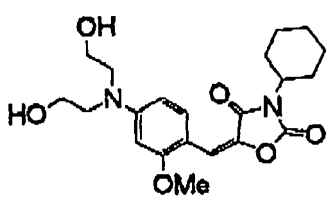

(D13)

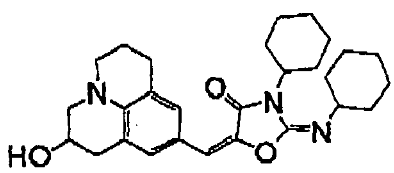

(D14)

Details of the method of using the sensitizing dye, for example, the structure thereof, individual or combination use or the amount thereof added, can be appropriately determined in accordance with the characteristic design of the lithographic printing plate precursor.

For instance, when two or more sensitizing dyes are used in combination, the compatibility thereof in the composition constituting the image-forming layer can be increased. For the selection of sensitizing dye, the molar absorption coefficient thereof at the emission wavelength of the light source used is an important factor in addition to the photosensitivity. Use of the dye having a large molar absorption coefficient is profitable, because the amount of dye added can be made relatively small. Also, the use of such a dye is advantageous in view of physical properties of the

image-forming layer. Since the photosensitivity and resolution of the image-forming layer and the physical properties of the exposed area of the image-forming layer are greatly influenced by the absorbance of sensitizing dye at the wavelength of light source, the amount of the sensitizing dye added is appropriately determined by taking account of these factors.

However, for the purpose of curing a layer having a large thickness, for example, of 5 μm or more, low absorbance is sometimes rather effective for increasing the curing degree. In the case of a lithographic printing plate precursor having the photosensitive of a relatively small thickness, the amount of the sensitizing dye added is so controlled that absorbance of the image-forming layer at the maximum absorption wavelength measured by reflection measurement is preferably in a range of 0.1 to 1.5, more preferably in a range of 0.2 to 1.2, still more preferably in a range of 0.3 to 1.0. Ordinarily, the amount of the sensitizing dye added is preferably from 0.05 to 30 parts by weight, more preferably from 0.1 to 20 parts by weight, still more preferably from 0.2 to 10 parts by weight, per 100 parts by weight of the total solid content of the image-forming layer.

(Polymerization initiator)

The polymerization initiator for use in the image-forming layer according to the invention is a compound which generates a radical with light energy or heat energy to initiate or accelerate polymerization of a compound having a polymerizable unsaturated group. The polymerization initiator is appropriately selected to use, for example, from known radical polymerization initiators and compounds containing a bond having small bond dissociation energy.

The polymerization initiators include, for example, organic halogen compounds, carbonyl compounds, organic peroxides, azo compounds, azide compounds, metallocene compounds, hexaarylbiimidazole compounds, organic boron compounds, disulfone compounds, oxime ester compounds and onium salt compounds.

The organic halogen compounds described above specifically include, for example, compounds described in Wakabayashi et al., Bull. Chem. Soc. Japan, 42, 2924 (1969), U.S. Patent 3,905,815, JP-B-46-4605, JP-A-48-36281, JP-A-53-133428, JP-A-55-32070, JP-A-60-239736, JP-A-61-169835, JP-A-61-169837, JP-A-62-58241, JP-A-62-212401, JP-A-63-70243, JP-A-63-298339 and M. P. Hutt, Journal of Heterocyclic Chemistry, 1, No. 3 (1970). Among them, oxazole compounds and s-triazine compounds each substituted with a trihalomethyl group are preferable.

More preferably, s-triazine derivatives in which at least one mono-, di- or tri-halogen substituted methyl group is connected to the s-triazine ring and oxazole derivatives in which at least one mono-, di- or tri-halogen substituted methyl group is connected to the oxazole ring are exemplified. Specific examples thereof include 2,4,6-tris(monochloromethyl)-s-triazine, 2,4,6-tris(dichloromethyl)-s-triazine, 2,4,6-tris(trichloromethyl)-s-triazine, 2-methyl-4,6-bis(trichloromethyl)-s-triazine, 2-n-propyl-4,6-bis(trichloromethyl)-s-triazine, 2-(α,α,β-trichloroethyl)-4,6-bis(trichloromethyl)-s-triazine, 2-(3,4-epoxyphenyl)-4,6-bis(trichloromethyl)-s-triazine, 2-[1-(p-methoxyphenyl)-2,4-butadienyl]-4,6-bis(trichloromemyl)-s-triazine, 2-styryl-4,6-bis(trichloromethyl)-s-triazine, 2-(p-methoxystyryl-4,6-bis(trichloromethyl)-s-triazine, 2-(p-isopropyloxystyryl-4,6-bis(trichloromethyl)-s-triazine, 2-(p-tolyl)-4,6-bis(trichloromethyl)-s-triazine, 2-(4-methoxynaphthyl)-4,6-bis(trichloromethyl)-s-triazine, 2-phenylthio-4,6-bis(trichloromethyl)-s-triaxine, 2-benzylthio-4,6-bis(trichloromethyl)-s-triazine, 2,4,6-tris(dibromomethyl)-s-triazine, 2,4,6-tris(tribromomethyl)-s-triazine, 2-methyl-4,6-bis(tribromomethyl)-s-triazine, 2-methoxy-4,6-bis(tribromomethyl)-s-triazine and compounds shown below.

(I)-1

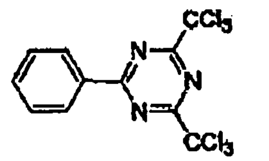

(I)-2

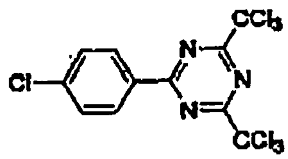

(I)-3

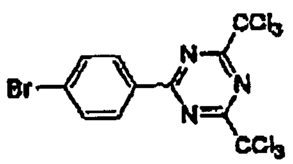

(I)-4

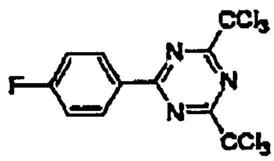

(I)-5

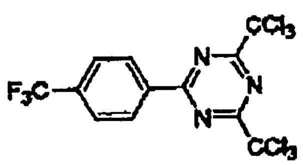

(I)-6

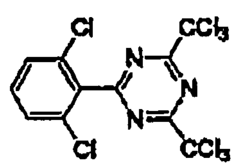

(I)-7

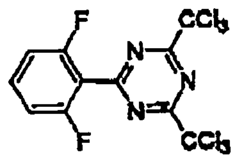

(I)-8

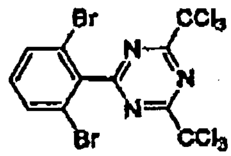

(I)-9

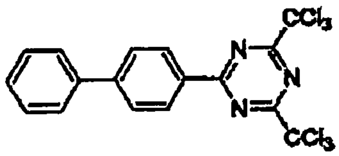

(I)-10

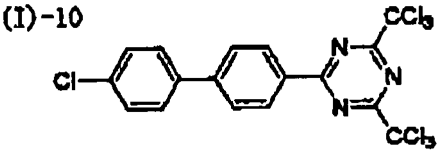

(I)-11

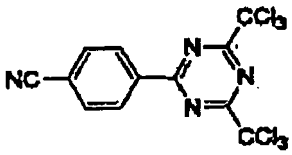

(I)-12

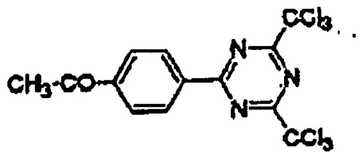

(I)-13

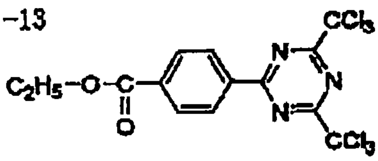

(I)-14

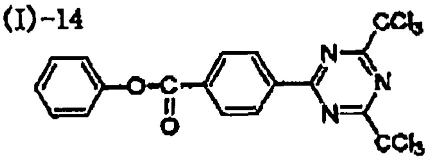

(I)-15

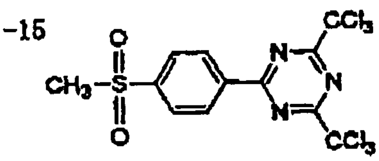

(I)-16

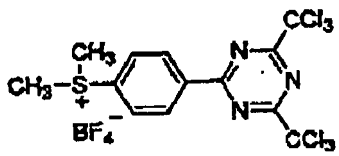

(I)-17

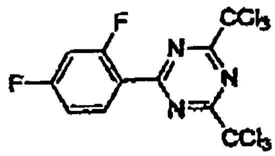

(I)-18

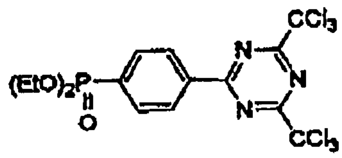

(I)-19

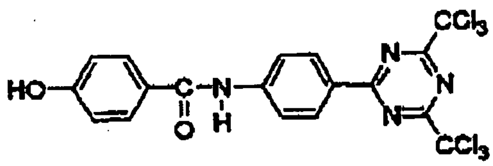

(I)-20

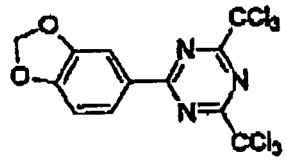

(I)-21

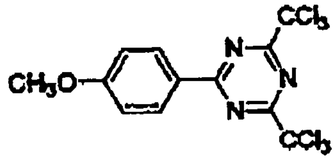

(I)-22

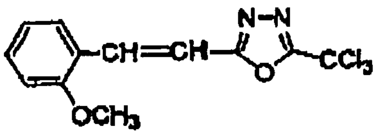

(I)-23

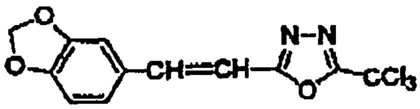

(I)-24

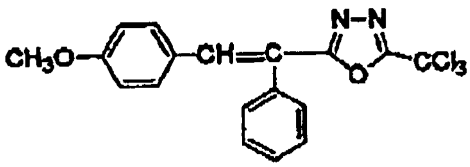

(I)-25

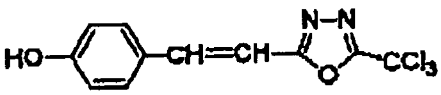

(I)-26

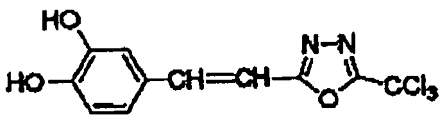

(I)-27

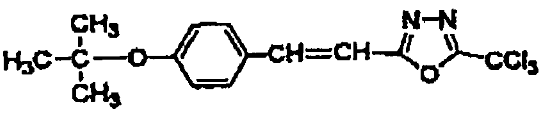

The carbonyl compounds described above include, for example, benzophenone derivatives, e.g., benzophenone, Michler's ketone, 2-methylbenzophenone, 3-methylbenzophenone, 4-methylbenzophenone, 2-chlorobenzophenone, 4-bromobenzophenone or 2-carboxybenzophenone, acetophenone derivatives, e.g., 2,2-dimethoxy-2-phenylacetophenone, 2,2-diethoxyacetophenone, 1-hydroxycyclohexylphenylketone, α-hydroxy-2-methylphenylpropane, 1-hydroxy-1-methylethyl-(p-isopropylphenyl)ketone, 1-hydroxy-1-(p-dodecylphenyl)ketone, 2-methyl-(4'-(methylthio)phenyl)-2-morpholino-1-propane or 1,1,1,-trichloromethyl-(p-butylpbenyl)ketone, thioxantone derivatives, e.g., thioxantone, 2-ethylthioxantone, 2-isopropylthioxantone, 2-chlorothioxantone, 2,4-dimetylthioxantone, 2,4-dietylthioxantone or 2,4-diisopropylthioxantone, and benzoic acid ester derivatives, e.g., ethyl p-dimethylaminobenzoate or ethyl p-diethylaminobenzoate.

The azo compounds described above include, for example, azo compounds described in JP-A-8-108621.

The organic peroxides described above include, for example, trimethylcyclohexanone peroxide, acetylacetone peroxide, 1,1-bis{tert-butylperoxy)-3,3,5-trimethylcyclohexane, 1,1-bis(tert-butylperoxy)cyclohexane, 2,2-bis(tert-butylperoxy)butane, tert-butylhydroperoxide, cumene hydroperoxide, diisopropylbenzene hydroperoxide, 2,5-dimethylhexane-2,5-dihydroperoxide, 1,1,3,3-tetramethylbutyl hydroperoxide, tert-butylcumyl peroxide, dicumyl peroxide, 2,5-dimethyl-2,5-di(tert-butylperoxy)hexane, 2,5-oxanoyl peroxide, peroxy succinic acid, benzoyl peroxide, 2,4-dichlorobenzoyl peroxide, diisopropylperoxy dicarbonate, di-2-ethylhexylperoxy dicarbonate, di-2-ethoxyethylperoxy dicarbonate, dimethoxyisopropylperoxy dicarbonate, di(3-methyl-3-methoxybutyl)peroxy dicarbonate, tert-butylperoxy acetate, tert-butylperoxy pivalate, tert-butylperoxy neodecanoate, tert-butylperoxy octanoate, tert-butylperoxy laurate, tersyl carbonate, 3,3',4,4'-tetra(tert-butylperoxycarbonyl)benzophenone, 3,3',4,4'-tetra(tert-hexylperoxycarbonyl)benzophenone, 3,3',4,4'-tetra(p-isopropylcumylperoxycarbonyl)benzophenone, carbonyl di(tert-butylperoxydihydrogen diphthalate) and carbonyl di(tert-hexylperoxydihydrogen diphthalate).

The metallocene compounds described above include, for example, various titanocene compounds described in JP-A-59-152396, JP-A-61-151197, JP-A-63-41484, JP-A-2-249, JP-A-2-4705 and JP-A-5-83588, for example, dicyclopentadienyl-Ti-bisphenyl, dicyclopentadienyl-Ti-bis-2,6-difluorophen-1-yl, dicyclopentadienyl-Ti-bis-2,4-diffuorophen-1-yl, dicyclopentadienyl-Ti-bis-2,4,6-trifluorophen-1-yl, dicyclopentadienyl-Ti-bis-2,3,5,6-tetrafluorophen-1-yl, dicyclopentadienyl-Ti-bis-2,3,4,5,6-pentafluorophen-1-yl, dimethylcyclopentadienyl-Ti-bis-2,6-difluorophen-1-yl, dimethylcyclopentadienyl-Ti-bis-2,4,6-trifluorophen-1-yl, dimethylcyclopentadienyl-Ti-bis-2,3,5,6-tetrafluorophen-1-yl, dimethylcyclopentadienyl-Ti-bis-2,3,4,5,6-pentafluorophen-1-yl, or bis(cyclopentadienyl)-bis(2,6-difluoro-3-(pyr-1-yl)phenyl) titanium and iron-arene complexes described in JP-A-1-304453 and JP-A-1-152109,

The hexaarylbiimidazole compounds described above include, for example, various compounds described in JP-B-6-29285 and U.S. Patents 3,479,185,4,311,783 and 4,622,286, specifically, for example, 2,2'-bis(o-chlorophenyl)-4,4',5,5'-tetraphenylbiimidazole, 2,2'-bis(o-bromophenyl)-4,4',5,5'-tetraphenylbiimidazole, 2,2'-bis(o,p-dichlorophenyl)-4,4',5,5' tetraphenylbiimidazole, 2,2'-bis(o-chlorophenyl)-4,4',5,5'-tetra(m-mekoxyphenyl)biimidazole, 2,2'-bis(o,o'-dichlorophenyl)4,4',5,5'-tetraphenylbiimidazole, 2,2'-bis(o-nitrophenyl)-4,4',5,5'-tetraphenylbiimidazole, 2,2'-bis(o-methylphenyl)-4,4',5,5'-tetraphenylbiimidazole and 2,2'-bis(o-trifluoromethylphenyl)-4,4',5,5'-tetrapbenylbiimidazole.

The organic boron compounds described above include, for example, organic boric acid salts described in JP-A-62-143044, JP-A-62-150242, JP-A-9-188685, JP-A-9-188686, JP-A-9-188710, JP-A-2000-131837, JP-A-2002-107916, Japanese Patent 2764769, JP-A-2002-116539 and Martin Kunz, Rad Tech '98, Proceeding, April 19-22 (1998), Chicago, organic boron sulfonium complexes or organic boron oxosulfonium complexes described in JP-A-6-157623, JP-A-6-175564 and JP-A-6-175561, organic boron iodonium complexes described in JP-A-6-175554 and JP-A-6-175553, organic boron phosphonium complexes described in JP-A-9-188710, and organic boron transition metal coordination complexes described in JP-A-6-348011, JP-A-7-128785, JP-A-7-140589, JP-A-7-306527 and JP-A-7-292014.

The disulfone compounds described above include, for example, compounds described in JP-A-61-166544 and JP-A-2002-328465.

The oxime ester compounds described above include, for example, compounds described in J. C. S. Perkin II, 1653-1660 (1979), J. C. S. Perkin II, 156-162 (1979), Journal of Photopolymer Science and Technology, 202-232 (1995) and JP-A-2000-66385, and compounds described in JP-A-2000-80068. Specific examples thereof include compounds represented by the following structural formulae:

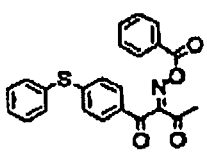
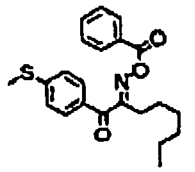
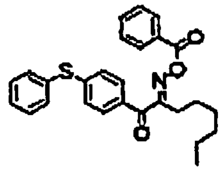
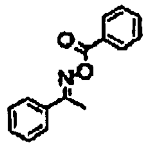
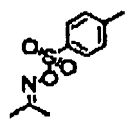

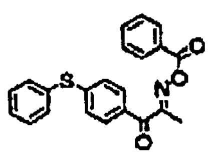
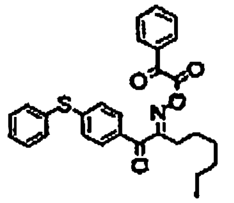
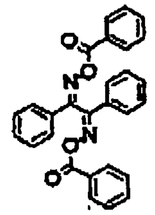
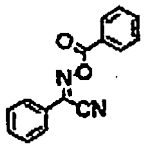
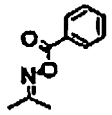

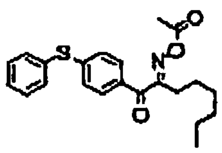
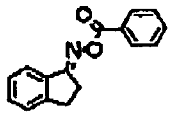
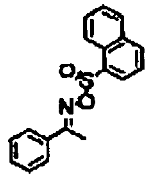
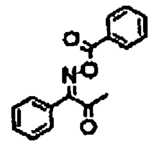
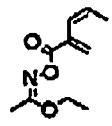

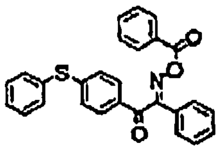
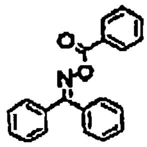
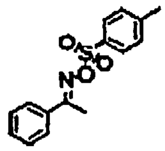
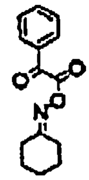
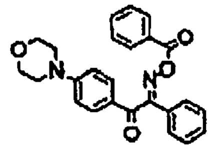

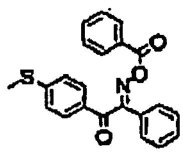
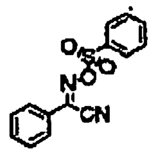

The onium salt compounds described above include onium salts, for example, diazonium salts described in S. I. Schlesinger, Photogr. Sci. End., 18, 387 (1974) and T. S. Bal et al., Polymer, 21, 423 (1980), ammonium salts described in U.S. Patent 4,069,055 and JP-A-4-365049, phosphonium salts described in U.S. Patents 4,069,055 and 4,069,056, iodonium salts described in European Patent 104,143, U.S. Patents 339,049 and 410,201, JP-A-2-150848 and JP-A-2-296514, sulfonium salts described in European Patents 370,693, 390,214, 233,567, 297,443 and 297,442, U.S. Patents 4,933,377, 161,811, 410,201, 339,049, 4,760,013,4,734,444 and 2,833,827 and German Patents 2,904,626, 3,604,580 and 3,604,581, selenonium salts described in J.V. Crivello et al., Macromolecules, 10 (6), 1307 (1977) and J.V. Crivello et al., J. Polymer Sci., Polymer Chem. Ed., 17, 1047 (1979), and arsonium salts described in C.S. Wen et al., Teh. Proc. Conf. Rad. Curing ASIA, p. 478, Tokyo, Oct. (1988).

In the invention, the onium salt compound functions not as an acid generator, but as an ionic radical polymerization initiator.

The onium salt compounds preferably used include onium salts represented by the following formulae (RI-I) to (RI-III):

$$Ar_{11}-\overset{+}{N}\equiv N \quad Z_{11}^{-} \qquad (RI-I)$$

$$Ar_{21}-\overset{+}{I}-Ar_{22} \quad Z_{21}^{-} \qquad (RI-II)$$

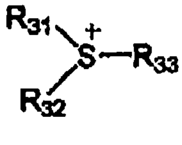 $Z_{31}^{-}$ (RI-III)

In formula (RI-I), $Ar_{11}$ represents an aryl group having 20 or less carbon atoms, which may have 1 to 6 substituents. Preferable examples of the substituent include an alkyl group having 12 or less carbon atoms, an alkenyl group having 12 or less carbon atoms, an alkynyl group having 12 or less carbon atoms, an aryl group having 12 or less carbon atoms, an alkoxy group having 12 or less carbon atoms, an aryloxy group having 12 or less carbon atoms, a halogen atom, an alkylamino group having 12 or less carbon atoms, a dialkylimino group having 12 or less carbon atoms, an alkylamido group or arylamido group having 12 or less carbon atoms, a carbonyl group, a carboxyl group, a cyano group, a sulfonyl group, an thioalkyl group having 12 or less carbon atoms and an thioaryl group having 12 or less carbon atoms. $Z_{11}^{-}$ represents a monovalent anion. Specific examples of the monovalent anion include a halogen ion, a perchlorate ion, a hexafluorophosphate ion, a tetrafluoroborate ion, a sulfonate ion, a sulfinate ion, a thiosulfonate ion and

a sulfate ion. Among them, a perchlorate ion, a hexafluorophosphate ion, a tetrafluoroborate ion, a sulfonate ion and a sulfinate ion are preferred in view of stability.

In the formula (RI-II), $Ar_{21}$ and $Ar_{22}$ each independently represents an aryl group having 20 or less carbon atoms, which may have 1 to 6 substituents. Preferable examples of the substituent include an alkyl group having 12 or less carbon atoms, an alkenyl group having 12 or less carbon atoms, an alkynyl group having 12 or less carbon atoms, an aryl group having 12 or less carbon atoms, an alkoxy group having 12 or less carbon atoms, an aryloxy group having 12 or less carbon atoms, a halogen atom, an alkylamino group having 12 or less carbon atoms, a dialkylimino group having 12 or less carbon atoms, an alkylamido group or arylamido group having 12 or less carbon atoms, a carbonyl group, a carboxyl group, a cyano group, a sulfonyl group, an thioalkyl group having 12 or less carbon atoms and an thioaryl group having 12 or less carbon atoms. $Z_{21}^-$ represents a monovalent anion. Specific examples of the monovalent anion include a halogen ion, a perchlorate ion, a hexafluorophosphate ion, a tetrafluoroborate ion, a sulfonate ion, a sulfinate ion, a thiosulfonate ion, a sulfate ion and a carboxylate ion. Among them, a perchlorate ion, a hexafluorophosphate ion, a tetrafluoroborate ion, a sulfonate ion, a sulfinate ion and a carboxylate ion are preferred in view of stability and reactivity.

In the formula (RI-III), $R_{31}$, $R_{32}$ and $R_{33}$ each independently represents an aryl group having 20 or less carbon atoms, which may have 1 to 6 substituents, an alkyl group, an alkenyl group or an alkynyl group. Among them, the aryl group is preferred in view of reactivity and stability. Preferable examples of the substituent include an alkyl group having 12 or less carbon atoms, an alkenyl group having 12 or less carbon atoms, an alkynyl group having 12 or less carbon atoms, an aryl group having 12 or less carbon atoms, an alkoxy group having 12 or less carbon atoms, an aryloxy group having 12 or less carbon atoms, a halogen atom, an alkylamino group having 12 or less carbon atoms, a dialkylimino group having 12 or less carbon atoms, an alkylamido group or arylamido group having 12 or less carbon atoms, a carbonyl group, a carboxyl group, a cyano group, a sulfonyl group, an thioalkyl group having 12 or less carbon atoms and an thioaryl group having 12 or less carbon atoms. $Z_{31}^-$ represents a monovalent anion. Specific examples of the monovalent anion include a halogen ion, a perchlorate ion, a bexafluorophosphate ion, a tetrafluoroborate ion, a sulfonate ion, a sulfinate ion, a thiosulfonate ion, a sulfate ion and a carboxylate ion. Among them, a perchlorate ion, a hexafluorophosphate ion, a tetrafluoroborate ion, a sulfonate ion, a sulfinate ion and a carboxylate ion are preferred in view of stability and reactivity. Carboxylate ions described in JP-A-2001-343742 are more preferable, and carboxylate ions described in JP-A-2002-148790 are particularly preferable.

Specific examples of the onium salt represented by any on of formulae (RI-I) to (RI-III) are set forth below, but the invention should not be construed as being limited thereto.

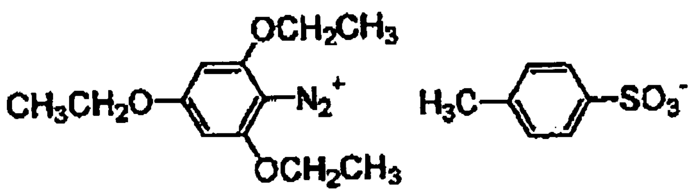

(N-1)

$PF_6^-$ (N-2)

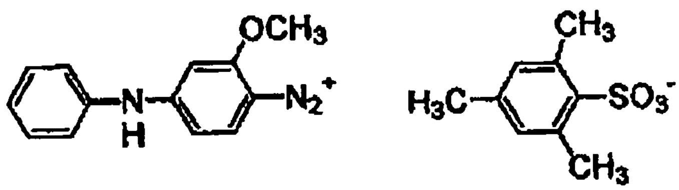

(N-3)

$ClO_4^-$ (N-4)

$PF_6^-$ (N-5)

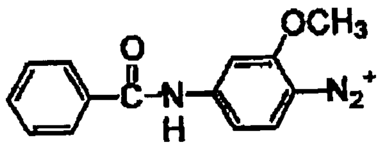

$CF_3SO_3^-$ (N-6)

$BF_4^-$ (N-7)

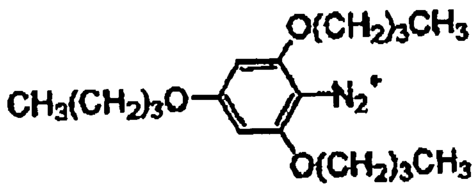

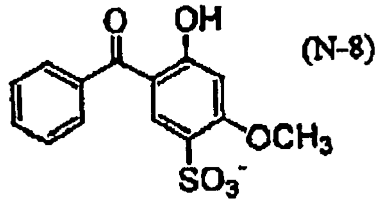

(N-8)

$ClO_4^-$ (N-9)

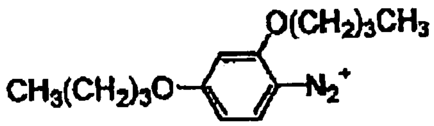

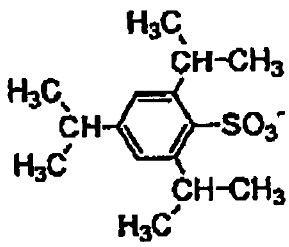

(N-10)

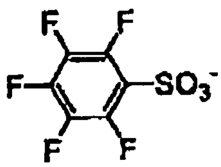

(N-11)

$PF_6^-$ v

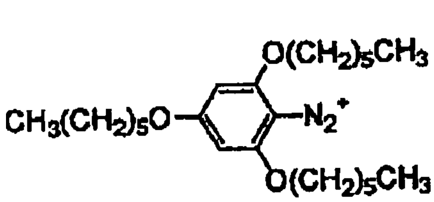

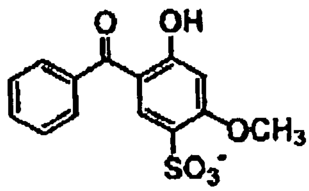

(N-13)

$ClO_4^-$ (N-14)

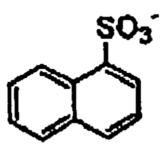

(N-15)

$PF_6^-$ (N-16)

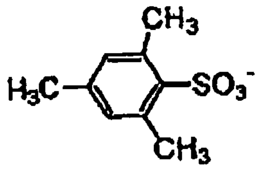

(N-17)

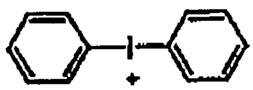

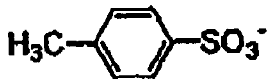

(I-1)

$PF_6^-$ (I-2)

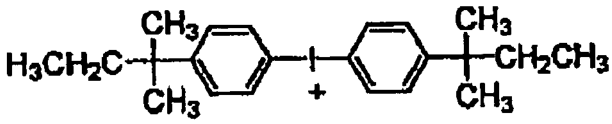

$PF_6^-$ (I-3)

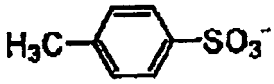

(I-4)

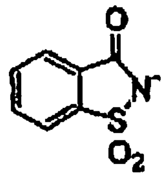

(I-9)

$ClO_4^-$ (I-5)

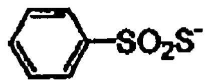

(I-10)

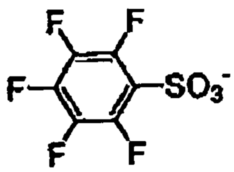

(I-6)

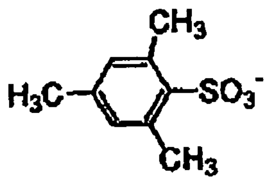

(I-11)

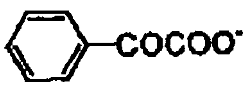

(I-7)

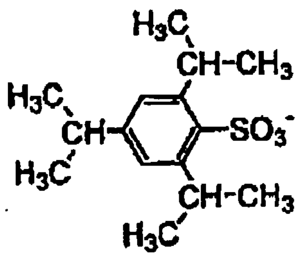

(I-12)

$CF_3SO_3^-$ (I-8)

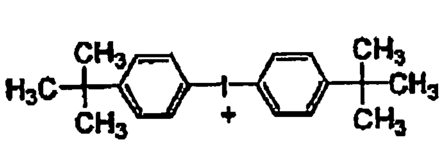

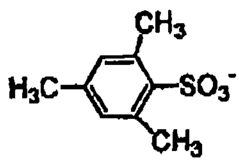

(I-13)

$ClO_4^-$ (I-14)

$PF_6^-$ (X-15)

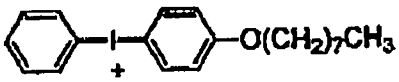 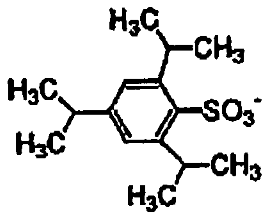 (I-16)

$CF_3COO^-$ (I-17)

$CF_3SO_3^-$ (I-18)

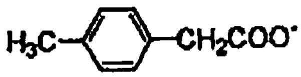 (I-19)

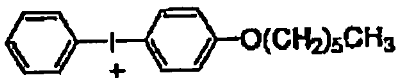 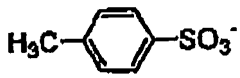 (I-20)

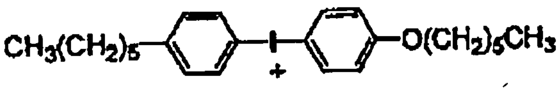 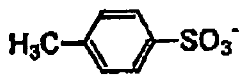 (I-21)

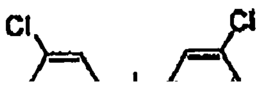 $BF_4^-$ (I-22)

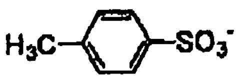 (I-23)

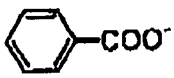 ( I -24)

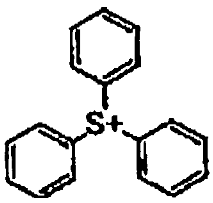 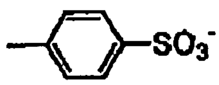 (S-1)

$PF_8^-$ (S-2)

$ClO_4^-$ (S-3)

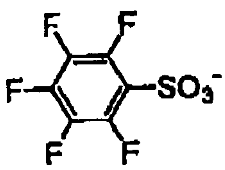 (S-4)

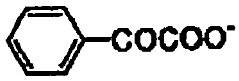 (S-5)

$CF_3SO_3^-$ (S-6)

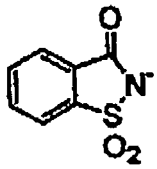 (S-7)

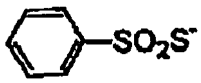 (S-8)

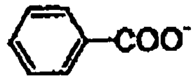 (S-9)

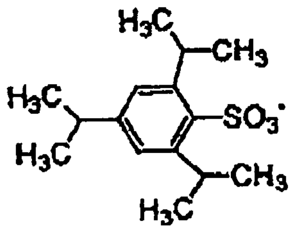 (S-10)

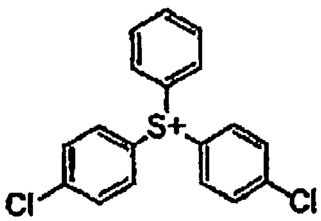

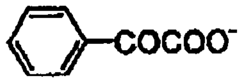 (S-11)

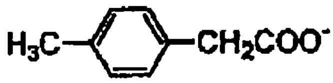 (S-12)

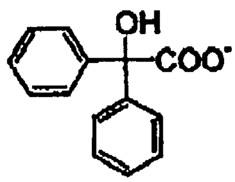 (S-13)

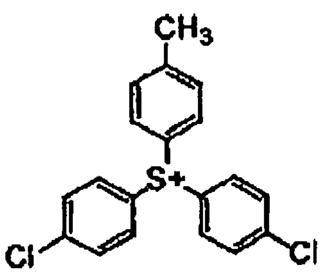 .

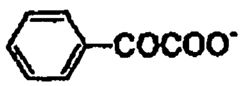 (S-14)

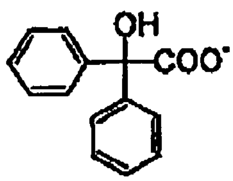 (S-15)

$BF_4^-$ (S-16)

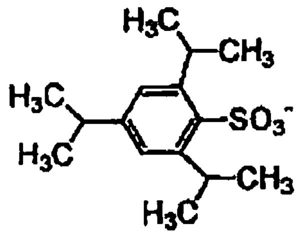

(S-17)

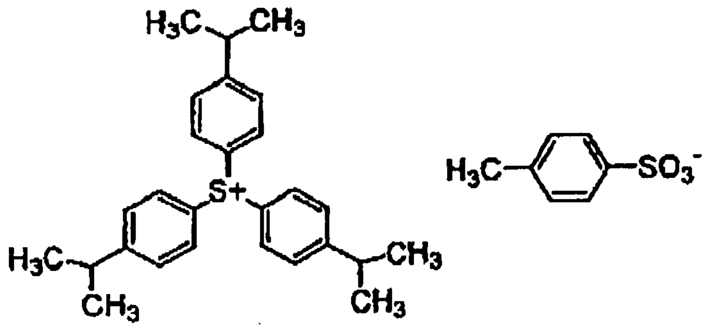

(S-18)

As the polymerization initiator, particularly, from the standpoint of reactivity and stability, the organic halogen compounds, metallocene compounds, hexaarylbiimidazole compounds, organic boron compounds, oxime ester compounds and onium salt compounds are preferable and the organic halogen compounds, metallocene compounds, hexaarylbiimidazole compounds and onium salt compounds are more preferable.

The polymerization initiators may be used individually or in combination of two or more thereof. The content of the polymerization initiator is preferably from 0.1 to 50% by weight, more preferably from 0.5 to 30% by weight, still more preferably from 0.8 to 20% by weight, based on the total solid content of the image-forming layer.

(Radical polymerizable compound)

The radical polymerizable compound for use in the image-forming layer according to the invention is an addition-polymerizable compound having at least one ethylenically unsaturated double bond, and it is selected from compounds having at least one, preferably two or more, terminal ethylenically unsaturated double bonds. Such compounds are widely known in the art and they can be used in the invention without any particular limitation. The polymerizable compound has a chemical form, for example, a monomer, a prepolymer, specifically, a dimer, a trimer or an oligomer, or a copolymer thereof, or a mixture thereof. Examples of the polymerizable compound include compounds represented by formulae (1) to (5) shown below.

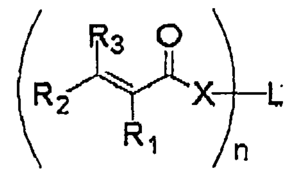

(1)

In formula (1), $R_1$ to $R_3$ each independently represents a monovalent organic group. $R_1$ preferably includes, for example, a hydrogen atom or an alkyl group. Among them, a hydrogen atom, a methyl group or a group formed by substituting one hydrogen atom of methyl group with a hydroxy group, an alkoxy group, an acyloxy group, an amino group, an acylamino group, a thiol group, an alkylthio group, an acylthio group, a sulfo group, a sulfonic acid group or a carboxyl group is more preferable because of high radical reactivity. $R_2$ and $R_3$ each independently preferably includes, for example, a hydrogen atom, a halogen atom, an amino group, a carboxyl group, an alkoxycarbonyl group, a sulfo group, a nitro group, a cyano group, an alkyl group, an aryl group, an alkoxy group, an aryloxy group, an alkylamino group, an arylamino group, an alkylsulfonyl group and an arylsulfonyl group. Among them, a hydrogen atom, a carboxyl group, an alkoxycarbonyl group, an alkyl group or an aryl group is preferable because of high radical reactivity.

X represents an oxygen atom, a sulfur atom, $-N(R_{12})-$ or $-C(R_{12}R_{13})-$, and $R_{12}$ and $R_{13}$ each represents a monovalent organic group. The monovalent organic group represented by $R_{12}$ or $R_{13}$ includes, for example, an alkyl group. $R_{12}$ or $R_{13}$ is preferably a hydrogen atom, a methyl group, an ethyl group or an isopropyl group because of high

radical reactivity. $R_{12}$ or $R_{13}$ may be combined with an atom constituting L to from a ring.

Examples of the substituent capable of being introduced into the organic group include an alkyl group, an alkenyl group, an alkynyl group, an aryl group, an alkoxy group, an aryloxy group, a halogen atom, an amino group, an alkylamino group, an arylamino group, a carboxyl group, an alkoxycarbonyl group, a sulfo group, a nitro group, a cyano group, an amido group, an alkylsulfonyl group and an arylsulfonyl group.

L represents an n-valent organic residue constituted from any of hydrogen, fluorine, chlorine, bromine, iodine, carbon, nitrogen, oxygen, boron, sulfur, phosphorus, silicon, lithium, sodium, potassium, magnesium, calcium, aluminum, scandium, titanium, vanadium, chromium, manganese, iron, cobalt, nickel, zinc, gallium, germanium, silver, palladium, lead, zirconium, rhodium, tin, platinum and tungsten. L is preferably an n-valent organic residue constituted from any of hydrogen, fluorine, chlorine, bromine, iodine, carbon, nitrogen, oxygen, boron, sulfur, phosphorus, silicon, lithium, sodium, potassium, magnesium and calcium, more preferably an n-valent organic residue constituted from any of hydrogen, fluorine, chlorine, bromine, iodine, carbon, nitrogen, oxygen, boron, sulfur, phosphorus and silicon.

n represents a natural number and is preferably from 1 to 100, more preferably from 2 to 80, still more preferably from 3 to 60.

Specific examples of the polymerizable compound represented by formula (I) include (a) an unsaturated carboxylic acid (for example, acrylic acid, methacrylic acid, itaconic acid, crotonic acid, isocrotonic acid, 2-hydroxymethylacrylic acid, $\alpha$-bromoacrylic acid, fumaric acid, mesaconic acid or maleic acid), (b) an ester thereof and (c) an amide thereof, and (d) an ester of an unsaturated carboxylic acid with an aliphatic polyhydric alcohol compound and (e) an amide of an unsaturated carboxylic acid with an aliphatic polyvalent amine compound are preferably used. Further, (f) an addition reaction product of an unsaturated carboxylic acid ester or amide having a nucleophilic substituent, for example, a hydroxy group, an amino group or a mercapto group, with a monofunctional or polyfunctional isocyanate or epoxy, or a dehydration condensation reaction product of the unsaturated carboxylic acid ester or amide with a monofunctional or polyfunctional carboxylic acid is also preferably used. Moreover, (g) an addition reaction product of an unsaturated carboxylic acid ester or amide having an electrophilic substituent, for example, an isocyanate group or an epoxy group with a monofunctional or polyfunctional alcohol, amine or thiol, or (h) a substitution reaction product of an unsaturated carboxylic acid ester or amide having a releasable substituent, for example, a halogen atom or a tosyloxy group with a monofunctional or polyfunctional alcohol, amine or thiol is also preferably used. In addition, compounds in which the unsaturated carboxylic acid described above is replaced by an unsaturated ketone (for example, vinyl methyl ketone or vinyl ethyl ketone) can also be used.

Specific examples of the monomer, which is an ester of an aliphatic polyhydric alcohol compound with an unsaturated carboxylic acid, include, as an acrylic acid ester, for example, ethylene glycol diacrylate, triethylene glycol diacrylate, propylene glycol diacrylate, trimethylolpropane triacrylate, hexanediol diacrylate, 1,4-cyclohexanediol diacrylate, pentaerythritol triacrylate, pentaerythritol tetraacrylate, dipentaerythritol hexaacrylate, sorbitol tetraacrylate, sorbitol hexaacrylate, tri(arryloyloxyethyl) isocyanurate, isocyanuric acid ethylene oxide (EO) modified triacrylate and polyester acrylate oligomer.

As an methacrylic acid ester, for example, tetramethylene glycol dimethacrylate, triethylene glycol dimethacrylate, trimethylolpropane trimethacrylate, pentaerythritol trimethacrylate, pentaerythritol tetramethacrylate, dipentaerythritol hexamethacrylate, sorbitol trimethacrylate, sorbitol tetramethacrylate, bis[p-(3-methacryloxy-2-hydroxypropoxy)phenyl]dimethylmethane or bis[p-(methacryloxyethoxy)phenyl]dimethylmethane is exemplified.

As an itaconic acid ester, for example, ethylene glycol diitaconate, tetramethylene glycol diitaconate, pentaerythritol diitaconate or sorbitol tetraitaconate is exemplified. As a crotonic acid ester, for example, ethylene glycol dicrotonate, tetramethylene glycol dicrotonate, pentaerythritol dicrotonate or sorbitol tetracrotonate is exemplified. As an isocrotonic acid ester, for example, ethylene glycol diisocrotonate, pentaerythritol diisocrotonate or sorbitol tetraisocrotonate is exemplified. As a maleic acid ester, for example, ethylene glycol dimaleate, pentaerythritol dimaleate or sorbitol tetramaleate is exemplified.

Other examples of the ester, which can be preferably used, include aliphatic alcohol esters described in JP-B-51-47334 (the term "JP-B" as used herein means an "examined Japanese patent publication") and JP-A-57-196231, esters having an aromatic skeleton described in JP-A-59-5240, JP-A-59-5241 and JP-A-2-226149, and esters containing an amino group described in JP-A-1-165613.

The above-described ester monomers can also be used as a mixture.

Specific examples of the monomer, which is an amide of an aliphatic polyvalent amine compound with an unsaturated carboxylic acid, include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide and xylylene bismethacrylamide. Other preferable examples of the amide monomer include amides having a cyclohexylene structure described in JP-B-54-21726.

Urethane type addition-polymerizable compounds produced using an addition reaction between an isocyanate and a hydroxy group are also preferably used, and specific examples thereof include vinylurethane compounds having two or more polymerizable vinyl groups per molecule obtained by adding a vinyl monomer containing a hydroxy group

represented by formula (VM) shown below to a polyisocyanate compound having two or more isocyanate groups per molecule, described in JP-B-48-41708.

$$CH_2=C(R_4)COOCH_2CH(R_5)OH \qquad (VM)$$

wherein $R_4$ and $R_5$ each independently represents H or $CH_3$.

Also, urethane acrylates described in JP-A-51-37193, JP-B-2-32293 and JP-B-2-16765, and urethane compounds having an ethylene oxide skeleton described in JP-B-58-49860, JP-B-56-17654, JP-B-62-39417 and JP-B-62-39418 are preferably used. Further, an image-forming layer having remarkably excellent photo-speed can be obtained by using an addition polymerizable compound having an amino structure or a sulfide structure in its molecule described in JP-A-63-277653, JP-A-63-260909 and JP-A-1-105238.

Other examples include polyfunctional acrylates and methaerylates, for example, polyester acrylates and epoxy acrylates obtained by reacting an epoxy resin with (meth)acrylic acid, described in JP-A-48-64183, JP-B-49-43191 and JP-B-52-30490. Specific unsaturated compounds described in JP-B-46-43946, JP-B-1-40337 and JP-B-1-40336, and vinylphosphonic acid type compounds described in JP-A-2-25493 can also be exemplified. In some cases, structure containing a perfluoroalkyl group described in JP-A-61-22048 can be preferably used. Moreover, photocurable monomers or oligomers described in Nippon Secchaku Kyokaishi (Journal of Japan Adhesion Society), Vol. 20, No. 7, pages 300 to 308 (1984) can also be used.

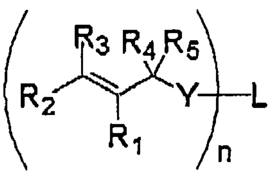

(2)

In formula (2), $R_1$ to $R_5$ each independently represents a monovalent organic group. $R_1$ to $R_5$ each independently preferably includes, for example, a hydrogen atom, a halogen atom, an amino group, a dialkylamino group, a carboxyl group, an alkoxycarbonyl group, a sulfo group, a nitro group, a cyano group, an alkyl group, an aryl group, an alkoxy group, an aryloxy group, an alkylamino group, an arylamino group, an alkylsulfonyl group and an arylsulfonyl group. Among them, a hydrogen atom, a carboxyl group, an alkoxycarbonyl group, an alkyl group or an aryl group is preferable. Alternatively, appropriate two of $R_1$ to $R_5$ may be combined with each other to form a ring, or any one of $R_1$ to $R_5$ may be combined with an atom constituting L to from a ring.

Examples of the substituent capable of being introduced into the organic group include those described in formula (1). Y represents an oxygen atom, a sulfur atom, $-N(R_{12})-$ or $-C(R_{12}R_{13})-$. $R_{12}$ and $R_{13}$ have the same meanings as $R_{12}$ and $R_{13}$ defined in formula (1), respectively. Preferable examples of $R_{12}$ and $R_{13}$ are also same as those described in formula (1), respectively.

L and n have the same meanings as L and n defined in formula (1), respectively. Preferable examples of L and n are also same as those described in formula (1), respectively.

Specific examples of the polymerizable compound represented by formula (2) include an ester compound of an alcohol having an unsaturated double bond (for example, ally alcohol, ethylene glycol monoallyl ether, 3-butene-1-ol, 2-cyclohexene-1-ol or retinol) with a monofunctional or polyfunctional carboxylic acid (for example, acetic acid, benzoic acid, maleic acid, tricarbaric acid, 1,3,5-cyclohexanetricarboxylic acid or 1,2,4-benzenetricarboxylic acid), a urethane compound of the alcohol having an unsaturated double bond with a monofunctional or polyfunctional iso(thio)cyanate (for example, butyl isocyanate, 1,3-bis(isocyanatomethyl)cyclohexane, 4,4'-methylenebis(cyclohexylisocyanate), isohoron diisocyanate, allyl isothiocyanate, phenyl isothiocyanate, phenyl isocyanate or 4,4'-methylenebis(phenyl isocyanate), an ether compound of the alcohol having an unsaturated double bond with a monofunctional or polyfunctional alcohol (for example, ethanol, ethylene glycol, polyethylene glycol, propylene glycol, cyclohexane diol, inositol, glycerol, trimethylol propane, pentaerythritol, xylitol, dextrin, phenol or bisphenol A), an addition reaction product of the alcohol having an unsaturated double bond with a monofunctional or polyfunctional epoxy compound (for example, ethylene glycol diglycidyl ether, cyclohexene oxide, neopentyl glycol diglycidyl ether or tris(2,3-epoxypropyl)isocyanurate), a substitution reaction product of the alcohol having an unsaturated double bond with a monofunctional or polyfunctional halogenated alkyl (for example, 1,4-dibromobutane or bis(2-bromoethyl) maleate) or a sulfonic acid (for example, methanesulfonic acid, camphorsulfonic acid or toluenesulfonic acid) ester of a monofunctional or polyfunctional alcohol, a substitution reaction product of a halogenated alkyl having an unsaturated double bond (for example, allyl bromide, 4-bromo-1-butene or 3-chloro-2-methylpropene) or a sulfonic acid ester of an alcohol having an unsaturated double bond with a nucleophilic compound, for example, a monofunctional or polyfunctional alcohol, a monofunctional or polyfunctional amine (for example, butylamine, ethylenediamine, triethylamine, pentaethylenehexamine, 2,2'-oxybis(ethylamine), morpholine, piperazine, pyridine, proline or 4,4'-methylenedianiline), a monofunctional or polyfunctional phosphine, a monofunctional or polyfunctional thiol, a monofunctional or polyfunctional carbonyl compound or a monofunctional or polyfunctional carboxylate, an amide of an amine having an unsaturated double bond (for example, allylamine, triallylamine, geranylamine or N-ethyl-2-methylallylamine) with a monofunctional or polyfunctional carboxylic acid, a urea of the amine having an unsaturated double bond with a monofunctional or polyfunctional isocyanate, a substitution reaction product of the amine having an unsaturated double bond with a monofunctional or polyfunctional halogenated alkyl or a sulfonic acid ester of a monofunctional or polyfunctional alcohol, an imine of the amine having an unsaturated double bond with a monofunctional or polyfunctional carbonyl compound, a sulfonamide of the amine having an unsaturated double bond with a monofunctional or polyfunctional sulfonic acid, a urethane of an iso(thio)cyanate having an unsaturated double bond (for example, allyl isocyanate or allyl isothiocyanate) with a monofunctional or polyfunctional alcohol, a urea of the iso(thio)cyanate having an unsaturated double bond with a monofunctional or polyfunctional amine, an amide of the iso(thio)cyanate having an unsaturated double bond with a monofunctional or polyfunctional carboxylic acid, an addition reaction product of the iso(thio)cyanate having an unsaturated double bond with a monofunctional or polyfunctional thiol, and an addition reaction product of the iso(thio)cyanate having an unsaturated double bond with a monofunctional or polyfunctional iso(thio)cyanate.

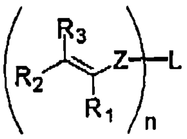 (3)

In formula (3), $R_1$ to $R_3$ each independently represents a monovalent organic group. $R_1$ to $R_3$ each independently preferably includes, for example, a hydrogen atom, a halogen atom, an amino group, a dialkylamino group, a carboxyl group, an alkoxycarbonyl group, a sulfo group, a nitro group, a cyano group, an alkyl group, an aryl group, an alkoxy group, an aryloxy group, an alkylamino group, an arylamino group, an alkylsulfonyl group and an arylsulfonyl group. Among them, a hydrogen atom, a carboxyl group, an alkoxycarbonyl group, an alkyl group or an aryl group is preferable. Alternatively, appropriate two of $R_1$ to $R_3$ may be combined with each other to form a ring, or any one of $R_1$ to $R_3$ may be combined with an atom constituting L to from a ring.

Examples of the substituent capable of being introduced into the organic group include those described in formula (1). Z represents an oxygen atom, a sulfur atom, $-N(R_{12})-$ or $-C(R_{12}R_{13})-$. $R_{12}$ and $R_{13}$ have the same meanings as $R_{12}$ and $R_{13}$ defined in formula (1), respectively. Preferable examples of $R_{12}$ and $R_{13}$ are also same as those described in formula (1), respectively.

L and n have the same meanings as L and n defined in formula (1), respectively. Preferable examples of L and n are also same as those described in formula (1), respectively.

Specific examples of the polymerizable compound represented by formula (3) include a monofunctional or polyfunctional carboxylic acid vinyl ester (for example, vinyl acetate, isopropenyl acetate or trivinyl 1,3,5-cyclohexanetricarboxylate), a vinyl ether (for example, 1,4-cyclohexanedimethanol divinyl ether or trimethylolpropane trivinyl ether), an ester of a vinyl ether alcohol (for example, ethylene glycol monovinyl ether or diethylene glycol monovinyl ether) with a monofunctional or polyfunctional carboxylic acid, a urethane of the vinyl ether alcohol with a monofunctional or polyfunctional iso(thio)cyanate, a substitution product of the vinyl ether alcohol with a monofunctional or polyfunctional halogenated alkyl or a sulfonic acid ester of a monofunctional or polyfunctional alcohol, an addition product of the vinyl ether alcohol with a monofunctional or polyfunctional epoxy, a substitution reaction product of a vinyl ether of halogenated alkyl (for example, 2-chloromethyl vinyl ether) or a vinyl ether sulfonic acid ester (for example, vinyloxyethyl p-toluenesulfonate) with a nucleophilic compound, for example, a monofunctional or polyfunctional alcohol, a monofunctional or polyfunctional amine, a monofunctional or polyfunctional phosphine, a monofunctional or polyfunctional thiol, a monofunctional or polyfunctional carbonyl compound or a monofunctional or polyfunctional carboxylate, an amide of a vinyl ether amine (for example, 3-amino-1-propanol vinyl ether or 2-(diethylamino)ethanol vinyl ether) with a monofunctional or polyfunctional carboxylic acid, a urea of the vinyl ether amine with a monofunctional or polyfunctional iso(thio)cyanate, a substitution product of the vinyl ether amine with a monofunctional or polyfunctional halogenated alkyl, a sulfonamide of the vinyl ether amine with a monofunctional or polyfunctional sulfonic acid, and a monofunctional or polyfunctional vinyl amide (for example, N-vinyl carbazole, N-vinyl pyrrolidinone or N-vinyl phthalimide).

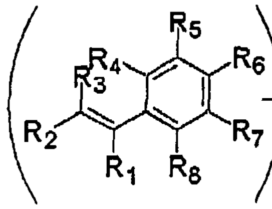 (4)

In formula (4), $R_1$ to $R_3$ each independently represents a monovalent organic group. $R_1$ to $R_3$ each independently preferably includes, for example, a hydrogen atom, a halogen atom, an amino group, a dialkylamino group, a carboxyl group, an alkoxycarbonyl group, a sulfo group, a nitro group, a cyano group, an alkyl group, an aryl group, an alkoxy group, an aryloxy group, an alkylamino group, an arylamino group, an alkylsulfonyl group and an arylsulfonyl group. Among them, a hydrogen atom, a carboxyl group, an alkoxycarbonyl group, an alkyl group or an aryl group is preferable. $R_4$ to $R_8$ each independently represents a monovalent organic group or a divalent organic group connecting to L. The monovalent organic group for any one of $R_4$ to $R_8$ preferably includes those described for the monovalent organic group for any one of $R_1$ to $R_3$ above. The divalent organic group for any one of $R_4$ to $R_8$ preferably includes divalent organic groups constituted from any of hydrogen, carbon, oxygen, nitrogen, sulfur, halogen, silicon and phosphorus. Alternatively, appropriate two of $R_4$ to $R_8$ may be combined with each other to form a ring, or any one of $R_4$ to $R_8$ may be combined with an atom constituting L to from a ring.

Examples of the substituent capable of being introduced into the organic group include those described in formula (1).

L and n have the same meanings as L and n defined in formula (1), respectively. Preferable examples of L and n are also same as those described in formula (1), respectively.

Specific examples of the polymerizable compound represented by formula (4) include an ester of a styrene containing a carboxylic acid (for example, p-styrenecarboxylic acid) or a styrene containing a sulfonic acid (for example, p-styrenesulfonic acid) with a monofunctional or polyfunctional alcohol, an amide of the styrene containing a carboxylic acid or sulfonic acid with a monofunctional or polyfunctional amine, an ester of a styrene containing a hydroxy group (for example, p-hydroxymethylstyrene, 2-hydroxyethyl p-styrenecarboxylate or 2-hydroxyethyl p-styrenesulfonate) with a monofunctional or polyfunctional carboxylic acid, a urethane of the styrene containing a hydroxy group with a monofunctional or polyfunctional iso(thio)cyanate, a substitution product of the styrene containing a hydroxy group with a monofunctional or polyfunctional halogenated alkyl or a sulfonic acid ester of a monofunctional or polyfunctional alcohol, an addition product of the styrene containing a hydroxy group with a monofunctional or polyfunctional epoxy, a substitution reaction product of a styrene containing a halogenated alkyl group (for example, p-chloromethylstyrene or 2-chloroethyl p-styrenecarboxylate) or a styrene containing a sulfonic acid ester group (for example, p-tosyloxymethylstyrene) with a nucleophilic compound, for example, a monofunctional or polyfunctional alcohol, a monofunctional or polyfunctional amine, a monofunctional or polyfunctional phosphine, a monofunctional or polyfunctional thiol, a monofunctional or polyfunctional carbonyl compound or a monofunctional or polyfunctional carboxylate, an amide of a styrene containing an amino group (for example, p-aminomethylstyrene) with a monofunctional or polyfunctional carboxylic acid, a urea of the styrene containing an amino group with a monofunctional or polyfunctional iso(thio)cyanate, a substitution product of the styrene containing an amino group with a monofunctional or polyfunctional halogenated alkyl, and a sulfonamide of the styrene containing an amino group with a monofunctional or polyfunctional sulfonic acid.

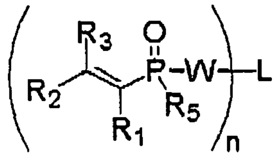 (5)

In formula (5), $R_1$ to $R_3$ each independently represents a monovalent organic group. $R_1$ to $R_3$ each independently preferably includes, for example, a hydrogen atom, a halogen atom, an amino group, a dialkylamino group, a carboxyl group, an alkoxycarbonyl group, a sulfo group, a nitro group, a cyano group, an alkyl group, an aryl group, an alkoxy group, an aryloxy group, an alkylamino group, an arylamino group, an alkylsulfonyl group and an arylsulfonyl group. Among them, a hydrogen atom, a carboxyl group, an alkoxycarbonyl group, an alkyl group or an aryl group is preferable. $R_5$ each independently represents a monovalent organic group. The monovalent organic group for $R_5$ preferably includes those described for the monovalent organic group for any one of $R_1$ to $R_3$ above. Alternatively, $R_5$ may from a ring together with L.

Examples of the substituent capable of being introduced into the organic group include those described in

formula (1). W represents an oxygen atom, a sulfur atom, -N($R_{12}$)- or -C($R_{12}R_{13}$)-. $R_{12}$ and $R_{13}$ have the same meanings as $R_{12}$ and $R_{13}$ defined in formula (1), respectively. Preferable examples of $R_{12}$ and $R_{13}$ are also same as those described in formula (1), respectively.

L and n have the same meanings as L and n defined in formula (1), respectively. Preferable examples of L and n are also same as those described in formula (1), respectively.

Specific examples of the polymerizable compound represented by formula (5) include an ester of a vinylphosphonic acid (for example, vinylphosphonic acid or methyl 2-phosphonoacrylate) with a monofunctional or polyfunctional alcohol, an amide of the vinylphosphonic acid with a monofunctional or polyfunctional amine, an ester of a vinylphosphonic acid containing a hydroxy group (for example, bis(2-hydroxyethyl) vinylphosphonic acid) with a monofunctional or polyfunctional carboxylic acid, a urethane of the vinylphosphonic acid containing a hydroxy group with a monofunctional or polyfunctional iso(thio)cyanate, a substitution product of the vinylphosphonic acid containing a hydroxy group with a monofunctional or polyfunctional halogenated alkyl or a sulfonic acid ester of a monofunctional or polyfunctional alcohol, an addition product of the vinylphosphonic acid containing a hydroxy group with a monofunctional or polyfunctional epoxy, a substitution reaction product of a vinylphosphonic acid containing a halogenated alkyl group (for example, bis(2-bromoethyl) vinylphosphonic acid) or a vinylphosphonic acid containing a sulfonic acid ester group (for example, p-tosyloxyethyl vinylphosphonic acid) with a nucleophilic compound, for example, a monofunctional or polyfunctional alcohol, a monofunctional or polyfunctional amine, a monofunctional or polyfunctional phosphine, a monofunctional or polyfunctional thiol, a monofunctional or polyfunctional carbonyl compound or a monofunctional or polyfunctional carboxylate.

Details of the method of using the polymerizable compound, for example, selection of the structure, individual or combination use or an amount added, can be appropriately determined in accordance with the characteristic design of the lithographic printing plate precursor. For instance, the compound is selected from the following standpoints.

In view of the sensitivity, a structure having a large content of unsaturated group per molecule is preferred and in many cases, a difunctional or more functional compound is preferred. Also, in order to increase the strength of the image area, that is, cured layer, a trifunctional or more functional compound is preferred. A combination use of compounds different in the functional number or in the kind of polymerizable group (for example, an acrylic acid ester, a methacrylic acid ester, a styrene compound or a vinyl ether compound) is an effective method for controlling both the sensitivity and strength.

The selection and use method of the polymerizable compound are also important factors for the compatibility and dispersibility with other components (for example, a binder polymer, a polymerization initiator or a coloring agent) in the image-forming layer. For instance, the compatibility may be improved in some cases by using the compound of low purity or using two or more kinds of the compounds in combination. A specific structure may be selected for the purpose of improving an adhesion property to a support, a protective layer or the like described hereinafter.

The polymerizable compound is used preferably in a range of 5 to 80% by weight, more preferably in a range of 25 to 75% by weight, based on the total solid content of the image-forming layer. The polymerizable compounds may be used individually or in combination of two or more thereof. The method of using the polymerizable compound can be adequately selected by taking account of the degree of polymerization inhibition due to oxygen, resolution, anti-fogging property, change in refractive index, surface tackiness and the like.

<Other constituting components of image-forming layer>

The image-forming layer according to the invention may further contain various other constituting components (additives) of image-forming layer, if desired. Other constituting components of the image-forming layer will be described blow.

(Co-sensitizer)

A co-sensitizer can be used in the image-forming layer. The co-sensitizer is an additive which can further increase the sensitivity of the image-forming layer when added to the image-forming layer. The operation mechanism of the co-sensitizer is not quite clear but may be considered to be mostly based on the following chemical process. Specifically, the co-sensitizer reacts with various intermediate active species (for example, a radical, a peroxide, an oxidizing agent or a reducing agent) generated during the process of photo-reaction initiated by light absorption of the polymerization initiator and subsequent addition-polymerization reaction to produce new active radicals. The co-sensitizers are roughly classified into (a) a compound which is reduced to produce an active radical, (b) a compound which is oxidized to produce an active radical and (c) a compound which reacts with a radical having low activity to convert it into a more highly active radical or acts as a chain transfer agent. However, in many cases, a common view about that an individual compound belongs to which type is not present.

(a) Compound which is reduced to produce an active radical

Compound having carbon-halogen bond:

An active radical is considered to be generated by the reductive cleavage of the carbon-halogen bond. Specific examples of the compound preferably used include a trihalomethyl-s-triazine and a trihalomethyloxadiazole.

Compound having nitrogen-nitrogen bond:

An active radical is considered to be generated by the reductive cleavage of the nitrogen-nitrogen bond. Specific examples of the compound preferably used include a hexaarylbiimidazole.

Compound having oxygen-oxygen bond:

An active radical is considered to be generated by the reductive cleavage of the oxygen-oxygen bond. Specific examples of the compound preferably used include an organic peroxide.

Onium compound:

An active radical is considered to be generated by the reductive cleavage of a carbon-hetero bond or oxygen-nitrogen bond Specific examples of the compound preferably used include a diaryliodonium salt, a triarylsulfonium salt and an N-alkoxypyridinium (azinium) salt.

(b) Compound which is oxidized to produce an active radical

Alkylate complex:

An active radical is considered to be generated by the oxidative cleavage of a carbon-hetero bond. Specific examples of the compound preferably used include a triaryl alkyl borate.

Alkylamine compound:

An active radical is considered to be generated by the oxidative cleavage of a C-X bond on the carbon adjacent to nitrogen, wherein X is preferably, for example, a hydrogen atom, a carboxyl group, a trimethylsilyl group or a benzyl group. Specific examples of the compound include an ethanolamine, an N-phenylglycine and an N-trimethylsilylmethylaniline.

Sulfur-containing or tin-containing compound:

A compound in which the nitrogen atom of the above-described amine is replaced by a sulfur atom or a tin atom can generate an active radical in the same manner. Also, a compound having an S-S bond is known to effect sensitization by the cleavage of the S-S bond.

$\alpha$-Substituted methylcarbonyl compound:

An active radical can be generated by the oxidative cleavage of carbonyl-$\alpha$-carbon bond. The compound in which the carbonyl is converted into an oxime ether also shows the similar function. Specific examples of the compound include an 2-alkyl-1-[4-(alkylthio)phenyl]-2-morpholinopropanone-1 and an oxime ether obtained by a reaction of the 2-alkyl-1-[4-(alkylthio)phenyl]-2-morpholinopropanone-1 with a hydroxyamine and subsequent etherification of the N-OH and an oxime ester obtained by subsequent esterification of the N-OH.

Sulfinic acid salt:

An active radical can be reductively generated. Specific examples of the compound include sodium arylsulfinate.

(c) Compound which reacts with a radical to convert it into a more highly active radical or acts as a chain transfer agent:

For example, a compound having SH, PH, SiH or GeH in its molecule is used as the compound which reacts

with a radical to convert it into a more highly active radical or acts as a chain transfer agent. The compound donates hydrogen to a low active radical species to generate a radical or is oxidized and deprotonized to generate a radical. The chain transfer agent contributes to improvements in the sensitivity and preservation stability.

A thiol compound (for example, a 2-mercaptobenzimidazole) is preferably used as the chain transfer agent. Among them, a thiol compound represented by formula (T) shown below is particularly preferably used. By using the thiol compound represented by formula (T) as the chain transfer agent, a problem of the odor and decrease in sensitivity due to evaporation of the compound from the image-forming layer or diffusion thereof into other layers are avoided and a lithographic printing plate precursor which is excellent in preservation stability and exhibits high sensitivity and good printing durability is obtained.

Formula (T):

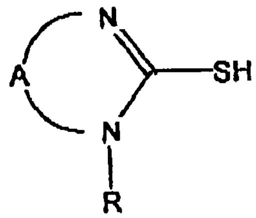

In formula (T), R represents a hydrogen atom, an alkyl group or an aryl group, A represents an atomic group necessary for forming a 5-membered or 6-membered hetero ring containing a carbon atom together with the N=C-N linkage, and A may have a substituent.

Compounds represented by any one of formulae (TA) and (TB) shown below are more preferably used.

Formula (TA)

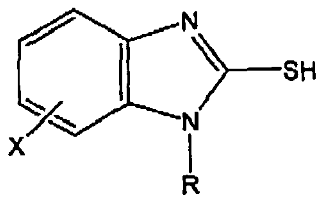

Formula (TB)

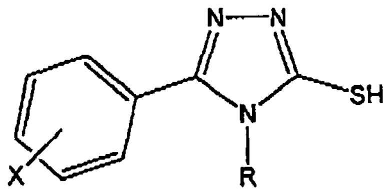

In formulae (TA) and (TB), R represents a hydrogen atom, an alkyl group or an aryl group, and X represents a hydrogen atom, a halogen atom, an alkoxy group, an alkyl group or an aryl group.

Specific examples of the compound represented by formula (T) are set forth below, but the invention should not be construed as being limited thereto.

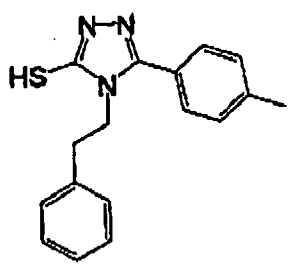

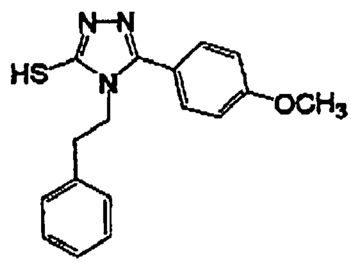

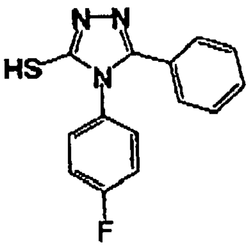

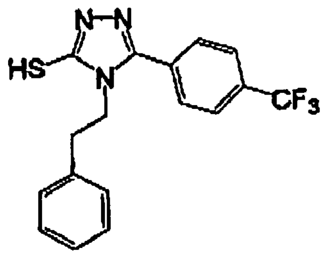

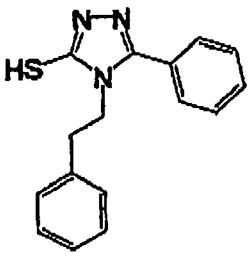

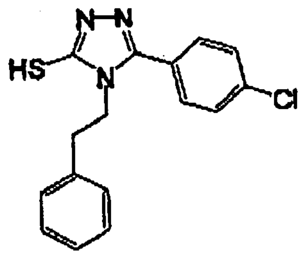

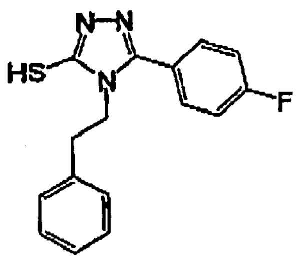

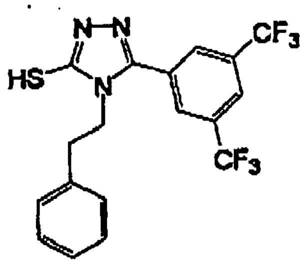

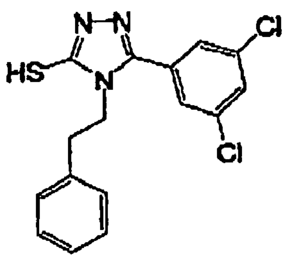

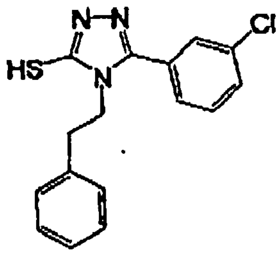

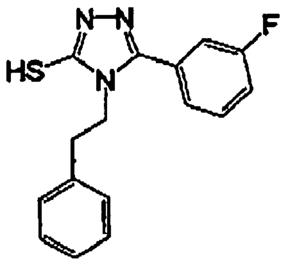

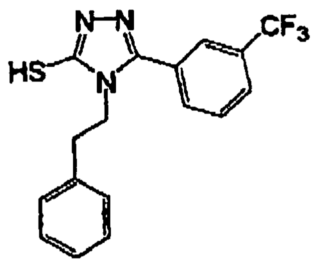

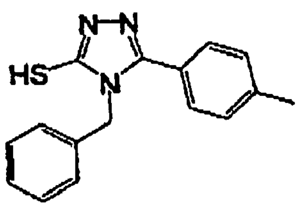

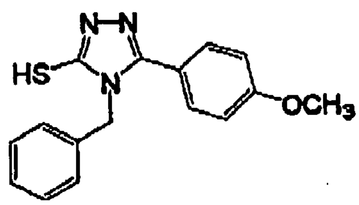

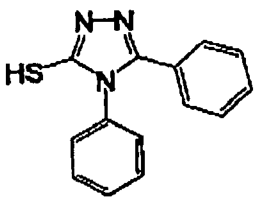

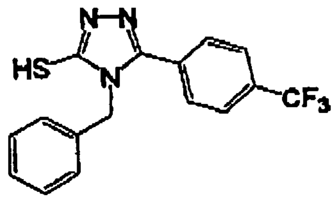

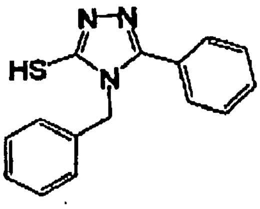

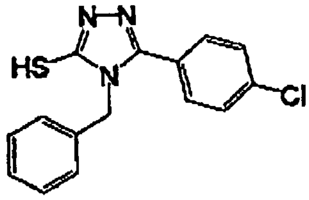

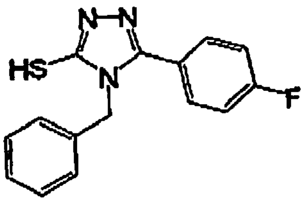

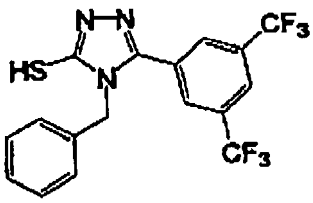

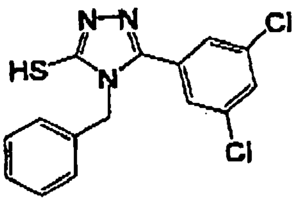

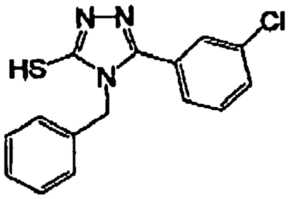

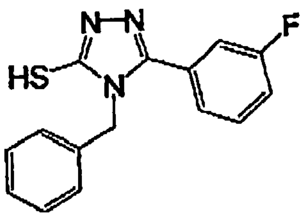

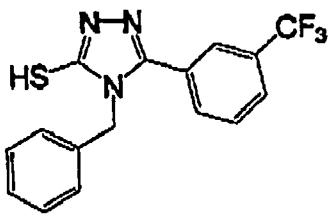

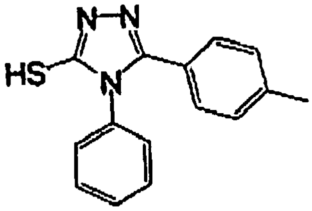

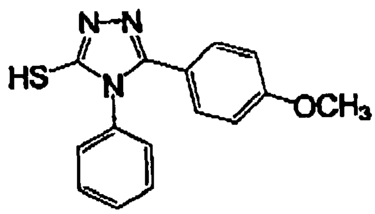

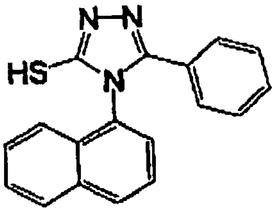
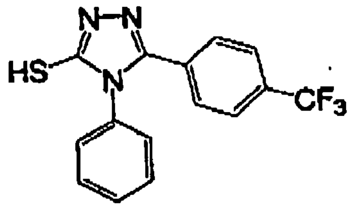
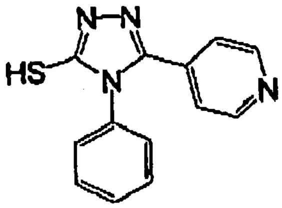
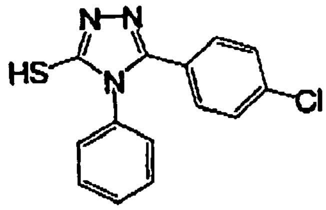
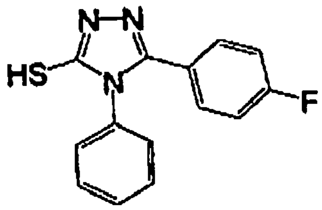
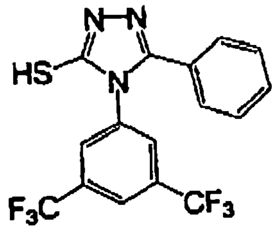
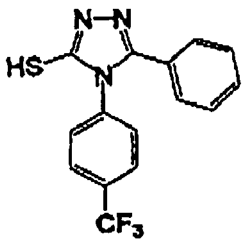
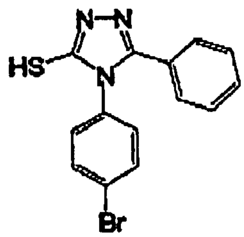
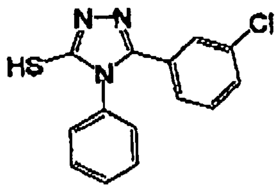
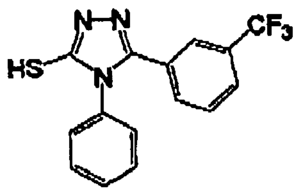
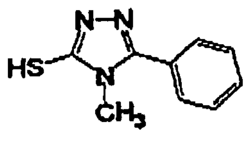
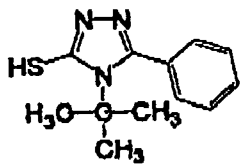
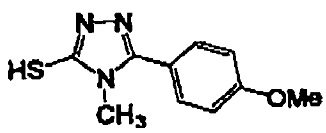
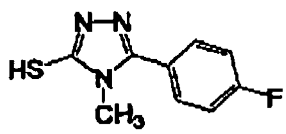

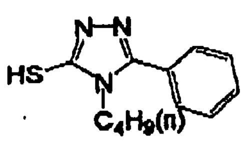

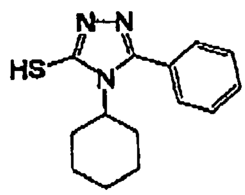

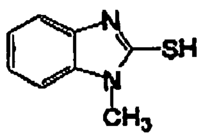

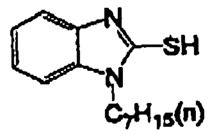

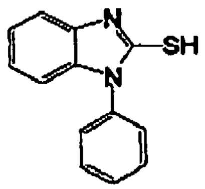

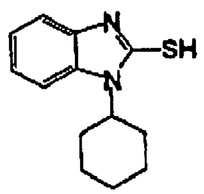

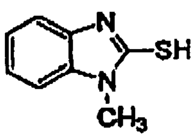

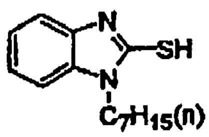

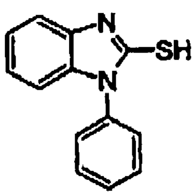

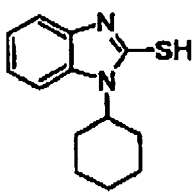

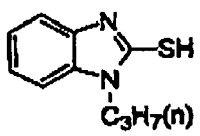

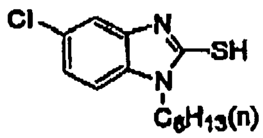

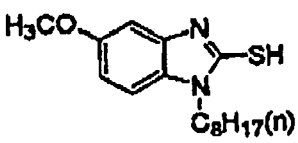

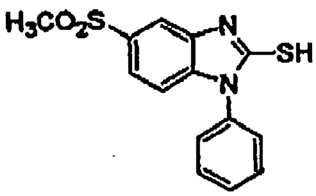

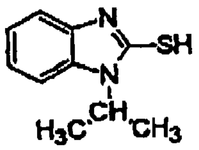
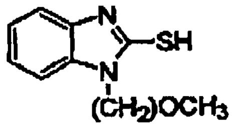
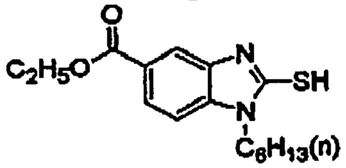
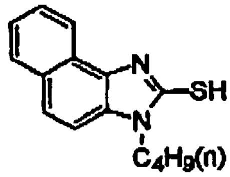
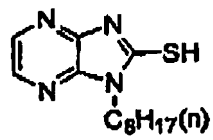
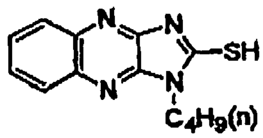
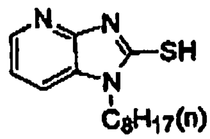
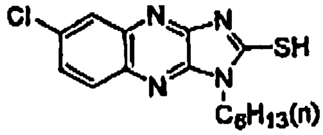
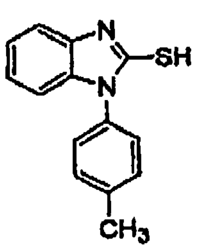
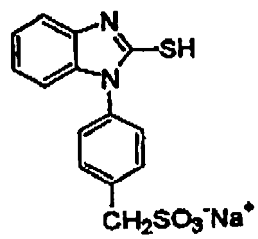

The amount of the chain transfer agent used is preferably from 0.01 to 20% by weight, more preferably from 0.1 to 15% by weight, still more preferably from 1.0 to 10% by weight, based on the total solid content of the image-forming layer.

Other specific examples of the co-sensitizer include compounds described, for example, in JP-A-9-236913 as additives for the purpose of increasing sensitivity. Some of them are set forth below, but the invention should not be construed as being limited thereto.

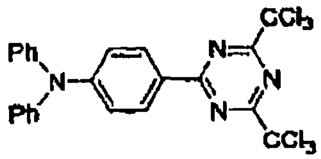
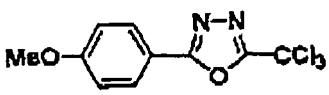
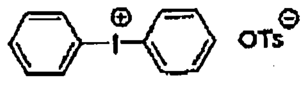
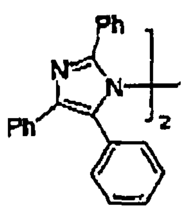
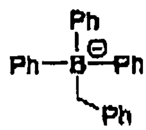
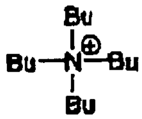
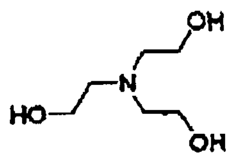

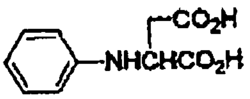
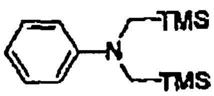
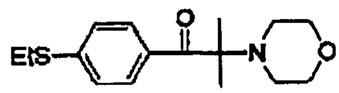
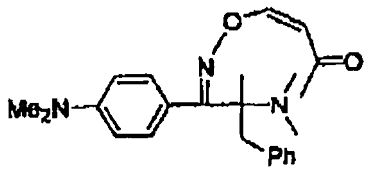
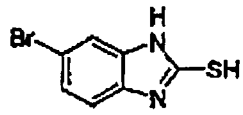

The co-sensitizers may be used individually or in combination of two or more thereof. The amount of the co-sensitizer used is ordinarily from 0.05 to 100 parts by weight, preferably from I to 80 parts by weight, more preferably from 3 to 50 parts by weight, per 100 parts by weight of the polymerizable compound.

(Surfactant)

Into the image-forming layer, a surfactant can be incorporated in order to progress the developing property and to improve the state of surface coated. The surfactant includes, for example, a nonionic surfactant, an anionic surfactant, a cationic surfactant, an amphoteric surfactant and a fluorine-based surfactant.

The nonionic surfactant for use in the invention is not particular restricted, and nonionic surfactants hitherto known can be used. Examples of the nonionic surfactant include polyoxyethylene alkyl ethers, polyoxyethylene alkyl phenyl ethers, polyoxyethylene polystyryl phenyl ethers, polyoxyethylene polyoxypropylene alkyl ethers, glycerin fatty acid partial esters, sorbitan fatty acid partial esters, pentaerythritol fatty acid partial esters, propylene glycol monofatty acid esters, sucrose fatty acid partial esters, polyoxyethylene sorbitan fatty acid partial esters, polyoxyethylene sorbitol fatty acid partial esters, polyethylene glycol fatty acid esters, polyglycerol fatty acid partial esters, polyoxyethylenated castor oils, polyoxyethylene glycerol fatty acid partial esters, fatty acid diethanolamides, N,N-bis-2-hydroxyalkylamines, polyoxyethylene alkylamines, triethanolamine fatty acid esters, trialylamine oxides, polyethylene glycols and copolymer of polyethylene glycol and polypropylene glycol.

The anionic surfactant for use in the invention is not particularly restricted and anionic surfactants hitherto known can be used. Examples of the anionic surfactant include fatty acid salts, abietic acid salts, hydroxyalkanesulfonic acid salts, alkanesulfonic acid salts, dialkylsulfosuccinic ester salts, straight-chain alkylbenzenesulfonic acid salts, branched alkylbenzenesulfonic acid salts, alkylnaphthalenesulfonic acid salts, alkylphenoxy polyoxyethylene propylsulfonic acid salts, polyoxyethylene alkylsulfophenyl ether salts, N-methyl-N-oleyltaurine sodium salt, N-alkylsulfosuccinic monoamide disodium salts, petroleum sulfonic acid salts, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styrylphenyl ether sulfate ester salts, alkyl phosphate ester salts, polyoxyethylene alkyl ether phosphate ester salts, polyoxyethylene alkyl phenyl ether phosphate ester salts, partial saponification products of styrene/maleic anhydride copolymer, partial saponification products of olefin/maleic anhydride copolymer and naphthalene sulfonate formalin condensates.

The cationic surfactant for use in the invention is not particularly restricted and cationic surfactants hitherto known can be used. Examples of the cationic surfactant include alkylamine salts, quaternary ammonium salts, polyoxyethylene alkylamine salts and polyethylene polyamine derivatives.

The amphoteric surfactant for use in the invention is not particularly restricted and amphoteric surfactants hitherto known can be used. Examples of the amphoteric surfactant include carboxybetaines, aminocarboxylic acids, sulfobetaines, aminosulfuric esters and imidazolines.

With respect to the surfactants described above, the term "polyoxyethylene" can be replaced with "polyoxyalkylene", for example, polyoxymethylene, polyoxypropylene or polyoxybutylene, and such surfactants can also be used in the invention.

Further, a preferable surfactant includes a fluorine-based surfactant containing a perfluoroalkyl group in its molecule. Examples of the fluorine-based surfactant include an anionic type, for example, perfluoroalkyl carboxylates, perfluoroalkyl sulfonates or perfluoroalkyl phosphates; an amphoteric type, for example, perfluoroalkyl betaines; a cationic type, for example, perfluoroalkyl trimethyl ammonium salts; and a nonionic type, for example, perfluoroalkyl amine oxides, perfluoroalkyl ethylene oxide adducts, oligomers having a perfluoroalkyl group and a hydrophilic group, oligomers having a perfluoroalkyl group and an oleophilic group, oligomers having a perfluoroalkyl group, a hydrophilic group and an oleophilic group or urethanes having a perfluoroalkyl group and an oleophilic group. Also, fluorine-based surfactants described in JP-A-62-170950, JP-A-62-226143 and JP-A-60-168144 are also preferably exemplified.

The surfactants may be used individually or in combination of two or more thereof. The content of the surfactant is preferably from 0.001 to 10% by weight, more preferably from 0.01 to 7% by weight, based on the total solid content of the image-forming layer.

(Hydrophilic polymer)

Into the image-forming layer, a hydrophilic polymer can be incorporated in order to improve the developing property and dispersion stability of microcapsule.
Preferable examples of the hydrophilic polymer include those having a hydrophilic group, for example, a hydroxy group, a carboxyl group, a carboxylate group, a hydroxyethyl group, a polyoxyethyl group, a hydroxypropyl group, a polyoxypropyl group, an amino group, an aminoethyl group, an aminopropyl group, an ammonium group, an amido group, a carboxymethyl group, a sulfonic acid group and a phosphoric acid group.
Specific examples of the hydrophilic polymer include gum arabic, casein, gelatin, a starch derivative, carboxymethyl cellulose or sodium salt thereof, cellulose acetate, sodium alginate, a vinyl acetate-maleic acid copolymer, a styrene-maleic acid copolymer, polyacrylic acid or salt thereof, polymethacrylic acid or salt thereof, a homopolymer or copolymer of hydroxyethyl methacrylate, a homopolymer or copolymer of hydroxyethyl acrylate, a homopolymer or copolymer of hydroxypropyl methacrylate, a homopolymer or copolymer of hydroxypropyl acrylate, a homopolymer or copolymer of hydroxybutyl methacrylate, a homopolymer or copolymer of hydroxybutyl acrylate, polyethylene glycol, a hydroxypropylene polymer, polyvinyl alcohol, a hydrolyzed polyvinyl acetate having a hydrolysis degree of 60% by mole or more, preferably 80% by mole or more, polyvinyl formal, polyvinyl butyral, polyvinyl pyrrolidone, a homopolymer or polymer of acrylamide, a homopolymer or copolymer of methacrylamide, a homopolymer or copolymer of N-methylolacrylamide, polyvinyl pyrrolidone, an alcohol-soluble nylon, and a polyether of 2,2-bis(4-hydroxyphenyl)propane with epichlorohydrin.
The weight average molecular weight of the hydrophilic polymer is preferably 5,000 or more, more preferably from 10,000 to 300,000. The hydrophilic polymer may be any of a random polymer, a block polymer, a graft polymer and the like. The content of the hydrophilic polymer is preferably 20% by weight or less, more preferably 10% by weight or less, based on the total solid content of the image-forming layer.

(Coloring agent)

Into the image-forming layer, a dye having large absorption in the visible light region can be used as a coloring agent for the image. Specific examples thereof include Oil Yellow #101, Oil Yellow #103, Oil Pink #312, Oil Green BG, Oil Blue BOS, Oil Blue #603, Oil Black BY, Oil Black BS, Oil Black T-505 (produced by Orient Chemical Industry Co., Ltd.), Victoria Pure Blue, Crystal Violet (CI42555), Methyl Violet (CI42535), Ethyl Violet, Rhodamine B (CI45170B), Malachite Green (CI42000), Methylene Blue (CI52015), and dyes described in JP-A-62-293247. Also, a pigment, for example, phthalocyanine-based pigment, azo-based pigment, carbon black and titanium oxide can be preferably used.
It is preferable to add the coloring agent, because after the image formation, the image area and the non-image area can be easily distinguished. The amount of the coloring agent added is preferably from 0.01 to 10% by weight based on the total solid content of the image-forming layer.

(Print-out agent)

To the image-forming layer, a compound capable of undergoing discoloration with an acid or a radical can be added in order to form a print-out image. As such a compound, for example, various dyes, e.g., diphenylmethane-based, triphenylmethane-based, thiazine-based, oxazine-based, xanthene-based, anthraquinone-based, iminoquinone-based, azo-based and azomethine-based dyes are effectively used.
Specific examples thereof include dyes, for example, Brilliant Green, Ethyl Violet, Methyl Green, Crystal Violet, Basic Fuchsine, Methyl Violet 2B, Quinaldine Red, Rose Bengale, Metanil Yellow, Thymolsulfophthalein, Xylenol Blue, Methyl Orange, Paramethyl Red, Congo Red, Benzopurpurine 4B, $\alpha$-Naphthyl Red, Nile Blue 2B, Nile Blue A, Methyl Violet, Malachite Green, Parafuchsine, Victoria Pure Blue BOH (produced by Hodogaya Chemical Co., Ltd.), Oil Blue #603, Oil Pink #312, Oil Red 5B, Oil Scarlet #308, Oil Red OG, Oil Red RR and Oil Green #502 (produced by Orient Chemical Industry Co., Ltd.), Spiron Red BEH Special (produced by Hodogaya Chemical Co., Ltd.), m-Cresol Purple, Cresol Red, Rhodamine B, Rhodamine 6G, Sulforhodamine B, Auramine, 4-p-diethylaminophenyliminonaphthoquinone, 2-carboxyanilino-4-p-diethylaminophenyliminonaphthoquinone, 2-carboxystearylamino-4-p-N,N-bis(hydroxyethyl)aminophenyliminonaphthoquinone, 1-phenyl-3-methyl-4-p-diethylaminophenylimino-5-pyrazolone and 1-$\beta$-naphthyl-4-p-diethylaminophenylimino-5-pyrazolone, and leuco dyes, for example, p,p',p''-hexamethyltriaminotriphenyl methane (leuco Crystal Violet) and Pergascript Blue SRB (produced by Ciba Geigy).
Other preferable examples include leuco dyes which are known as a material for heat-sensitive paper or

pressure-sensitive paper. Specific examples thereof include Crystal Violet Lactone, Malachite Green Lactone, Benzoyl Leuco Methylene Blue, 2-(N-phenyl-N-methylamino)-6-(N-p-tolyl-N-ethyl)aminofluorane, 2-anilino-3-methyl-6-(N-ethyl-p-toluidino)fluorane, 3,6-dimethoxyfluorane, 3-(N,N-diethylamino)-5-methyl-7-(N,N-dibenzylamino)fluorane, 3-(N-cyclohexyl-N-methylamino)-6-methyl-7-anilinofluorane, 3-(N,N-diethylamino)-6-methyl-7-anilinofluorane, 3-(N,N-diethylamino)-6-methyl-7-xylidinofluorane, 3-(N,N-diethylamino)-6-methyl-7-chlorofluorane, 3-(N,N-diethylamino)-6-methoxy-7-aminofluorane, 3-(N,N-diethylamino)-7-(4-chloroanilino)fluorane, 3-(N,N-diethylamino)-7-chlorofluorane, 3-(N,N-diethylamino)-7-benzylaminofluorane, 3-(N,N-diethylamino)-7,8-benzofluorane, 3-(N,N-dibutylamino)-6-methyl-7-anilinofluorane, 3-(N,N-dibutylamino)-6-methyl-7-xylidinofluorane, 3-piperidino-6-methyl-7-anilinofluorane, 3-pyrrolidino-6-methyl-7-anilinofluorane, 3,3-bis(1-ethyl-2-methylindol-3-yl)phthalide, 3,3-bis(1-n-butyl-2-methylindol-3-yl)phthalide, 3,3-bis(p-dimethylaminophenyl)-6-dimethylaminophthalide, 3-(4-diethylamino-2-ethoxyphenyl)-3-(1-ethyl-2-methylindol-3-yl)-4-azaphthalide and 3-(4-diethylaminophenyl)-3-(1-ethyl-2-methylindol-3-yl)phthalide.

The amount of the compound capable of undergoing discoloration with an acid or a radical added is preferably from 0.01 to 15% by weight based on the total solid content of the image-forming layer.

(Thermal polymerization inhibitor)

It is preferred to add a small amount of a thermal polymerization inhibitor to the image-forming layer in order to inhibit undesirable thermal polymerization of the polymerizable compound during the production or preservation of the image-forming layer.

The thermal polymerization inhibitor preferably includes, for example, hydroquinone, p-methoxyphenol, di-tert-butyl-p-cresol, pyrogallol, tert-butyl catechol, benzoquinone, 4,4'-thiobis(3-methyl-6-tert-butylphenol), 2,2'-methylenebis(4-methyl-6-tert-butylphenol) and N-nitroso-N-phenylhydroxylamine aluminum salt.

The amount of the thermal polymerization inhibitor added is preferably from about 0.01 to about 5% by weight based on the total solid content of the image-forming layer.

(Higher fatty acid derivative)

To the image-forming layer, a higher fatty acid derivative, for example, behenic acid or behenic acid amide may be added and localized on the surface of the image-forming layer during the process of drying after coating in order to avoid polymerization inhibition due to oxygen. The amount of the higher fatty acid derivative added is preferably from about 0.1 to about 10% by weight based on the total solid content of the image-forming layer.

(Plasticizer)

The image-forming layer may contain a plasticizer. Preferable examples of the plasticizer include a phthalic acid ester, for example, dimethyl phthalate, diethyl phthalate, dibutyl phthalate, diisobutyl phthalate, diocyl phthalate, octyl capryl phthalate, dicyclohexyl phthalate, ditridecyl phthalate, butyl benzyl phthalate, diisodecyl phthalate or diallyl phthalate; a glycol ester, for example, dimethyl glycol phthalate, ethyl phthalylethyl glycolate, methyl phthalylethyl glycolate, butyl phthalylbutyl glycolate or triethylene glycol dicaprylic acid ester; a phosphoric acid ester, for example, tricresyl phosphate or triphenyl phosphate; an aliphatic dibasic acid ester, for example, diisobutyl adipate, dioctyl adipate, dimethyl sebacate, dibutyl sebacate, dioctyl azelate or dibutyl maleate; polyglycidyl methacrylate, triethyl citrate, glycerin triacetyl ester and butyl laurate. The content of the plasticizer is preferably about 30% by weight or less based on the total solid content of the image-forming layer.

(Fine inorganic particle)

The image-forming layer may contain fine inorganic particle in order to increase strength of the cured layer in the image area. The fine inorganic particle preferably includes, for example, silica, alumina, magnesium oxide, titanium oxide, magnesium carbonate, calcium alginate and a mixture thereof. Even if the fine inorganic particle has no light-to-heat converting property, it can be used, for example, for strengthening the film or enhancing interface adhesion property due to surface roughening. The average particle size of the fine inorganic particle is preferably from 5 nm to 10 $\mu$m, more preferably from 0.5 to 3$\mu$m, from the standpoint of the dispersion stability in the image-forming layer, retention of sufficient film strength and formation of the non-image area excellent in hydrophilicity and preventing from the occurrence of stain at the printing. The fine inorganic particle is easily available as a commercial product, for example, colloidal silica dispersion. The content of the fine inorganic particle is preferably 20% by weight or less, more preferably 10% by weight or less, based on the total solid content of the image-forming layer.

(Hydrophilic low molecular weight compound)

The image-forming layer may contain a hydrophilic low molecular weight compound in order to improve the developing property. Examples of the hydrophilic low molecular weight compound include a water-soluble organic compound, for example, a glycol compound, e.g., ethylene glycol, diethylene glycol, triethylene glycol, propylene glycol, dipropylene glycol or tripropylene glycol, or an ether or ester derivative thereof, a polyhydroxy compound, e.g., glycerine or pentaerythritol, an organic amine, e.g., triethanol amine, diethanol amine or monoethanol amine, or a salt thereof, an organic sulfonic acid, e.g., toluene sulfonic acid or benzene sulfonic acid, or a salt thereof, an organic phosphonic acid, e.g., phenyl phosphonic acid, or a salt thereof, an organic carboxylic acid, e.g., tartaric acid, oxalic acid, citric acid, maleic acid, lactic acid, gluconic acid or an amino acid, or a salt thereof, and an organic quaternary ammonium salt, e.g., tetraethyl amine hydrochloride.

(Formation of image-forming layer)

Several embodiments can be employed in order to form the image-forming layer. One embodiment is a method of dissolving the constituting components of image-forming layer in an appropriate solvent to be applied to the below-mentioned support as described, for example, in JP-A-2002-287334. The solvent used include, for example, ethylene dichloride, cyclohexanone, methyl ethyl ketone, methanol, ethanol, propanol, ethylene glycol monomethyl ether, 1-methoxy-2-propanol, 2-methxyethyl acetate, 1-methoxy-2-propyl acetate, dimethoxyethane, methyl lactate, ethyl lactate, N,N-dimethylacetamide, N,N-dimethylformamide, tetramethylurea, N-methylpyrrolidone, dimethylsulfoxide, sulfolane, $\gamma$-butyrolactone, toluene and water. The solvents may be used individually or as a mixture. Another embodiment is a method (image-forming layer of microcapsule type) of encapsulating the constituting components of image-forming layer into microcapsule to incorporate into the image-forming layer as described, for example, in JP-A-2001-277740 and JP-A-2001-277742. In the image-forming layer of microcapsule type, the constituting components may be present outside the microcapsules. It is a more preferable embodiment of the image-forming layer of microcapsule type that the hydrophobic constituting components are encapsulated in microcapsules and the hydrophilic constituting components are present outside the microcapsules.

As a method for microencapsulation of the constituting component of image-forming layer, known methods can be used. Methods of producing the microcapsule include, for example, a method of utilizing coacervation described in U.S. Patents 2,800,457 and 2,800,458, a method of using interfacial polymerization described in U.S. Patent 3,287,154, JP-B-38-19574 and JP-B-42-446, a method of using deposition of polymer described in U.S. Patents 3,418,250 and 3,660,304, a method of using an isocyanate polyol wall material described in U.S. Patent 3,796,669, a method of using an isocyanate wall material described in U.S. Patent 3,914,511, a method of using a urea-formaldehyde-type or urea-formaldehyde-resorcinol-type wall-forming material described in U.S. Patens 4,001,140, 4,087,376 and 4,089,802, a method of using a wall material, for example, a melamine-formaldehyde resin or hydroxycellulose described in U.S. Patent 4,025,445, an in-situ method by monomer polymerization described in JP-B-36-9163 and JP-B-51-9079, a spray drying method described in British Patent 930,422 and U.S. Patent 3,111,407, and an electrolytic dispersion cooling method described in British Patents 952,807 and 967,074.

A preferable microcapsule wall used in the invention has three-dimensional crosslinkage and has a solvent-swellable property. From this point of view, a preferable wall material of the microcapsule includes polyurea, polyurethane, polyester, polycarbonate, polyamide and a mixture thereof, and polyurea and polyurethane are particularly preferred. Further, a compound having a crosslinkable functional group, for example, an ethylenically unsaturated bond may be introduced into the microcapsule wall.

The average particle size of the microcapsule is preferably from 0.01 to 3.0 $\mu$m, more preferably from 0.05 to 2.0 $\mu$m, still more preferably from 0.10 to 1.0 $\mu$m from the standpoint of good resolution and good preservation stability.

Further, an embodiment of incorporating the constituting component of image-forming layer described above, particularly preferably, the infrared absorbing agent, into fine resin particles is also used according to the invention.

The embodiment is performed by dissolving the constituting component of image-forming layer in a solvent and mixing the resulting solution with a polymer solution (preferably an aqueous polymer solution) using, for example, a homogenizer to prepare a dispersion of fine resin particles for use.

As the solvent used, ethyl acetate, methyl ethyl ketone (MEK), diisopropyl ether, dichloromethane, chloroform, toluene, dichloroethane and mixed solvents thereof are exemplified. The solvents may be used individually or as a mixture.

As the polymer, polyvinyl alcohol (PVA), polyacrylic acid, sodium polyacrylate, polyacrylamide, polymethacrylic acid, sodium polymethacrylate, polymethacrylamide, polystyrenesulfonic acid, sodium polystyrenesulufonate, acrylic acid/methyl acrylate copolymer, methacrylic acid/methyl methacrylate copolymer and styrene/sodium styrenesulufonate copolymer are exemplified.

The solid concentration of the coating solution for image-forming layer is preferably from 1 to 50% by weight.

The image-forming layer may also be formed by preparing plural coating solutions by dispersing or dissolving

the same or different constituting components into the same or different solvents and conducting repeatedly the coating and drying plural times.

The coating amount (solid content) of the image-forming layer may be varied according to the use, but ordinarily, it is preferably from 0.3 to 3.0 g/$m^2$ in consideration of good sensitivity, good film property of the image-forming layer and the like.

Various methods can be used for the coating of the image-forming layer. Examples of the coating method include bar coater coating, spin coating, spray coating, curtain coating, dip coating, air knife coating, blade coating and roll coating.

The image-forming layer coated on a support according to the method described above is dried to remove the solvent used. The drying method includes, for example, a method of blowing hot air on the surface coated and a method of keeping in a heating oven for a certain period of time. In order to prepare the lithographic printing plate precursor for use in the plate making method according to the invention, at the drying described above, the surface of support is preferably maintained at temperature lower than the heat fusion temperature of fine heat-fusible resin particle contained in the image-forming layer and more preferably at least 5°C lower than the heat fusion temperature of fine heat-fusible resin particle. By maintaining the drying temperature described above, the fine heat-fusible resin particles contained in the image-forming layer can be kept in their fine particle morphology.

(Support)

The support for use in the lithographic printing plate precursor according to the invention is not particularly restricted as long as it is a dimensionally stable plate-like hydrophilic support. The support includes, for example, paper, paper laminated with plastic (for example, polyethylene, polypropylene or polystyrene), a metal plate (for example, aluminum, zinc or copper plate), a plastic film (for example, cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate or polyvinyl acetal film) and paper or a plastic film laminated or deposited with the metal described above. Preferable examples of the support include a polyester film and an aluminum plate. Among them, the aluminum plate is preferred since it has good dimensional stability and is relatively inexpensive.

The aluminum plate includes a pure aluminum plate, an alloy plate comprising aluminum as a main component and containing a trace amount of hetero element and a thin film of aluminum or aluminum alloy laminated with plastic. The hetero element contained in the aluminum alloy includes, for example, silicon, iron, manganese, copper, magnesium, chromium, zinc, bismuth, nickel and titanium. The content of the hetero element in the aluminum alloy is preferably 10% by weight or less. Since completely pure aluminum is difficult to be produced in view of the refining technique, an aluminum alloy plate containing a slight amount of hetero element is preferably used. The composition of the aluminum plate is not limited and those materials known and used conventionally can be appropriately utilized. The thickness of the aluminum plate is preferably from 0.1 to 0.6 mm, more preferably from 0.15 to 0.4 mm, and still more preferably from 02 to 0.3 mm.

The aluminum plate is preferably subjected to a surface treatment, for example, roughening treatment or anodizing treatment The surface treatment facilitates improvement in the hydrophilic property and ensures the adhesion property between the image-forming layer and the support. In advance of the roughening treatment of the aluminum plate, a degreasing treatment, for example, with a surfactant, an organic solvent or an aqueous alkaline solution is conducted for removing rolling oil on the surface thereof, if desired.

The roughening treatment of the surface of the aluminum plate is conducted by various methods and includes, for example, mechanical roughening treatment, electrochemical roughening treatment (roughening treatment of electrochemically dissolving the surface) and chemical roughening treatment (roughening treatment of chemically dissolving the surface selectively). As the method of the mechanical roughening treatment, a known method, for example, a ball graining method, a brush graining method, a blast graining method or a buff graining method can be used. The electrochemical roughening treatment method includes, for example, a method of conducting it by passing alternating current or direct current in an electrolytic solution containing an acid, for example, hydrochloric acid or nitric acid. Also, a method of using a mixed acid described in JP-A-54-63902 can be used.

The aluminum plate after the roughening treatment is then subjected, if desired, to an alkali etching treatment using an aqueous solution, for example, of potassium hydroxide or sodium hydroxide and further subjected to a neutralizing treatment, and then subjected to an anodizing treatment in order to enhance the abrasion resistance, if desired.

For the anodizing treatment of the aluminum plate, various electrolytes capable of forming porous oxide film can be used. Ordinarily, sulfuric acid, hydrochloric acid, oxalic acid, chromic acid or a mixed acid thereof is used. The concentration of the electrolyte can be appropriately determined depending on the kind of the electrolyte.

Since the conditions of the anodizing treatment are varied depending on the electrolyte used, they cannot be defined generally. However, it is ordinarily preferred that electrolyte concentration in the solution is from 1 to 80% by weight, liquid temperature is from 5 to 70°C, current density is from 5 to 60 A/d$m^2$, voltage is from 1 to 100 V, and

electrolysis time is from 10 seconds to 5 minutes. The amount of the anodized film formed is preferably from 1.0 to 5.0 g/m$^2$, more preferably from 1.5 to 4.0 g/m$^2$, from the standpoint of good printing durability, good scratch resistance in the non-image area and the like.

The aluminum plate subjected to the surface treatment and having the anodized film is used as it is as the support. However, in order to more improve the adhesion property to a layer provided thereon, hydrophilicity, resistance to stain, heat insulating property or the like, a known treatment, for example, a treatment for enlarging micropores or a sealing treatment of micropores of the anodized film described in JP-A-2001-253181 and JP-A-2001-322365, or a surface hydrophilizing treatment by immersing the aluminum plate in an aqueous solution containing a hydrophilic compound, may be appropriately conducted.

As the sealing treatment, a sealing treatment with water vapor, a sealing treatment with an aqueous solution containing an inorganic fluorine compound, for example, fluorozirconic acid alone or sodium fluoride, a sealing treatment with steam having lithium chloride added thereto or a sealing treatment with hot water may be employed. Among them, the sealing treatment with an aqueous solution containing an inorganic fluorine compound, the sealing treatment with water vapor and the sealing treatment with hot water are preferred.

The hydrophilizing treatment includes an alkali metal silicate method described in U.S. Patents 2,714,066, 3,181,461, 3,280,734 and 3,902,734. According to the method, the support is subjected to an immersion treatment or an electrolytic treatment in an aqueous solution, for example, of sodium silicate. In addition, the hydrophilizing treatment includes, for example, a method of treating with potassium fluorozirconate described in JP-B-36-22063 and a method of treating with polyvinylphosphonic acid described in U.S. Patents 3,276,868, 4,153,461 and 4,689,272.

In the case of using a support having a surface of insufficient hydrophilicity, for example, a polyester film, it is desirable to coat a hydrophilic layer thereon to make the surface sufficiently hydrophilic. Examples of the hydrophilic layer preferably includes a hydrophilic layer formed by coating a coating solution containing a colloid of oxide or hydroxide of at least one element selected from beryllium, magnesium, aluminum, silicon, titanium, boron, germanium, tin, zirconium, iron, vanadium, antimony and a transition metal described in JP-A-2001-199175, a hydrophilic layer containing an organic hydrophilic matrix obtained by crosslinking or pseudo-crosslinking of an organic hydrophilic polymer described in JP-A-2002-79772, a hydrophilic layer containing an inorganic hydrophilic matrix obtained by sol-gel conversion comprising hydrolysis and condensation reaction of polyalkoxysilane and titanate, zirconate or aluminate, and a hydrophilic layer comprising an inorganic thin layer having a surface containing metal oxide. Among them, the hydrophilic layer formed by coating a coating solution containing a colloid of oxide or hydroxide of silicon is preferred.

Further, in the case of using, for example, a polyester film as the support, it is preferred to provide an antistatic layer on the hydrophilic layer side, opposite side to the hydrophilic layer or both sides. When the antistatic layer is provided between the support and the hydrophilic layer, it also contributes to improve the adhesion property of the hydrophilic layer to the support. As the antistatic layer, for example, a polymer layer containing fine particles of metal oxide or a matting agent dispersed therein described in JP-A-2002-79772 can be used.

The center line average roughness of support is preferably from 0.10 to 1.2 $\mu$m from the standpoint of good adhesion property to the image-forming layer, good printing durability, good resistance to stain and the like. The color density of the support is preferably from 0.15 to 0.65 in terms of the reflection density value from the standpoint of good image-forming property by preventing halation at the image exposure, good aptitude for plate inspection after development and the like.

(Undercoat layer)

In the lithographic printing plate precursor according to the invention, an undercoat layer may be provided between the image-forming layer and the support, if desired. The undercoat layer has the function of strengthening the adhesion property between the support and the image-forming layer in the exposed area and the function of facilitating separation of the image-forming layer from the support in the unexposed area, thereby improving the developing property.

As the compound for the undercoat layer, specifically, a silane coupling agent having an addition-polymerizable ethylenic double bond reactive group described in JP-A-10-282679 and a phosphorus compound having an ethylenic double bond reactive group described in JP-A-2-304441 are preferably exemplified.

In the undercoat layer, a known resin having a hydrophilic group can also be used. Specific examples of the resin include gum arabic, casein, gelatin, a starch derivative, carboxy methyl cellulose or sodium salt thereof, cellulose acetate, sodium alginate, a vinyl acetate-maleic acid copolymer, a styrene-maleic acid copolymer, polyacrylic acid or salt thereof, polymethacrylic acid or salt thereof, a homopolymer or copolymer of hydroxyethyl methacrylate, a homopolymer or copolymer of hydroxyethyl acrylate, a homopolymer or copolymer of hydroxypropyl methacrylate, a homopolymer or copolymer of hydroxypropyl acrylate, a homopolymer or copolymer of hydroxybutyl methacrylate, a homopolymer or copolymer of hydroxybutyl acrylate, a polyethylene glycol, a hydroxypropylene polymer, a polyvinyl alcohol, a hydrolyzed polyvinyl acetate having a hydrolysis degree of 60% by mole or more, preferably 80% by mole or more, polyvinyl formal, polyvinyl butyral, polyvinyl pyrrolidone, a homopolymer or copolymer of acrylamide, a homopolymer or polymer of methacrylamide, a homopolymer or copolymer of N-methylolacrylamide, polyvinyl pyrrolidone, an alcohol-soluble nylon, a polyether of 2,2-bis(4-hydroxyphenyl)propane and epichlorohydrin.

The polymer compound for use in the undercoat layer preferably has adsorptivity to the surface of support. Whether the adsorptivity to the surface of support is present or not can be judged, for example, by the following method.

Specifically, a test compound is dissolved in a solvent in which the test compound is easily soluble to prepare a coating solution, and the coating solution is coated and dried on a support so as to have the coating amount after drying of 30 $mg/m^2$. After thoroughly washing the support coated with the test compound using the solvent in which the test compound is easily soluble, the residual amount of the test compound that has not been removed by the washing is measured to calculate the adsorption amount to the support. For measurement of the residual amount, the amount of the residual test compound may be directly determined, or it may be calculated from the amount of the test compound dissolved in the washing solution. The determination for the compound can be performed, for example, by fluorescent X-ray measurement, reflection spectral absorbance measurement or liquid chromatography measurement. The compound having the adsorptivity to support means a compound that remains by 1 $mg/m^2$ or more even after conducting the washing treatment described above.

Impartation of the adsorptivity to the surface of support to the polymer compound can be performed by introduction of the adsorbing group into the polymer compound. The adsorbing group to the surface of support is a functional group capable of forming a chemical bond (for example, an ionic bond, a hydrogen bond, a coordinate bond or a bond with intermolecular force) with a substance (for example, metal or metal oxide) or a functional group (for example, a hydroxy group) present on the surface of support. The adsorbing group is preferably an acid group or a cationic group.

The acid group preferably has an acid dissociation constant (pKa) of 7 or less. Examples of the acid group include a phenolic hydroxy group, a carboxyl group, $-SO_3H$, $-OSO_3H$, $-PO_3H_2$, $-OPO_3H_2$, $-CONHSO_2-$, $-SO_2NHSO_2-$ and $-COCH_2COCH_3$. Among them, a phosphoric acid group ($-OPO_3H_2$ or $-PO_3H_2$) is particularly preferred. The acid group may be the form of a metal salt.

The cationic group is preferably an onium group. Examples of the onium group include an ammonium group, a phosphonium group, an arsonium group, a stibonium group, an oxonium group, a sulfonium group, a selenonium group, a stannonium group and iodonium group. Among them, the ammonium group, phosphonium group and sulfonium group are preferred, the ammonium group and phosphonium group are more preferred, and the ammonium group is most preferred.

In order to introduce the adsorbing group into the polymer compound, a monomer having the adsorbing group is used. Preferable examples of the monomer having the adsorbing group include compounds represented by the following formula (VII) or (VIII):

(VII)

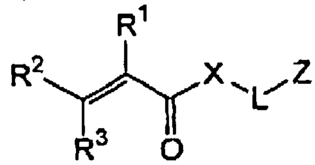

(VIII)

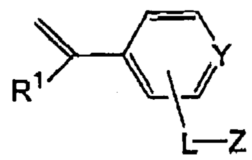

In formulae (VII) and (VIII), $R^1$, $R^2$ and $R^3$ each independently represents a hydrogen atom, a halogen atom or an alkyl group having from 1 to 6 carbon atoms. $R^1$ and $R^2$ and $R^3$ each independently represents preferably a hydrogen atom or an alkyl group having from 1 to 6 carbon atoms, more preferably a hydrogen atom or an alkyl group having from 1 to 3 carbon atoms, and most preferably a hydrogen atom or a methyl group. It is particularly preferred that $R^2$ and $R^3$ each represents a hydrogen atom.

X represents an oxygen atom (-O-) or imino group (-NH-). Preferably, X represents an oxygen atom.

L represents a divalent connecting group. It is preferred that L represents a divalent aliphatic group (for example, an alkylene group, an alkenylene group or an alkinylene group), a divalent aromatic group (for example, an arylene group), a divalent heterocyclic group or a combination of each of theses groups with an oxygen atom (-O-), a sulfur atom (-S-), an imino group (-NH-), a substituted imino group (-NR-, wherein R represents an aliphatic group, an aromatic group or a heterocyclic group) or a carbonyl group (-CO-).

The aliphatic group may have a cyclic structure or a branched structure. The number of carbon atoms of the aliphatic group is preferably from 1 to 20, more preferably from 1 to 15, most preferably from 1 to 10. It is preferred that the aliphatic group is a saturated aliphatic group rather than an unsaturated aliphatic group. The aliphatic group may have a substituent. Examples of the substituent include a halogen atom, a hydroxy group, an aromatic group and a heterocyclic group.

The number of carbon atoms of the aromatic group is preferably from 6 to 20, more preferably from 6 to 15,

most preferably from 6 to 10. The aromatic group may have a substituent. Examples of the substituent include a halogen atom, a hydroxy group, an aliphatic group, an aromatic group and a heterocyclic group.

It is preferred that the heterocyclic group has a 5-membered or 6-membered ring as the hetero ring. Other heterocyclic ring, an aliphatic ring or an aromatic ring may be condensed to the heterocyclic ring. The heterocyclic group may have a substituent. Examples of the substituent include a halogen atom, a hydroxy group, an oxo group (=O), a thioxo group (=S), an imino group (=NH), a substituted imino group (=N-R, where R represents an aliphatic group, an aromatic group or a heterocyclic group), an aliphatic group, an aromatic group and a heterocyclic group.

It is preferred that L represents a divalent connecting group containing a plurality of polyoxyalkylene structures. It is more preferred that the polyoxyalkylene structure is a polyoxyethylene structure. Specifically, it is preferred that L contains $-(OCH_2CH_2)n-$ (n is an integer of 2 or more).

Z represents a functional group adsorbing to the surface of support. The adsorbing functional group is the same as that described above.

Y represents a carbon atom or a nitrogen atom. In the case where Y is a nitrogen atom and L is connected to Y to form a quaternary pyridinium group, Z is not mandatory, because the quaternary pyridinium group itself exhibits the adsorptivity.

Representative examples of the monomer represented by formula (VII) or (VIII) are set forth below.

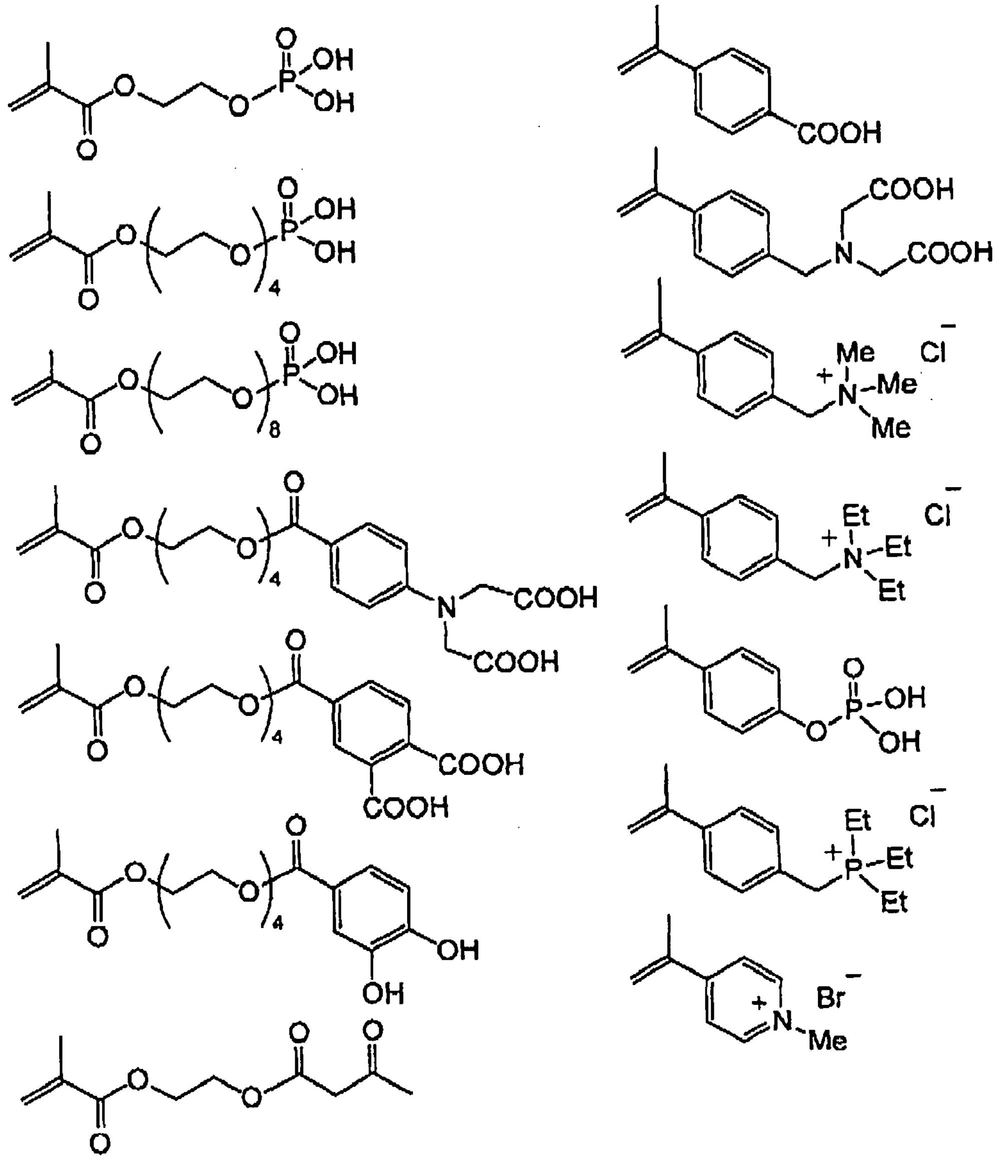

It is preferred that the polymer compound for use in the undercoat layer further has a hydrophilic group. Examples of the hydrophilic group includes a hydroxy group, a carboxyl group, a carboxylate group, a hydroxyethyl group, a polyoxyethyl group, a hydroxypropyl group, a polyoxypropyl group, an amino group, an aminoethyl group, an aminopropyl

group, an ammonium group, an amido group, a carboxymethyl group, a sulfonic acid group and a phosphoric acid group.

In the case of using the binder polymer containing a cationic group in its side chain in the image-forming layer according to the invention, as the hydrophilic group of the polymer compound for undercoat layer which interacts with the cationic group, an anionic group, for example, a carboxyl group, a carboxylate group, a sulfonic acid group or a phosphoric acid group is preferable.

It is preferred that the polymer compound for undercoat layer used in the invention further has a crosslinkable group. The crosslinkable group acts to improve the adhesion property to the image area. In order to impart the crosslinking property to the polymer compound for undercoat layer, introduction of a crosslinkable functional group, for example, an ethylenically unsaturated bond into the side chain of the polymer or introduction by formation of a salt structure between a polar substituent of the polymer compound and a compound containing a substituent having a counter charge to the polar substituent of the polymer compound and an ethylenically unsaturated bond is used.

Examples of the monomer having the ethylenically unsaturated bond in the molecule thereof include a monomer of an ester or amide of acrylic acid or methacrylic acid, wherein the ester or amide residue (R in -COOR or -CONHR) has the ethylenically unsaturated bond.

Examples of the residue (R described above) having an ethylenically unsaturated bond include $-(CH_2)_nCR_1=CR_2R_3$, $-(CH_2O)_nCH_2CR_1=CR_2R_3$, $-(CH_2CH_2O)_nCH_2CR_1=CR_2R_3$, $-(CH_2)_nNH-CO-O-CH_2CR_1=CR_2R_3$, $-(CH_2)_n-O-CO-CR_1=CR_2R_3$ and $-(CH_2CH_2O)_2-X$ (wherein $R_1$ to $R_3$ each represents a hydrogen atom, a halogen atom or an alkyl group having from 1 to 20 carbon atoms, an aryl group, alkoxy group or aryloxy group, or $R_1$ and $R_2$ or $R_1$ and $R_3$ may be combined with each other to form a ring. n represents an integer of 1 to 10. X represents a dicyclopentadienyl residue).

Specific examples of the ester residue include $-CH_2CH=CH_2$, $-CH_2CH_2O-CH_2CH=CH_2$, $-CH_2C(CH_3)=CH_2$, $-CH_2CH=CH-C_6H_5$, $-CH_2CH_2OCOCH=CH-C_6H_5$, $-CH_2CH_2-NHCOO-CH_2CH=CH_2$ and $-CH_2CH_2O-X$ (wherein X represents a dicyclopentadienyl residue).

Specific examples of the amide residue include $-CH_2CH=CH_2$, $-CH_2CH_2O-Y$ (wherein Y represents a cyclohexene residue) and $-CH_2CH_2OCO-CH=CH_2$.

The content of the crosslinkable group (content of the radical polymerizable unsaturated double bond determined by iodine titration) in the polymer compound for undercoat layer is preferably from 0.1 to 10.0 mmol, more preferably from 1.0 to 7.0 mmol, most preferably from 2.0 to 5.5 mmol, based on 1 g of the polymer compound. In the range described above, preferable compatibility between sensitivity and stain resistance and good preservation stability can be achieved.

As the polymer compound for undercoat layer, a polymer including a monomer unit having an adsorbing group and a monomer unit having a hydrophilic group is preferable and a polymer including a monomer unit having an adsorbing group, a monomer unit having a hydrophilic group and a monomer unit having a crosslinkable group is particularly preferable.

Specific examples of the polymer compound for undercoat layer are set forth below, but the invention should not be construed as being limited thereto.

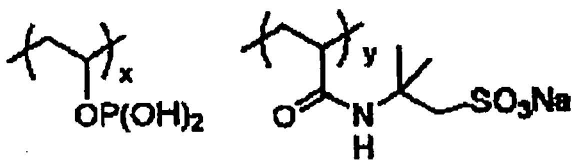

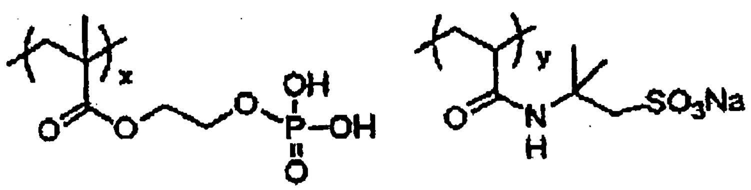

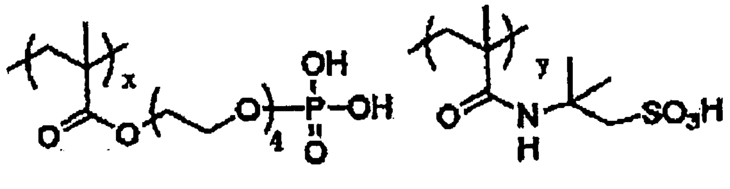

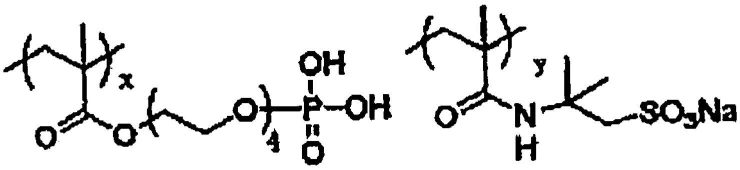

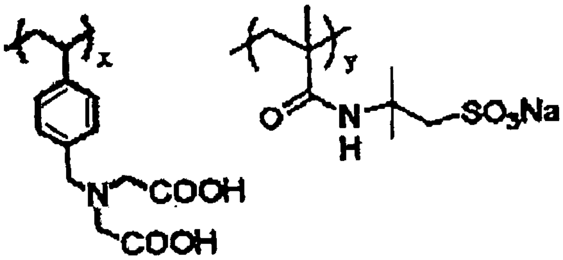

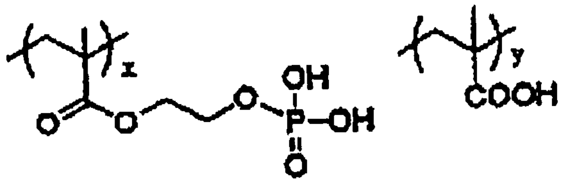

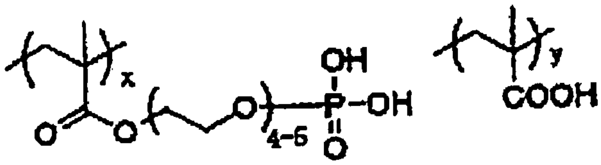

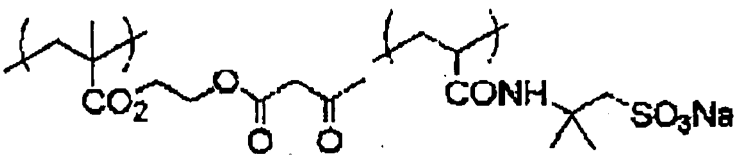

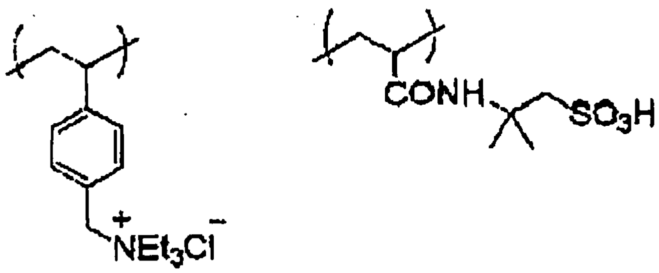

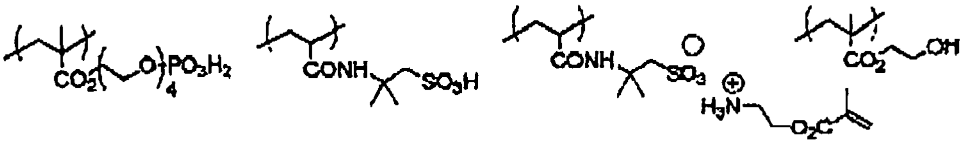

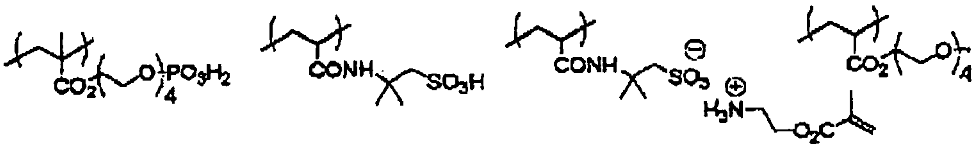

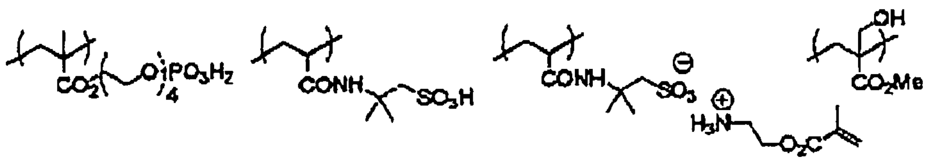

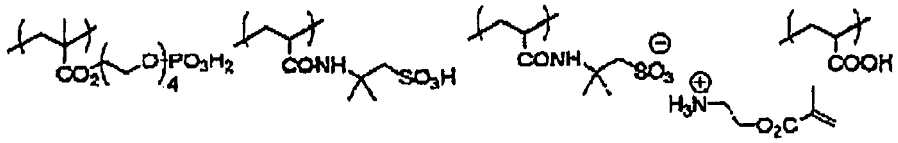

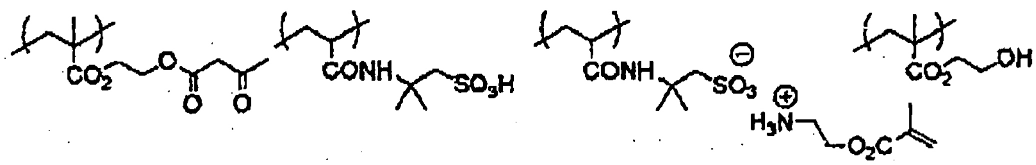

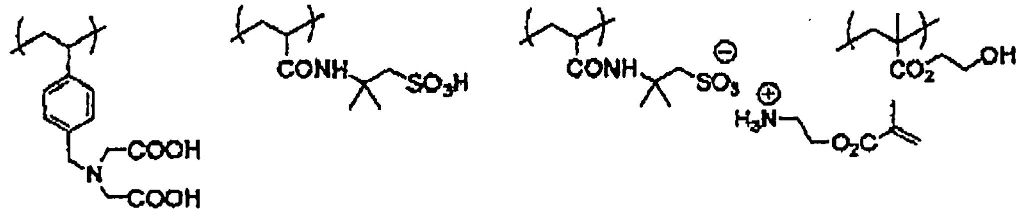

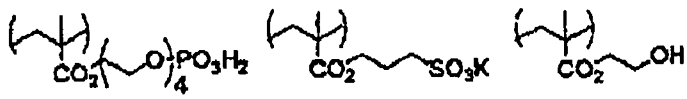

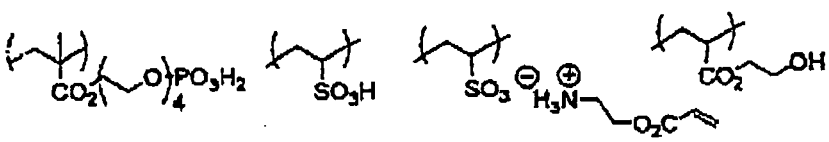

Further, a copolymer including a repeating unit having an ethylenically unsaturated bond or the like described in JP-A-2005-125749 is also preferably used.

The weight average molecular weight of the polymer compound for undercoat layer is preferably 5,000 or more, more preferably from 10,000 to 300,000. The number average molecular weight of the polymer compound is preferably 1,000 or more, more preferably from 2,000 to 250,000. The polydispersity (weight average molecular weight/number average molecular weight) thereof is preferably from 1.1 to 10.

The polymer compound for undercoat layer may be any of a random polymer, a block polymer, a graft polymer and the like, and is preferably a random polymer.

The polymer compounds for undercoat layer may be used individually or in a mixture of two or more thereof.

The coating amount (solid content) of the undercoat layer is preferably from 0.1 to 100 mg/$m^2$, more preferably from 1 to 30 mg/$m^2$.

(Backcoat layer)

After applying the surface treatment to the support or forming the undercoat layer on the support, a backcoat layer can be provided on the back surface of the support, if desired.

The backcoat layer preferably includes, for example, a coating layer comprising an organic polymer compound described in JP-A-5-45885 and a coating layer comprising a metal oxide obtained by hydrolysis and polycondensation of an organic metal compound or an inorganic metal compound described in JP-A-6-35174. Among them, use of an

alkoxy compound of silicon, for example, $Si(OCH_3)_4$, $Si(OC_2H_5)_4$, $Si(OC_3H_7)_4$ or $Si(OC_4H_9)_4$ is preferred since the starting material is inexpensive and easily available.

(Protective layer)

In the lithographic printing plate precursor used for the plate making method according to the invention, a protective layer (oxygen-blocking layer) is preferably provided on the image-forming layer in order to prevent diffusion and penetration of oxygen which inhibits the polymerization reaction at the time of exposure. The protective layer for use in the invention preferably has oxygen permeability (A) at 25°C under one atmosphere of $1.0 \leq (A) \leq 20$ (ml/$m^2$-day). When the oxygen permeability (A) is extremely lower than 1.0 (ml/$m^2$·day), problems may occur in that an undesirable polymerization reaction arises during the production or preservation before image exposure and in that undesirable fog or spread of image line occurs at the image exposure. On the contrary, when the oxygen permeability (A) greatly exceeds 20 (ml/$m^2$-day), decrease in sensitivity may be incurred. The oxygen permeability (A) is more preferably in a range of $1.5 \leq (A) \leq 12$ (ml/$m^2$·day), still more preferably in a range of $2.0 \leq (A) \leq 10.0$ (ml/$m^2$·day). Besides the above described oxygen permeability, as for the characteristics required of the protective layer, it is desired that the protective layer does not substantially hinder the transmission of light for the exposure, is excellent in the adhesion property to the image-forming layer, and can be easily removed during a development step after the exposure. Contrivances on the protective layer have been heretofore made and described in detail in U.S. Patent 3,458,311 and JP-B-55-49729.

As the material of the protective layer, a water-soluble polymer compound relatively excellent in crystallizability is preferably used. Specifically, a water-soluble polymer, for example, polyvinyl alcohol, vinyl alcohol/vinyl phthalate copolymer, vinyl acetate/vinyl alcohol/vinyl phthalate copolymer, vinyl acetate/crotonic acid copolymer, polyvinyl pyrrolidone, acidic cellulose, gelatin, gum arabic, polyacrylic acid or polyacrylamide is enumerated. The water-soluble polymer compounds may be used individually or as a mixture. Of the compounds, when polyvinyl alcohol is used as a main component, the best results can be obtained in the fundamental characteristics of the protective layer, for example, oxygen-blocking property and removability by development.

Polyvinyl alcohol for use in the protective layer may be partially substituted with an ester, ether or acetal as long as it contains unsubstituted vinyl alcohol units for achieving the necessary oxygen-blocking property and water solubility. Also, a part of polyvinyl alcohol may have other copolymer component. As specific examples of the polyvinyl alcohol, polyvinyl alcohols having a hydrolysis degree of 71 to 100% and a polymerization repeating unit of 300 to 2,400 are exemplified. Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8 (produced by Kuraray Co., Ltd.). They can be used individually or as a mixture. According to a preferred embodiment, the content of polyvinyl alcohol in the protective layer is from 20 to 95% by weight, more preferably from 30 to 90% by weight.

Also, known modified polyvinyl alcohol can be preferably used For instance, polyvinyl alcohols of various polymerization degrees having at random a various kind of hydrophilic modified cites, for example, an anion-modified cite modified with an anion, e.g., a carboxyl group or a sulfo group, a cation-modified cite modified with a cation, e.g., an amino group or an ammonium group, a silanol-modified cite or a thiol-modified cite, and polyvinyl alcohols of various polymerization degrees having at the terminal of the polymer chain a various kind of modified cites, for example, the above-described anion-modified cite, cation modified cite, silanol-modified cite or thiol-modified cite, an alkoxy-modified cite, a sulfide-modified cite, an ester modified cite of vinyl alcohol with a various kind of organic acids, an ester modified cite of the above-described anion-modified cite with an alcohol or an epoxy-modified cite are exemplified.

As a component used as a mixture with polyvinyl alcohol, polyvinyl pyrrolidone or a modified product thereof is preferable from the viewpoint of the oxygen-blocking property and removability by development. The content thereof is ordinarily from 3.5 to 80% by weight, preferably from 10 to 60% by weight, more preferably from 15 to 30% by weight, in the protective layer.

The components of the protective layer (selection of PVA and use of additives) and the coating amount are determined taking into consideration fog-preventing property, adhesion property and scratch resistance besides the oxygen-blocking property and removability by development In general, the higher the hydrolyzing rate of the PVA used (the higher the unsubstituted vinyl alcohol unit content in the protective layer) and the larger the layer thickness, the higher is the oxygen-blocking property, thus it is advantageous in the point of sensitivity. The molecular weight of the polymer compound, for example, polyvinyl alcohol (PVA) is ordinarily from 2,000 to 10,000,000, preferably from 20,000 to 3,000,000.

As other composition of the protective layer, glycerin, dipropylene glycol or the like can be added in an amount of several % by weight of the polymer compound to provide flexibility. Further, an anionic surfactant, for example, sodium alkylsulfate or sodium alkylsulfonate, an amphoteric surfactant, for example, alkylaminocarboxylate or alkylaminodicarboxylate, or a nonionic surfactant, for example, polyoxyethylene alkyl phenyl ether can be added in an amount of several % by weight of the polymer compound

The adhesion property of the protective layer to the image portion and scratch resistance are also extremely important in view of handling of the lithographic printing plate precursor. Specifically, when a hydrophilic layer comprising a water-soluble polymer is laminated on the oleophilic image-forming layer, layer peeling due to an insufficient adhesion property is liable to occur, and the peeled portion causes such a defect as failure in curing of the image-forming layer due to polymerization inhibition by oxygen. Various proposals have been made for improving the adhesion property between the image-forming layer and the protective layer. For example, it is described in U.S. Patent Application Nos. 292,501 and 44,563 that a sufficient adhesion property can be obtained by mixing from 20 to 60% by weight of an acryl-based emulsion or a water-insoluble vinyl pyrrolidone/vinyl acetate copolymer with a hydrophilic polymer mainly comprising polyvinyl alcohol and laminating the resulting mixture on an image-forming layer. Any of these known techniques can be applied to the protective layer according to the invention. Coating methods of the protective layer are described in detail, for example, in U.S. Patent 3,458,311 and JP-B-55-49729.

Further, it is also preferred to incorporate an inorganic stratiform compound into the protective layer of the lithographic printing plate precursor according to the invention for the purpose of improving the oxygen-blocking property and property for protecting the surface of image-forming layer.

The inorganic stratiform compound used here is a particle having a thin tabular shape and includes, for instance, mica, for example, natural mica represented by the following formula: A $(B, C)_{2-5}$ $D_4$ $O_{10}$ $(OH, F, O)_2$, (wherein A represents any one of K, Na and Ca, B and C each represents any one of Fe (II), Fe(III), Mn, Al, Mg and V, and D represents Si or Al) or synthetic mica, talc represented by the following formula: $3MgO\cdot4SiO\cdot H_2O$, teniolite, montmorillonite, saponite, hectoliter, and zirconium phosphate.

Of the micas, examples of the natural mica include muscovite, paragonite, phlogopite, biotite and lepidolite. Examples of the synthetic mica include non-swellable mica, for example, fluorphlogopite $KMg_3(AlSi_3O_{10})F_2$ or potassium tetrasilic mica $KMg_{2.5}(Si_4O_{10})F_2$, and swellable mica, for example, Na tetrasilic mica $NaMg_{2.5}(Si_4O_{10})F_2$, Na or Li teniolite $(Na, Li)Mg_2Li(Si_4O_{10})F_2$, or montmorillonite based Na or Li hectolite $(Na, Li)_{1/8}Mg_{2/5}Li_{1/8}(Si_4O_{10})F_2$. Synthetic smectite is also useful.

Of the inorganic stratiform compounds, fluorine based swellable mica, which is a synthetic inorganic stratiform compound, is particularly useful in the invention. Specifically, the swellable synthetic mica and an swellable clay mineral, for example, montmorillonite, saponite, hectolite or bentonite have a stratiform structure comprising a unit crystal lattice layer having thickness of approximately 10 to 15 angstroms, and metallic atom substitution in the lattices thereof is remarkably large in comparison with other clay minerals. As a result, the lattice layer results in lack of positive charge and in order to compensate it, a cation, for example, $Na^+$, $Ca^{2+}$ or $Mg^{2+}$ is adsorbed between the lattice layers. The cation existing between the lattice layers is referred to as an exchangeable cation and is exchangeable with various cations. In particular, in the case where the cation between the lattice layers is Li+ or $Na^+$, because of a small ionic radius, a bond between the stratiform crystal lattices is week, and the inorganic stratiform compound greatly swells upon contact with water. When share is applied under such conditions, the stratiform crystal lattices are easily cleaved to form a stable sol in water. The bentnite and swellable synthetic mica have strongly such tendency and are useful in the invention. Particularly, the swellable synthetic mica is preferably used.

With respect to the shape of the inorganic stratiform compound for use in the invention, the thinner the thickness or the larger the plain size as long as smoothness of coated surface and transmission of actinic radiation are not damaged, the better from the standpoint of control of diffusion. Therefore, an aspect ratio of the inorganic stratiform compound is ordinarily 20 or more, preferably 100 or more, particularly preferably 200 or more, The aspect ratio is a ratio of thickness to major axis of particle and can be determined, for example, from a projection drawing of particle by a microphotography. The larger the aspect ratio, the greater the effect obtained.

As for the particle size of the inorganic stratiform compound used in the invention, an average major axis is ordinarily from 0.3 to 20 $\mu$m, preferably from 0.5 to 10 $\mu$m, particularly preferably from 1 to 5 $\mu$m. An average thickness of the particle is ordinarily 0.1 $\mu$m or less, preferably 0.05 $\mu$m or less, particularly preferably 0.01 $\mu$m or less. For example, in the swellable synthetic mica that is the representative compound of the inorganic stratiform compounds, thickness is approximately from 1 to 50 nm and plain size is approximately from 1 to 20 $\mu$m.

When such an inorganic stratiform compound particle having a large aspect ratio is incorporated into the protective layer, strength of coated layer increases and penetration of oxygen or moisture can be effectively inhibited so that the protective layer can be prevented from deterioration due to deformation, and even when the lithographic printing plate precursor is preserved for a long period of time under a high humidity condition, it is prevented from decrease in the image-forming property thereof due to the change of humidity and exhibits excellent preservation stability.

The content of the inorganic stratiform compound in the protective layer is preferably from 5/1 to 1/100 in terms of weight ratio to the amount of binder used in the protective layer. When a plurality of inorganic stratiform compounds is used in combination, it is also preferred that the total amount of the inorganic stratiform compounds fulfills the above-described weight ratio.

An example of common dispersing method for the inorganic stratiform compound used in the protective layer is described below. Specifically, from 5 to 10 parts by weight of a swellable stratiform compound that is exemplified as

a preferable inorganic stratiform compound is added to 100 parts by weight of water to adapt the compound to water and to be swollen, followed by dispersing using a dispersing machine. The dispersing machine used include, for example, a variety of mills conducting dispersion by directly applying mechanical power, a high-speed agitation type dispersing machine providing a large shear force and a dispersion machine providing ultrasonic energy of high intensity. Specific examples thereof include a ball mill, a sand grinder mill, a visco mill, a colloid mill, a homogenizer, a dissolver, a polytron, a homomixer, a homoblender, a keddy mill, a jet agitor, a capillary type emulsifying device, a liquid siren, an electromagnetic strain type ultrasonic generator and an emulsifying device having a Polman whistle. A dispersion containing from 5 to 10% by weight of the inorganic stratiform compound thus prepared is highly viscous or gelled and exhibits extremely good preservation stability. In the formation of a coating solution for protective layer using the dispersion, it is preferred that the dispersion is diluted with water, sufficiently stirred and then mixed with a binder solution.

To the coating solution for protective layer can be added a known additive, for example, a surfactant for improving coating property or a water-soluble plasticizer for improving physical property of coated layer in addition to the inorganic stratiform compound Examples of the water-soluble plasticizer include propionamide, cyclohexanediol, glycerin or sorbitol. Also, a water-soluble (meth)acrylic polymer can be added. Further, to the coating solution may be added a known additive for increasing adhesion property to the image-forming layer or for improving preservation stability of the coating solution.

The coating solution for protective layer thus-prepared is coated on the image-forming layer and dried to form a protective layer. The coating solvent may be appropriately selected in view of the binder used, and when a water-soluble polymer is used, distilled water or purified water is preferably used as the solvent. A coating method for the protective layer is not particularly limited, and known methods, for example, methods described in U.S. Patent 3,458,311 and JP-B-55-49729 can be utilized. Specific examples of the coating method for the protective layer include a blade coating method, an air knife coating method, a gravure coating method, a roll coating method, a spray coating method, a dip coating method and a bar coating method. The drying method for the protective layer includes, for example, a method of blowing hot air on the surface coated and a method of keeping in a heating oven for a certain period of time. In order to prepare the lithographic printing plate precursor for use in the plate making method according to the invention, at the drying of the protective layer, the surface of support is preferably maintained at temperature lower than the heat fusion temperature of fine heat-fusible resin particle contained in the image-forming layer and more preferably at least 5°C lower than the heat fusion temperature of fine heat-fusible resin particle. By maintaining the drying temperature described above, the fine heat-fusible resin particles contained in the image-forming layer can be kept in their fine particle morphology.

The coating amount of the protective layer is preferably in a range of 0.05 to 10 g/m$^2$ in terms of the coating amount after drying. When the protective layer contains the inorganic stratiform compound, it is more preferably in a range of 0.1 to 0.5 g/m$^2$, and when the protective layer does not contain the inorganic stratiform compound, it is more preferably in a range of 0.5 to 5 g/m$^2$.

(Plate making method)

The plate making method of a lithographic printing plate according to the invention comprises exposing imagewise a lithographic printing plate precursor comprising a support having thereon at least an image-forming layer containing a binder polymer, a radical polymerizable compound, a polymerization initiator, a sensitizing dye and a fine heat-fusible resin particle, developing the exposed lithographic printing plate precursor to remove a non-image area and drying the developed lithographic printing plate precursor at heat fusion temperature of the fine heat-fusible resin particle or higher.

(Exposure)

The lithographic printing plate precursor is imagewise exposed through a transparent original having a line image, a halftone dot image or the like, or imagewise exposed, for example, by scanning of laser beam based on digital data. The desirable wavelength of the exposure light source is from 350 to 450 nm.

As for the available laser light source of 350 to 450 nm, the followings can be used.

A gas laser, for example, Ar ion laser (364 nm, 351 mn, 10 mW to 1 W), Kr ion laser (356 nm, 351 nm, 10 mW to 1 W) and He-Cd laser (441 nm, 325 nm, 1 mW to 100 mW); a solid laser, for example, a combination of Nd:YAG ($YVO_4$) with SHG crystals×twice (355 nm, 5 mW to 1 W) and a combination of Cr:LiSAF with SHG crystal (430 nm, 10 mW); a semiconductor laser system, for example, a $KNbO_3$ ring resonator (430 nm, 30 mW), a combination of a waveguide-type wavelength conversion element with an AlGaAs or InGaAs semiconductor (380 nm to 450 nm, 5 mW to 100 mW), a combination of a waveguide-type wavelength conversion element with an AlGaInP or AlGaAs semiconductor (300 nm to 350 nm, 5 mW to 100 mW), and AlGaInN (350 nm to 450 nm, 5 mW to 30 mW); a pulse laser, for example, $N_2$ laser (337 nm, pulse 0.1 to 10 mJ) and XeF (351 nm, pulse 10 to 250 mJ) can be used. Among the light sources, the AlGaInN semiconductor laser (commercially available InGaN semiconductor laser, 400 to 410 nm, 5 to 30

mW) is particularly preferable in view of the wavelength characteristics and cost.

As for the exposure apparatus of scanning exposure system for the lithographic printing plate precursor, the exposure mechanism includes an internal drum system, an external drum system and a flat bed system. As the light source, among the light sources described above, those capable of conducting continuous oscillation can be preferably utilized. In practice, the exposure apparatuses described below are particularly preferable in view of the relationship between the sensitivity of lithographic printing plate precursor (hereinafter, also referred to as a "photosensitive material") and the time for plate making.

- A single beam to triple beam exposure apparatus of internal drum system, using one or more gas or solid laser light sources so as to provide a semiconductor laser having a total output of 20 mW or more
- A multi-beam (from 1 to 10 beams) exposure apparatus of flat bed system, using one or more semiconductor, gas or solid lasers so as to provide a total output of 20 mW or more
- A multi-beam (from 1 to 9 beams) exposure apparatus of external drum system, using one or more semiconductor, gas or solid lasers so as to provide a total output of 20 mW or more
- A multi-beam (10 or more beams) exposure apparatus of external drum system, using one or more semiconductor or solid lasers so as to provide a total output of 20 mW or more

As for the laser direct drawing-type lithographic printing plate precursor, the following equation (eq 1) is ordinarily established among the sensitivity X (J/$cm^2$) of photosensitive material, the exposure area S ($cm^2$) of photosensitive material, the power q (W) of one laser light source, the number n of lasers and the total exposure time t (s):

$$X \cdot S = n \cdot q \cdot t \qquad \text{(eq 1)}$$

i) In the case of the internal drum (single beam) system

The following equation (eq 2) is ordinarily established among the laser revolution number f (radian/s), the sub-scanning length Lx (cm) of photosensitive material, the resolution Z (dot/cm) and the total exposure time t (s):

$$f \cdot Z \cdot t = Lx \qquad \text{(eq 2)}$$

ii) In the case of the external drum (multi-beam) system

The following equation (eq 3) is ordinarily established among the drum revolution number F (radian/s), the sub-scanning length Lx (cm) of photosensitive material, the resolution Z (dot/cm), the total exposure time t (s) and the number (n) of beams:

$$F \cdot Z \cdot n \cdot t = Lx \qquad \text{(eq 3)}$$

iii) In the case of the flat bed (multi-beam) system

The following equation (eq 4) is ordinarily established among the revolution number H (radian/s) of polygon mirror, the sub-scanning length Lx (cm) of photosensitive material, the resolution Z (dot/cm), the total exposure time t (s) and the number (n) of beams:

$$H \cdot Z \cdot n \cdot t = Lx \qquad \text{(eq 4)}$$

When the resolution (2,560 dpi) required for a practical lithographic printing plate precursor, the plate size (A1/B1, sub-scanning length: 42 inch), the exposure condition of about 20 sheets/hour and the photosensitive characteristics (photosensitive wavelength, sensitivity: about 0.1 mJ/$cm^2$) of the lithographic printing plate precursor according to the invention are substituted for the above equations, it can be understood that the lithographic printing plate precursor according to the invention is particularly preferably combined with a multi-beam exposure system using a laser having a total output of 20 mW or more, and on taking account of operability, cost and the like, it is most preferably combined with an external drum system semiconductor laser multi-beam (10 or more beams) exposure apparatus.

Other examples of the exposure light source which can be used in the invention include an ultra-high pressure mercury lamp, a high pressure mercury lamp, a medium pressure mercury lamp, a low pressure mercury lamp, a chemical lamp, a carbon arc lamp, a xenon lamp, a metal halide lamp, various visible or ultraviolet laser lamps, a fluorescent lamp, a tungsten lamp and sunlight.
In the plate making method according to the invention, the lithographic printing plate precursor may be heated simultaneously with the imagewise exposure. The heating at imagewise exposure is preferably performed under mild conditions of temperature lower than the heat fusion temperature of fine heat-fusible resin particle contained in the image-forming layer, more preferably under milder conditions of temperature of at least 5°C lower than the heat fusion temperature of fine heat-fusible resin particle, and particularly preferably under milder conditions of temperature of at least 10°C lower than the heat fusion temperature of fine heat-fusible resin particle.

(Pre-heat)

In the method of preparing a lithographic printing plate according to the invention, the entire surface of the lithographic printing plate precursor may be heated (hereinafter, referred to as pre-heat), if desired, before or during the exposure or between the exposure and the development. By the pre-heat, the image-forming reaction in the image-forming layer is accelerated and advantages, for example, improvement in the sensitivity and printing durability and stabilisation of the sensitivity are achieved.
In the method of preparing a lithographic printing plate according to the invention, the pre-heat is preferably performed under mild conditions of temperature lower than the heat fusion temperature of fine heat-fusible resin particle contained in the image-forming layer, more preferably under milder conditions of temperature of at least 5°C lower than the heat fusion temperature of fine heat-fusible resin particle, and particularly preferably under milder conditions of temperature of at least 10°C lower than the heat fusion temperature of fine heat-fusible resin particle. The pre-beat is preferably conducted at temperature of 40°C or higher under the above-described conditions. The time for heat is ordinarily from 5 to 180 seconds, and preferably from 10 to 120 seconds.
When the temperature for pre-heat is excessively high, fusion of the fine heat-fusible resin particles also occurs in the non-image area and a problem, for example, delay in the development or the occurrence of satin in the non-image area, may arise in some cases.
The heating means used in the pre-heat step of the method of preparing a lithographic printing plate according to the invention includes, for example, a conventional convection oven, an IR irradiation apparatus, an IR laser, a microwave apparatus or a Wisconsin oven.

(Development)

In accordance with the plate making method of the lithographic printing plate according to the invention, the lithographic printing plate precursor is exposed imagewise with a semiconductor laser or solid laser, heated, if desired, the entire surface of the exposed lithographic printing plate precursor as described above, and then rubbed a surface of the exposed lithographic printing plate precursor with a rubbing member in the presence of a developer having pH of 2 to 10 in an automatic processor equipped with the rubbing member to remove the unexposed area of the image-forming layer, thereby preparing a lithographic printing plate.
The developer for use in the invention is preferably, for example, water alone or an aqueous solution containing water as a main component (containing 60% by weight or more of water). Particularly, an aqueous solution having the composition similar to that of conventionally known dampening water, an aqueous solution containing a surfactant (for example, an anionic, nonionic, cationic or amphoteric surfactant) and an aqueous solution containing a water-soluble polymer compound are preferable. An aqueous solution containing both the surfactant and the water-soluble polymer compound is especially preferable. The pH of the developer is more preferably from 3 to 8, and still more preferably from 4 to 7.
The anionic surfactant for use in the invention includes, for example, fatty acid salts, abietic acid salts, hydroxyalkanesulfonic acid salts, alkanesulfonic acid salts, dialkylsulfosuccinic acid salts, straight-chain alkylbenzenesulfonic acid salts, branched alkylbenzenesulfonic acid salts, alkylnaphthalenesulfonic acid salts, alkylphenoxypolyoxy ethylene propylsulfonic acid salts, polyoxyethylene alkylsulfophenyl ether salts, N-methyl-N-oleyltaurine sodium salt, N-alkylsulfosuccinic acid monoamide disodium salts, petroleum sulfonic acid salts, sulfated castor oil, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styryl phenyl ether sulfate ester salts, alkyl phosphate ester salts, polyoxyethylene alkyl ether phosphate ester salts, polyoxyethylene alkyl phenyl ether phosphate ester salts, partially saponified products of styrene-maleic anhydride copolymer, partially saponified products of olefin-maleic anhydride copolymer and naphthalene sulfonate formalin condensates. Of the compounds, dialkylsulfosuccinic acid salts, alkyl sulfate ester salts and alkylnaphthalenesulfonic acid salts are particularly preferably used.

The cationic surfactant for use in the invention is not particularly limited and conventionally known cationic surfactants can be used. Examples of the cationic surfactant include alkylamine salts, quaternary ammonium salts, polyoxyethylene alkyl amine salts and polyethylene polyamine derivatives.

The nonionic surfactant for use in the invention includes, for example, polyethylene glycol type higher alcohol ethylene oxide addacts, alkylphenol ethylene oxide addacts, fatty acid ethylene oxide addacts, polyhydric alcohol fatty acid ester ethylene oxide addacts, higher alkylamine ethylene oxide addacts, fatty acid amide ethylene oxide addacts, ethylene oxide addacts of fat, polypropylene glycol ethylene oxide addacts, dimethylsiloxane-ethylene oxide block copolymers, dimethylsiloxane-(propylene oxide-ethylene oxide) block copolymers, fatty acid esters of polyhydric alcohol type glycerol, fatty acid esters of pentaerythritol, fatty acid esters of sorbitol and sorbitan, fatty acid esters of sucrose, alkyl ethers of polyhydric alcohols and fatty acid amides of alkanolamines.

In the invention, ethylene oxide addacts of sorbitol and/or sorbitan fatty acid esters, polypropylene glycol ethylene oxide addacts, dimethylsiloxane-ethylene oxide block copolymers, dimethylsiloxane-(propylene oxide-ethylene oxide) block copolymers and fatty acid esters of polyhydric alcohols are more preferable.

Further, from the standpoint of stable solubility in water or opacity, with respect to the nonionic surfactant used in the developer according to the invention, the HLB (hydrophile-lipophile balance) value thereof is preferably 6 or more, more preferably 8 or more.

Furthermore, an oxyethylene adduct of acetylene glycol type or acetylene alcohol type or a surfactant, for example, a fluorine-based surfactant or a silicon-based surfactant can also be used.

The amphoteric surfactant for use in the invention includes, for example, 2-alkylimidazoline derivatives, alkyl aminoacetates, alkyl iminodiacetates, alkyl aminopropionates, alkyl iminodipropionates, alkyl dimethyl ammonio acetates, alkylamidopropyl dimethyl ammonio acetates, alkyl sulfobetaines, alkyl diaminoethyl glycine salts and alkyl phosphobetaines. In the invention, alkyl aminoacetates, alkyl iminodiacetates, alkyl aminopropionates, alkyl iminodipropionates, alkyl dimethyl ammonio acetates and alkylamidopropyl dimethyl ammonio acetates are preferable, and alkyl dimethyl ammonio acetates and alkylamidopropyl dimethyl ammonio acetates are more preferable.

Of the surfactants used in the developer according to the invention, the nonionic surfactant, anionic surfactant and amphoteric surfactant are preferable, and the nonionic surfactant and amphoteric surfactant are particularly preferable.

The surfactants may be used individually or as a mixture of two or more thereof. The content of the surfactant in the developer is preferably from 0.01 to 10% by weight, more preferably from 0.01 to 5% by weight.

The water-soluble polymer compound for use in the developer according to the invention includes, for example, soybean polysaccharide, modified starch, gum arabic, dextrin, a cellulose derivative (for example, carboxymethyl cellulose, carboxyethyl cellulose or methyl cellulose) or a modified product thereof, pllulan, polyvinyl alcohol or a derivative thereof, polyvinyl pyrrolidone, polyacrylamide, an acrylamide copolymer, a vinyl methyl ether/maleic anhydride copolymer, a vinyl acetate/maleic anhydride copolymer and a styrene/maleic anhydride copolymer.

As the soybean polysaccharide, those known can be used. For example, as a commercial product, Soyafive (trade name, produced by Fuji Oil Co., Ltd.) is available and various grade products can be used. The soybean polysaccharide preferably used has viscosity in a range from 10 to 100 mPa/sec in a 10% by weight aqueous solution thereof.

As the modified starch, known modified starch can be used. The modified starch can be prepared, for example, by a method wherein starch, for example, of corn, potato, tapioca, rice or wheat is decomposed, for example, with an acid or an enzyme to an extent that the number of glucose residue per molecule is from 5 to 30 and then oxypropylene is added thereto in an alkali.

Two or more of the water-soluble polymer compounds may be used in combination. The content of the water-soluble polymer compound in the developer is preferably from 0.1 to 20% by weight, more preferably from 0.5 to 10% by weight.

The developer according to the invention may contain an organic solvent. The organic solvent that can be contained in the developer include, for example, an aliphatic hydrocarbon (e.g., hexane, heptane, Isopar E, Isopar H, Isopar G (produced by Esso Chemical Co., Ltd.), gasoline or kerosene), an aromatic hydrocarbon (e.g., toluene or xylene), a halogenated hydrocarbon (e.g., methylene dichloride, ethylene dichloride, trichlene or monochlorobenzene) and a polar solvent.

Examples of the polar solvent include an alcohol (e.g., methanol, ethanol, propanol, isopropanol, benzyl alcohol, ethylene glycol monomethyl ether, 2-ethyoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, methyl phenyl carbinol, n-amyl alcohol or methyl amyl alcohol), a ketone (e.g., acetone, methyl ethyl ketone, ethyl butyl ketone, methyl isobutyl ketone or cyclohexanone), an ester (e.g., ethyl acetate, propyl acetate, butyl acetate, amyl acetate, benzyl acetate, methyl lactate, butyl lactate, ethylene glycol monobutyl acetate, polyethylene glycol monomethyl ether acetate, diethylene glycol acetate, diethyl phthalate or

butyl levulinate) and others (e.g., triethyl phosphate, tricresyl phosphate, N-phenylethanolamine or N-phenyldiethanolamine).

When the organic solvent is insoluble in water, it may be employed by being solubilized in water using a surfactant or the like. In the case where the developer contains the organic solvent, the concentration of the organic solvent is desirably less than 40% by weight in view of safety and inflammability.

Into the developer according to the invention, an antiseptic agent, a chelating agent, a defoaming agent, an organic acid, an inorganic acid, an inorganic salt or the like can be incorporated in addition to the above components.

As the antiseptic agent, for example, phenol or a derivative thereof, formalin, an imidazole derivative, sodium dehydroacetate, a 4-isothiazolin-3-one derivative, benzisotiazolin-3-one, a benzotriazole derivative, an amidine guanidine derivative, a quaternary ammonium salt, a pyridine derivative, a quinoline derivative, a guanidine derivative, diazine, a triazole derivative, oxazole, an oxazine derivative and a nitro bromo alcohol, e.g., 2-bromo-2-nitropropane-1,3-diol, 1,1-dibromo-1-nitro-2-ethanol or 1,1-dibromo-1-nitro-2-propanol are preferably used.

As the chelating agent, for example, ethylenediaminetetraacetic acid, potassium salt thereof, sodium salt thereof; diethylenetriaminepentaacetic acid, potassium salt thereof, sodium salt thereof; triethylenetetraminehexaacetic acid, potassium salt thereof, sodium salt thereof; hydroxyethylethylenediaminetriacetic acid, potassium salt thereof, sodium salt thereof; nitrilotriacetic acid, sodium salt thereof, organic phosphonic acids, for example, 1-hydroxyethane-1,1-diphosphonic acid, potassium salt thereof, sodium salt thereof; aminotri(methylenephosphonic acid), potassium salt thereof, sodium salt thereof; and phophonoalkanetricaxboxylic acids are illustrated. A salt of an organic amine is also effectively used in place of the sodium salt or potassium salt in the chelating agents described above.

As the defoaming agent, for example, a conventional silicone-based self-emulsifying type or emulsifying type defoaming agent and a nonionic surfactant having HLB of 5 or less are used. The silicone defoaming agent is preferably used. Any of emulsifying dispersing type and solubilizing type can be used.

As the organic acid, for example, citric acid, acetic acid, oxalic acid, malonic acid, salicylic acid, caprylic acid, tartaric acid, malic acid, lactic acid, levulinic acid, p-toluenesulfonic acid, xylenesulfonic acid, phytic acid and an organic phosphonic acid are illustrated. The organic acid can also be used in the form of an alkali metal salt or an ammonium salt.

As the inorganic acid and inorganic salt, for example, phosphoric acid, methaphosphoric acid, ammonium primary phosphate, ammonium secondary phosphate, sodium primary phosphate, sodium secondary phosphate, potassium primary phosphate, potassium secondary phosphate, sodium tripolyphosphate, potassium pyrophosphate, sodium hexamethaphosphate, magnesium nitrate, sodium nitrate, potassium nitrate, ammonium nitrate, sodium sulfate, potassium sulfate, ammonium sulfate, sodium sulfite, ammonium sulfite, sodium hydrogen sulfate and nickel sulfate are illustrated.

The developer described above can be used as a developer and a development replenisher for the exposed lithographic printing plate precursor and it is preferably applied to an automatic processor described hereinafter. In the case of conducting the development processing using the automatic processor, the developer becomes fatigued in accordance with the processing amount, and hence the processing ability may be restored using a replenisher or a fresh developer. Such a replenishment system can be preferably applied to the plate making method of the lithographic printing plate precursor according to the invention.

The development processing using the aqueous solution having pH of 2 to 10 according to the invention is preferably performed by an automatic processor equipped with a supplying means for a developer and a rubbing member. As the automatic processor, there are illustrated an automatic processor in which a lithographic printing plate precursor after image exposure is subjected to a rubbing treatment while it is transporting described in JP-A-2-220061 and JP-A-60-59351, and an automatic processor in which a lithographic printing plate precursor after image exposure placed on a cylinder is subjected to a rubbing treatment while rotating the cylinder described in U.S. Patents 5,148,746 and 5,568,768 and British Patent 2,297,719. Among them, an automatic processor using a rotating brush roll as the rubbing member is particularly preferred.

The rotating brush roller which can be preferably used in the invention can be appropriately selected by taking account, for example, of scratch resistance of the image area and nerve strength of the support of the lithographic printing plate precursor. As for the rotating brush roller, a known rotating brush roller produced by implanting a brush material in a plastic or metal roller can be used. For example, a rotating brush roller described in JP-A-58-159533 and JP-A-3-100554, or a brush roller described in JP-U-B-62-167253 (the term "JP-UM-B" as used herein means an "examined Japanese utility model publication"), in which a metal or plastic groove-type member having implanted therein in rows a brush material is closely radially wound around a plastic or metal roller acting as a core, can be used.

As the brush material, a plastic fiber (for example, a polyester-based synthetic fiber, e.g., polyethylene terephthalate or polybutylene terephthalate; a polyamide-based synthetic fiber, e.g., nylon 6.6 or nylon 6.10; a polyacrylic synthetic fiber, e.g., polyacrylonitrile or polyalkyl (meth)acrylate; and a polyolefin-based synthetic fiber, e.g., polypropylene or polystyrene) can be used. For instance, a brush material having a fiber bristle diameter of 20 to 400 μm and a bristle length of 5 to 30 mm can be preferably used. The outer diameter of the rotating brush roller is preferably from 30 to 200 mm, and the peripheral velocity at the tip of the brush rubbing the plate surface is preferably from 0.1 to 5 m/sec.

It is preferred to use a plurality, that is, two or more of the rotating brush rollers.

The rotary direction of the rotating brush roller for use in the invention may be the same direction or the opposite direction with respect to the transporting direction of the lithographic printing plate precursor according to the invention, but when two or more rotating brush rollers are used in an automatic processor as shown in Fig. 2, it is preferred that at least one rotating brush roller rotates in the same direction and at least one rotating brush roller rotates in the opposite direction with respect to the transporting direction. By such an arrangement, the image-forming layer in the non-image area can be more steadily removed. Further, a technique of rocking the rotating brush roller in the rotation axis direction of the brush roller is also effective.

The developer can be used at an appropriate temperature, and is preferably used at 10 to 50°C.

In the method of preparing a lithographic printing plate according to the invention, after the development described above, drying is performed to prepare a lithographic printing plate. The drying after development can be performer in a known manner.

The drying is preferably carried out at temperature at least 10°C higher than the heat fusion temperature of the fine heat-fusible resin particle contained in the image-forming layer, and particularly preferably at temperature at least 20°C higher than the heat fusion temperature of the fine heat-fusible resin particle. The upper limit of the drying temperature is preferably 100°C higher than the heat fusion temperature of the fine heat-fusible resin particle. The time for drying is ordinarily from 5 to 180 seconds, and preferably from 10 to 120 seconds.

Due to the drying, the fine resin particles contained in the image-forming layer are fused and the image area is totally hydrophobilized to increase water resistance, thereby enabling printing a large number of sheets.

In the invention, it is optionally possible to conduct water washing and an oil-desensitization treatment between the development and drying. In the oil-desensitization treatment, a known oil-desensitizing solution can be used.

According to the invention, the development processing step is conducted after the exposure step, preferably after the exposure step and the heat treatment step to prepare a lithographic printing plate. It is preferable that a plate setter used in the exposure step, a heat treatment means used in the heat treatment step and a development apparatus used in the development processing step are connected with each other and the lithographic printing plate precursor is subjected to automatically continuous processing. Specifically, a plate making line wherein the plate setter and the development apparatus are connected with each other by transport means, for example, a conveyer is illustrated. Also, the heat treatment means may be placed between the plate setter and the development apparatus or the heat treatment means and the development apparatus may constitute a unit apparatus.

In case where the lithographic printing plate precursor used is apt to be influenced by surrounding light under a working environment, it is preferable that the plate making line is blinded by a filter, a cover or the like.

(Post-heat and/or post-exposure)

According to the invention, after the drying step, the entire surface of lithographic printing plate may be subjected to heating and/or exposure to light. This will enable to strengthen the image and to achieve higher printing durability. The heating of the entire surface of lithographic printing plate is ordinarily carried out in a temperature range of 200 to 500°C using the heating means as described above. When the temperature is too low, a sufficient effect of strengthening the image may not be obtained, whereas when it is excessively high, problems of deterioration of the support and thermal decomposition of the image area may occur sometimes. In the case of exposure of the entire surface of lithographic printing plate, as a light source for the entire surface exposure, for example, a carbon arc lamp, a mercury lamp, a gallium lamp, a metal halide lamp, a xenon lamp, a tungsten lamp or various laser beams are exemplified. In order to obtain sufficient printing durability, the amount of the entire surface exposure is preferably 10 mJ/$cm^2$ or more, more preferably 100 mJ/$cm^2$ or more. The heating and exposure may be performed individually, simultaneously or successively.

## EXAMPLES

The present invention will be described in more detail with reference to the following examples, but the invention should not be construed as being limited thereto. Examples 1 and 2 and Comparative Example 1

<Preparation of Lithographic Printing Plate Precursor (1)>

(Preparation of Aluminum support)

An aluminum plate (material: 1050, refining; H16) having a thickness of 0.24 mm was immersed in an aqueous 5% by weight sodium hydroxide solution maintained at 65°C to conduct a degreasing treatment for one minute, followed by washed with water. The degreased aluminum plate was immersed in an aqueous 10% by weight hydrochloric acid solution maintained at 25°C for one minute to neutralize, followed by washed with water. Subsequently, the aluminum

plate was subjected to an electrolytic surface-roughening treatment with alternating current under condition of current density of 100 A/dm$^2$ in an aqueous 0.3% by weight hydrochloric acid solution at 25°C for 60 seconds and then subjected to a desmut treatment in an aqueous 5% by weight sodium hydroxide solution maintained at 60°C for 10 seconds. The aluminum plate thus-treated was subjected to an anodizing treatment under condition of current density of 10 A/dm$^2$ and voltage of 15 V in an aqueous 15% by weight sulfuric acid solution at 25°C for one minute to prepare a support.

(Formation of under layer)

Coating solution for under layer having the composition shown below was coated on the aluminum support obtained above so as to have a dry coating amount of 10 mg/m$^2$ and dried at 100°C for 1 minute to form an under layer.

<Coating solution for under layer>

| | |
|---|---|
| Polyvinylphosphonic acid | 1 g |
| Methanol | 600 g |
| Distilled water | 400 g |

(Formation of image-forming layer)

Coating solution 1 for image-forming layer having the composition shown below was coated on the aluminum support provided with the under layer described above so as to have a dry coating amount of 1.3 g/m$^2$ and dried at 75°C for one minute to form an image-forming layer.

<Coating solution 1 for image-forming layer>

| | |
|---|---|
| Radical polymerizable compound | 0.40 g |
| Isocyanuric acid EO-modined triacrylate (Aronics M-315, produced by Toa Gosei Co., Ltd.) | |
| Radical polymerizable compound | 0.13 g |
| Ethoxylated trimethylolpropane triacrylate (SR9035, produced by Nippon Kayaku Co., Ltd.; EO addition molar number. 15) | |
| Binder Polymer (1) shown below | 0.54 g |
| Polymerization Initiator (1) shown below | 0.18 g |
| Sensitizing Dye (1) shown below | 0.06 g |
| Chain Transfer Agent (1) shown below | 0.07 g |
| Methylene blue | 0.02 g |
| Solution 1 of Fine Heat-Fusible Resin Particle shown below | 5.00 g |
| Thermal polymerization inhibitor | 0.01 g |
| N-nitrosophenylhydroxylamine aluminum salt | |
| 1-Methoxy-2-propanol | 2.5 g |
| Acetone | 7.0 g |
| Distilled water | 10.0 g |

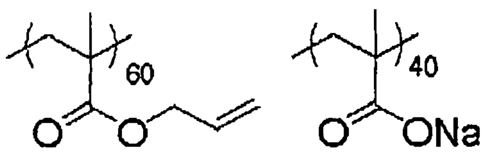

Binder Polymer (1) (weight average molecular weight: 100,000)

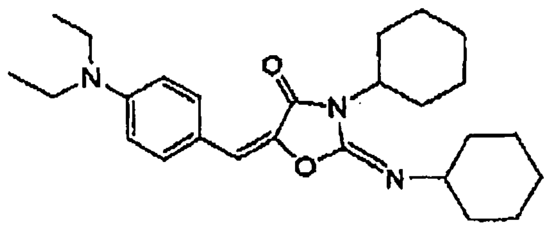

Sensitizing Dye (1)

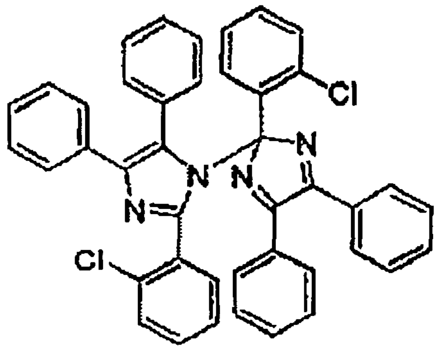

Polymerization Initiator (1)

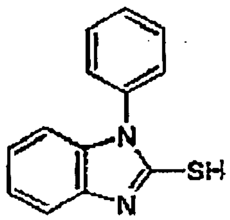

Chain Transfer Agent (1)

<Solution of Fine Heat-Fusible Resin Particle 1>

In 21.0 g of ethyl acetate were dissolved 6.0 g of phenol cresol resin (PR-54020, produced by Sumitomo Duretz Co., Ltd, weight average molecular weight 2,000) and 0.1 g of Pionine A-41C (produced by Takemoto Oil and Fat Co., Ltd.) to prepare an oil phase. To the oil phase was added 36.0 g of an aqueous phase composed of a 4% aqueous solution of polyvinyl alcohol (PVA-205, produced by Kuraray Co., Ltd.) and the mixture was emulsified using a homogenizer at 10,000 rpm for 10 minutes. After adding 24.0 g of water to the emulsion, the mixture was heated at 50°C for 3 hours while distilling off the organic solvent. The solid content concentration measured was 15.0% by weight The average particle size was 300 nm. The heat fusion temperature of the resulting Fine Heat-Fusible Resin Particle 1 was 80°C.

(Formation of protective layer)

Coating solution 1 for protective layer having the composition shown below was coated on the image-forming layer described above so as to have a dry coating amount of 0.3 g/m$^2$ and dried at 75°C for one minute to form a protective layer.

<Coating solution 1 for protective layer>

| | |
|---|---|
| Dispersion of Mica (1) shown below | 13.00 g |
| Polyvinyl alcohol (saponification degree: 98% by mole; polymerization degree: 500) | 1.30 g |
| Sodium 2-ethylhexylsulfosuccinate | 0.20 g |
| Vinyl pyrrolidone/vinyl acetate (1/1) copolymer (molecular weight: 70,000) | 0.05 g |
| Surfactant (Emalex 710, produced by Nihon-Emulsion Co., Ltd.) | 0.05 g |
| Waster | 133.00 g |

<Preparation of Dispersion of Mica (1)>

In 368 g of water was added 32 g of synthetic mica (SOMASIF ME-100, produced by CO-OP Chemical Co., Ltd.; aspect ratio: 1,000 or more) and the mixture was dispersed using a homogenizer until the average particle diameter (measured by a laser scattering method) became 0.5 μm to obtain Dispersion of Mica (1).

(1) Exposure, Development and Printing

Lithographic Printing Plate Precursor (1) was subjected to imagewise exposure using a semiconductor laser of 405 nm having an output of 100 mW with varying energy density.

Then, development processing was performed using an automatic development processor having a structure shown in Fig. 2 in which Developer (1) having the composition shown below was supplied to a developing bath and pre-heating and pre-water washing were not carried out. The pH of developer was 8. After the development, without carrying out water washing and finishing the lithographic printing plate precursor was dried at temperature described in Table 1 to prepare a lithographic printing plate. The time for drying was 30 seconds.

Developer (1)

| | |
|---|---|
| Water | 100.00 g |
| Benzyl alcohol | 1.00 g |
| Polyoxyethylene naphthyl ether (average number of oxyethylene: n =13) | 1.00 g |
| Sodium salt of dioctylsulfosuccinic acid ester | 0.50 g |
| Gum arabic | 1.00 g |
| Ethylene glycol | 0.50 g |
| Ammonium primary phosphate | 0.05 g |
| Citric acid | 0.05 g |
| Tetrasodium ethylenediaminetetraacetate | 0.05 g |

(2) Evaluation

Using the lithographic printing plate precursor prepared above, developing property, sensitivity, printing durability and stain resistance were evaluated in the following manner. The results obtained are shown in Table 1.

<Developing property>

Transporting speed necessary for completely removing the non-image area of the lithographic printing plate precursor under the development conditions described above was determined to relatively evaluate the developing property. Specifically, the developing property was calculated according to the formula shown below using Comparative Example 1 as the criterion (100). As the value increases, the developing property becomes higher.

Developing property = (Transporting speed of subject lithographic printing plate precursor)/(Transporting speed of criterion lithographic printing plate precursor) x 100

<Sensitivity>

After performing printing of 100 sheets as described above and confirming that a printed material free from ink

stain in the non-image area was obtained, 500 sheets were continuously printed. The exposure amount for causing no unevenness in the ink density of the image area on the 600th printed material was determined to relatively evaluate the sensitivity. Specifically, the sensitivity was calculated according to the formula shown below using Comparative Example I as the criterion (100). As the value increases, the sensitivity becomes higher.

Sensitivity = (Exposure amount of criterion lithographic printing plate precursor)/(Exposure amount of subject lithographic printing plate precursor)

<Printing durability>

As increase in the number of printing sheets according to the printing as described above, the image-forming layer was gradually abraded to cause decrease in the ink receptivity, resulting in decrease of ink density on a printed material. A number of printed materials obtained until the ink density (reflection density) decreased by 0.1 from that at the initiation of printing was determined to relatively evaluate the printing durability. Specifically, the printing durability was calculated according to the formula shown below using Comparative Example 1 as the criterion (100). As the value increases, the printing durability becomes higher.

Printing durability = (Number of printed materials of subject lithographic printing plate)/(Number of printed materials of criterion lithographic printing plate) × 100

<Stain resistance>

The 500th sheet of the printed material from the initiation of printing was picked up and the density of ink adhered on the non-image area was measured to relatively evaluate the stain resistance. Specifically, the stain resistance was calculated according to the formula shown below using Comparative Example 1 as the criterion (100). As the value increases, the density of ink adhered on the non-image area decreases, that is, the stain resistance becomes better.

Stain resistance = (Ink density of non-image area on printed material of criterion lithographic printing plate)/(Ink density of non-image area on printed material of subject lithographic printing plate) × 100

TABLE 1

| | Drying Temperature | Developing Property | Sensitivity | Printing Durability | Stain Resistance | Evaluation Criterion |
|---|---|---|---|---|---|---|
| Example 1 | 90°C | 100 | 120 | 150 | 100 | |
| Example 2 | 100°C | 100 | 140 | 200 | 100 | |
| Comparative Example 1 | 70°C | 100 | 100 | 100 | 100 | Evaluation Criterion |

As is apparent from the results shown in Table 1, the lithographic printing plate excellent in the sensitivity and printing durability can be obtained by using the plate making method of a lithographic printing plate according to the invention.

Examples 3 and 4 and Comparative Example 2

Lithographic Printing Plate Precursor (1) was subjected to the imagewise exposure with laser as described above and then heated the entire surface thereof in the pre-heating unit of the automatic development processor shown in Fig. 2 at temperature shown in Table 2. The time (heating time) for passing the lithographic printing plate precursor through the pre-heating unit was one minute. Thereafter, the development processing was performed as described above and the drying treatment was performed at 100°C to prepare a lithographic printing plate.

The lithographic printing plate thus-obtained was mounted on a printing machine (SOR-M, produced by Heidelberg) and printing was performed at a printing speed of 6,000 sheets per hour using dampening water (EU-3 (etching solution, produced by Fuji Film Co., Ltd.))/water/isopropyl alcohol = 1/89/10 (by volume ratio)) and TRANS-G (N) black ink (produced by Dainippon Ink & Chemicals, Inc.). The evaluations were conducted in the same manner as in Example 1. The results obtained are shown in Table 2. As the criterion (100) for the relative evaluation, the lithographic printing plate prepared under conditions of Comparative Example 1 was used.

TABLE 2

| | Pre-Heating Temperature | Drying Temperature | Developing Property | Sensitivity | Printing Durability | Stain Resistance | Evaluation Criterion |
|---|---|---|---|---|---|---|---|
| Example 3 | 75°C | 100°C | 100 | 150 | 220 | 100 | |
| Example 4 | 80°C | 100°C | 100 | 160 | 240 | 100 | |
| Comparative Example 1 | None | 70°C | 100 | 100 | 100 | 100 | Evaluation Criterion |
| Comparative Example 2 | 90°C | 100°C | 50 | 400 | 300 | 10 | |

As is apparent from the results shown in Table 2, the lithographic printing plate more excellent in the sensitivity and printing durability can be obtained by using the plate making method of a lithographic printing plate according to the invention and conducting the pre-heating at temperature lower than the heat fusion temperature of the fine heat-fusible resin particle.

Examples 5 to 8 and Comparative Examples 3 to 6

<Preparation of Lithographic Printing Plate Precursors (2) to (5)>

Lithographic Printing Plate Precursors (2) to (5) were prepared in the same manner as in Lithographic Printing Plate Precursor (1) except for changing Binder Polymer (1) in Coating solution 1 for image-forming layer to Binder Polymers (2) to (5) shown below, respectively.

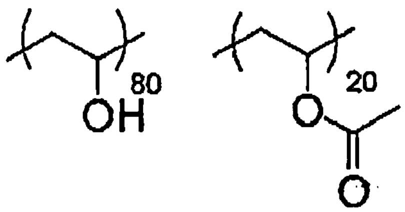

Binder Polymer (2) (weight average molecular weight: 100,000)

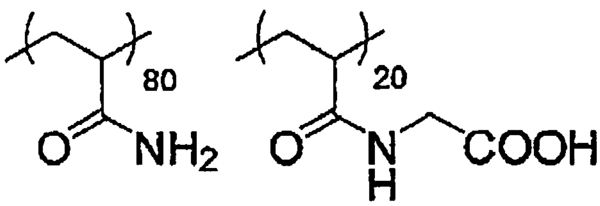

Binder Polymer (3) (weight average molecular weight: 80,000)

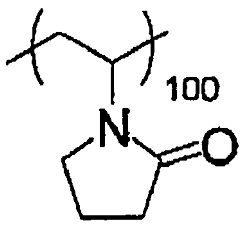

Binder Polymer (4) (weight average molecular weight: 150,000)

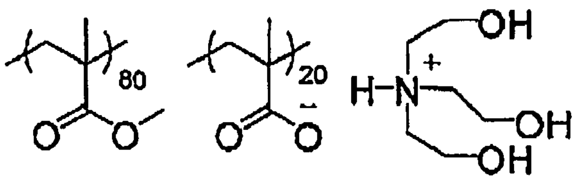

Binder Polymer (5) (weight average molecular weight: 50,000)

Lithographic Printing Plate Precursors (2) to (5) were evaluated in the same manner as in Example 1. As the criterion (100) for the relative evaluation, the lithographic printing plates of Comparative Examples 3, 4, 5 and 6 were used, respectively. The results obtained are shown in Table 3.

TABLE 3

| | Lithographic Printing Plate Precursor | Binder Polymer | Drying Temperature | Developing Property | Sensitivity | Printing Durability | Stain Resistance | Evaluation Criterion |
|---|---|---|---|---|---|---|---|---|
| Example 5 | 2 | 2 | 100°C | 100 | 140 | 200 | 100 | |
| Comparative Example 3 | 2 | 2 | 70°C | 100 | 100 | 100 | 100 | Evaluation Criterion |
| Example 6 | 3 | 3 | 100°C | 100 | 140 | 200 | 100 | |
| Comparative Example 4 | 3 | 3 | 70°C | 100 | 100 | 100 | 100 | Evaluation Criterion |
| Example 7 | 4 | 4 | 100°C | 100 | 140 | 200 | 100 | |
| Comparative Example 5 | 4 | 4 | 70°C | 100 | 100 | 100 | 100 | Evaluation Criterion |
| Example 8 | 5 | 5 | 100°C | 100 | 140 | 200 | 100 | |
| Comparative Example 6 | 5 | 5 | 70°C | 100 | 100 | 100 | 100 | Evaluation Criterion |

As is apparent from the results shown in Table 3, the similar excellent results can be obtained by using the plate making method of a lithographic printing plate according to the invention even when the kind of binder polymer is changed.

Examples 9 to 12

<Preparation of Lithographic Printing Plate Precursors (6) to (8)>

Lithographic Printing Plate Precursor (6) to (8) were prepared in the same manner as in Lithographic Printing Plate Precursor (1) except for changing Binder Polymer (1) in Coating solution 1 for image-forming layer to Binder Polymers (6) to (8) shown below, respectively.

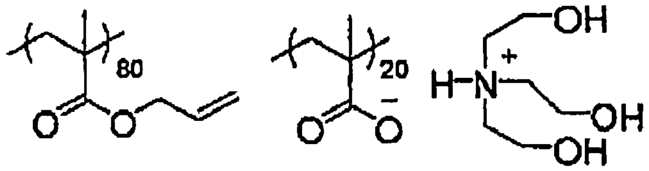

Binder Polymer (6) (weight average molecular weight: 50,000)

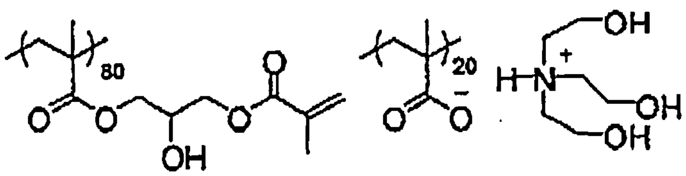

Binder Polymer (7) (weight average molecular weight: 50,000)

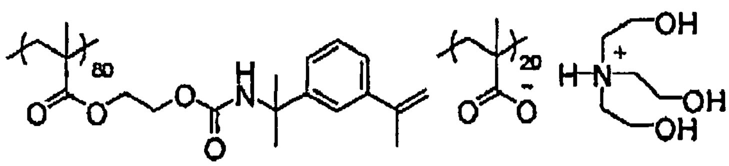

Binder Polymer (8) (weight average molecular weight: 50,000)

Lithographic Printing Plate Precursors (6) to (8) and Lithographic Printing Plate Precursor (5) were evaluated in the same manner as in Example 1. As the criterion (100) for the relative evaluation, Lithographic Printing Plate Precursor (5) was used. The results obtained are shown in Table 4.

TABLE 4

| | Lithographic Printing Plate Precursor | Binder Polymer | Drying Temperature | Developing Property | Sensitivity | Printing Durability | Stain Resistance | Evaluation Criterion |
|---|---|---|---|---|---|---|---|---|
| Example 9 | 5 | 5 | 100°C | 100 | 100 | 100 | 100 | Evaluation Criterion |
| Example 10 | 6 | 6 | 100°C | 100 | 110 | 120 | 100 | |
| Example 11 | 7 | 7 | 100°C | 100 | 140 | 180 | 100 | |
| Example 12 | 8 | 8 | 100°C | 100 | 120 | 150 | 100 | |

As is apparent from the results shown in Table 4, the plate making method of a lithographic printing plate according to the invention can provide the remarkably good results when it is applied to the lithographic printing plate precursor using the binder polymer having a polymerizable group.

Examples 13 to 15

<Preparation of Lithographic Printing Plate Precursors (9) and (10)>

Lithographic Printing Plate Precursors (9) and (10) were prepared in the same manner as in Lithographic Printing Plate Precursor (1) except for changing Solution 1 of Fine Heat-Fusible Resin Particle in Coating solution 1 for image-forming layer to Solutions of Fine Heat-Fusible Resin Particles 2 and 3 each having a reactive group with the binder polymer shown below, respectively.

<Solution of Fine Heat-Fusible Resin Particle 2>

In a mixture of 5.0 g of acetonitrile and 16.0 g of ethyl acetate were dissolved 6.0 g of epoxy resin (Epicoat 1002, produced by Yuka Shell Epoxy Co., Ltd.) and 0.1 g of Pionine A-41C (produced by Takemoto Oil and Fat Co., Ltd.) to prepare an oil phase. Using the oil phase, Solution of Fine Heat-Fusible Resin Particle 2 having the solid content concentration of 15.0% by weight and average particle size of 350 nm was prepared in the same manner as in the preparation of Solution of Fine Heat-Fusible Resin Particle 1. The heat fusion temperature of the resulting Fine Heat-Fusible Resin Particle 2 was 90°C.

<Solution of Fine Heat-Fusible Resin Particle 3>

To a 2,000 ml three-neck flask were added 2.57 g of sodium dodecylsulfate and 1,300 ml of distilled water and the mixture was stirred under a stream of nitrogen at 75°C for 10 minutes. To the solution was added a solution prepared by mixing 0.462 g of potassium persulfate, 11.3 ml of distilled water and 3.5 ml of a 1M aqueous sodium hydrogen carbonate solution and then was dropwise added a mixed solution of 78.61 g of N-isobutyloxymethylacrylamide and 50.06 g of methyl methacrylate over a period of 3 hours. After the completion of the dropwise addition, a solution prepared by mixing 0.462 g of ammonium persulfate, 142 ml of distilled water and 3.5 ml of a 1M aqueous sodium hydrogen carbonate solution was added and the mixture was continued to stir for 3 hours. The reaction mixture obtained was cooled to room temperature, filtered with a glass filter to obtain an aqueous solution of Fine Heat-Fusible Resin Particle 3. The solid content concentration of the resulting aqueous solution was 15% by weight The average particle size of the fine resin particles was 100 nm. The heat fusion temperature of the resulting Fine Heat-Fusible Resin Particle 3 was 100°C.

Lithographic Printing Plate Precursors (9) and (10) and Lithographic Printing Plate Precursor (1) were evaluated in the same manner as in Example 1. As the criterion (100) for the relative evaluation, Lithographic Printing Plate Precursor (1) was used. The results obtained are shown in Table 5.

TABLE 5

| | Lithographic Printing Plate Precursor | Fine Heat-Fusible Resin Particle | Drying Temperature | Developing Property | Sensitivity | Printing Durability | Stain Resistance | Evaluation Criterion |
|---|---|---|---|---|---|---|---|---|
| Example 13 | 1 | 1 | 100°C | 100 | 100 | 100 | 100 | Evaluation Criterion |
| Example 14 | 9 | 2 | 110°C | 100 | 140 | 180 | 100 | |
| Example 15 | 10 | 3 | 120°C | 100 | 140 | 160 | 100 | |

As is apparent from the results shown in Table 5, the plate making method of a lithographic printing plate according to the invention can provide the remarkably good results when it is applied to the lithographic printing plate precursor using the fine beat-fusible resin particle having a reactive group with the binder polymer.

## Claims

1. A plate making method of a lithographic printing plate comprising:

   exposing imagewise a lithographic printing plate precursor comprising a support and an image-forming layer comprising a binder polymer, a radical polymerizable compound, a polymerization initiator, a sensitizing dye and a heat-fusible resin particle; and
   developing the exposed lithographic printing plate precursor to remove a non-image area;
   **characterized by** drying the developed lithographic printing plate precursor at heat fusion temperature of the heat-fusible resin particle or higher.

2. The plate making method of a lithographic printing plate as claimed in Claim 1, which further comprises, between the imagewise exposure and the development, heating the exposed lithographic printing plate precursor at temperature lower than the heat fusion temperature of the heat-fusible resin particle.

3. The plate making method of a lithographic printing plate as claimed in Claim 2, which comprises, between the imagewise exposure and the development, heating the exposed lithographic printing plate precursor at temperature at least 5°C lower than the heat fusion temperature of the heat-fusible resin particle.

4. The plate making method of a lithographic printing plate as claimed in any one of Claims 1 to 3, which comprises, after the development of the exposed lithographic printing plate precursor to remove a non-image area, drying the developed lithographic printing plate precursor at temperature at least 10°C higher than the heat fusion temperature of the heat-fusible resin particle.

5. The plate making method of a lithographic printing plate as claimed in any one of Claims 1 to 4, wherein the development is conducted in an aqueous solution having pH of from 2 to 10.

6. The plate making method of a lithographic printing plate as claimed in any one of Claims 1 to 5, wherein the heat-fusible resin particle has an average particle size of from 10 to 2,000 nm.

7. The plate making method of a lithographic printing plate as claimed in any one of Claims 1 to 6, wherein the heat-fusible resin particle has the heat fusion temperature of 70°C or higher.

8. The plate making method of a lithographic printing plate as claimed in any one of Claims 1 to 7, wherein the heat-fusible resin particle has a functional group reacting with the binder polymer.

9. The plate making method of a lithographic printing plate as claimed in any one of Claims 1 to 8, wherein the binder polymer has a hydrophilic group.

10. The plate making method of a lithographic printing plate as claimed in Claim 9, wherein the hydrophilic group is at least one member selected from an amido group, a hydroxy group, a salt formed by neutralization of an acid group with an amino group, a tertiary amino group, a salt formed by neutralization of an amino group with an acid and a quaternary ammonium group.

11. The plate making method of a lithographic printing plate as claimed in any one of Claims I to 10, wherein the sensitizing dye absorbs light of from 350 to 450 nm.

## Patentansprüche

1. Plattenherstellungsverfahren für eine Lithographiedruckplatte, umfassend:

   bildweises Belichten eines Lithographiedruckplattenvorläufers, der einen Träger und eine bildgebende Schicht

umfasst, die ein Bindepolymer, eine radikalisch polymerisierbare Verbindung, einen Polymerisationsinitiator, einen Sensibilisierungsfarbstoff und einen durch Wärme verschmelzbaren Harzpartikel umfasst; und
Entwickeln des belichteten Lithographiedruckplattenvorläufers, um einen Nicht-Bildbereich zu entfernen;
**gekennzeichnet durch** Trocknen des entwickelten Lithographiedruckplattenvorläufers bei der Wärmeverschmelzungstemperatur des **durch** Wärme verschmelzbaren Harzpartikels oder höher.

**2.** Plattenherstellungsverfahren für eine Lithographiedruckplatte gemäß Anspruch 1, welches ferner zwischen der bildweisen Belichtung und der Entwicklung das Erwärmen des belichteten Lithographiedruckplattenvorläufers bei einer Temperatur, die niedriger ist als die Wärmeverschmelzungstemperatur des durch Wärme verschmelzbaren Harzpartikels, umfasst.

**3.** Plattenherstellungsverfahren für eine Lithographiedruckplatte gemäß Anspruch 2, welches zwischen der bildweisen Belichtung und der Entwicklung das Erwärmen des belichteten Lithographiedruckplattenvorläufers bei einer Temperatur umfasst, die mindestens 5°C niedriger ist als die Wärmeverschmelzungstemperatur des durch Wärme verschmelzbaren Harzpartikels.

**4.** Plattenherstellungsverfahren für eine Lithographiedruckplatte gemäß irgendeinem der Ansprüche 1 bis 3, welches nach der Entwicklung des belichteten Lithographiedruckplattenvorläufers zur Entfernung eines Nicht-Bildbereiches das Trocknen des entwickelten Lithographiedruckplattenvorläufers bei einer Temperatur umfasst, die mindestens 10°C höher ist als die Wärmeverschmelzungstemperatur des durch Wärme verschmelzbaren Harzpartikels.

**5.** Plattenherstellungsverfahren für eine Lithographiedruckplatte gemäß irgendeinem der Ansprüche 1 bis 4, worin die Entwicklung in einer wässrigen Lösung mit einem pH-Wert von 2 bis 10 durchgeführt wird.

**6.** Plattenherstellungsverfahren für eine Lithographiedruckplatte gemäß irgendeinem der Ansprüche 1 bis 5, worin der durch Wärme verschmelzbare Harzpartikel eine mittlere Partikelgröße von 10 bis 2.000 nm aufweist.

**7.** Plattenherstellungsverfahren für eine Lithographiedruckplatte gemäß irgendeinem der Ansprüche 1 bis 6, worin der durch Wärme verschmelzbare Harzpartikel eine Wärmeverschmelzungstemperatur von 70°C oder höher aufweist.

**8.** Plattenherstellungsverfahren für eine Lithographiedruckplatte gemäß irgendeinem der Ansprüche 1 bis 7, worin der durch Wärme verschmelzbare Harzpartikel eine funktionelle Gruppe aufweist, die mit dem Bindepolymer reagiert.

**9.** Plattenherstellungsverfahren für eine Lithographiedruckplatte gemäß irgendeinem der Ansprüche 1 bis 8, worin das Bindepolymer eine hydrophile Gruppe aufweist.

**10.** Plattenherstellungsverfahren für eine Lithographiedruckplatte gemäß Anspruch 9, worin die hydrophile Gruppe mindestens ein Element ist, ausgewählt aus einer Amidgruppe, einer Hydoxygruppe, einem Salz, gebildet durch Neutralisation einer Säuregruppe mit einer Aminogruppe, einer tertiären Aminogruppe, einem Salz, gebildet durch Neutralisation einer Aminogruppe mit einer Säure, und einer quaternären Ammoniumgruppe.

**11.** Plattenherstellungsverfahren für eine Lithographiedruckplatte gemäß irgendeinem der Ansprüche 1 bis 10, worin der Sensibilisierungsfarbstoff Licht von 350 bis 450 nm absorbiert.

## Revendications

**1.** Procédé de fabrication de plaque d’une plaque d’impression lithographique comprenant le fait :

d’exposer sous forme d’image un précurseur de plaque d’impression lithographique comprenant un support et une couche de formation d’image comprenant un polymère liant, un composé polymérisable par voie radicalaire, un initiateur de polymérisation, un colorant sensibilisateur et une particule de résine thermofusible ; et
de développer le précurseur de plaque d’impression lithographique exposé pour enlever une surface non imagée ;
**caractérisé par** le fait de sécher le précurseur de plaque d’impression lithographique développé à une température supérieure ou égale à la température de fusion thermique de la particule de résine thermofusible.

**2.** Procédé de fabrication de plaque d’une plaque d’impression lithographique tel que revendiqué dans la revendication

1, qui comprend en outre, entre l'exposition sous forme d'image et le développement, le fait de chauffer le précurseur de plaque d'impression lithographique exposé à une température inférieure à la température de fusion thermique de la particule de résine thermofusible.

3. Procédé de fabrication de plaque d'une plaque d'impression lithographique tel que revendiqué dans la revendication 2, qui comprend, entre l'exposition sous forme d'image et le développement, le fait de chauffer le précurseur de plaque d'impression lithographique exposé à une température inférieure d'au moins 5°C à la température de fusion thermique de la particule de résine thermofusible.

4. Procédé de fabrication de plaque d'une plaque d'impression lithographique tel que revendiqué dans l'une quelconque des revendications 1 à 3, qui comprend, après le développement du précurseur de plaque d'impression lithographique exposé pour enlever une surface non imagée, le fait de sécher le précurseur de plaque d'impression lithographique développé à une température supérieure d'au moins 10°C à la température de fusion thermique de la particule de résine thermofusible.

5. Procédé de fabrication de plaque d'une plaque d'impression lithographique tel que revendiqué dans l'une quelconque des revendications 1 à 4, dans lequel le développement est mené dans une solution aqueuse ayant un pH allant de 2 à 10.

6. Procédé de fabrication de plaque d'une plaque d'impression lithographique tel que revendiqué dans l'une quelconque des revendications 1 à 5, dans lequel la particule de résine thermofusible a une taille moyenne de particules allant de 10 à 2000 nm.

7. Procédé de fabrication de plaque d'une plaque d'impression lithographique tel que revendiqué dans l'une quelconque des revendications 1 à 6, dans lequel la température de fusion thermique de la particule de résine thermofusible est supérieure ou égale à 70°C.

8. Procédé de fabrication de plaque d'une plaque d'impression lithographique tel que revendiqué dans l'une quelconque des revendications 1 à 7, dans lequel la particule de résine thermofusible a un groupe fonctionnel réagissant avec le polymère liant.

9. Procédé de fabrication de plaque d'une plaque d'impression lithographique tel que revendiqué dans l'une quelconque des revendications 1 à 8, dans lequel le polymère liant a un groupe hydrophile.

10. Procédé de fabrication de plaque d'une plaque d'impression lithographique tel que revendiqué dans la revendication 9, dans lequel le groupe hydrophile est au moins un élément choisi parmi un groupe amido, un groupe hydroxy, un sel formé par neutralisation d'un groupe acide avec un groupe amino, un groupe amino tertiaire, un sel formé par neutralisation d'un groupe amino avec un acide et un groupe ammonium quaternaire.

11. Procédé de fabrication de plaque d'une plaque d'impression lithographique tel que revendiqué dans l'une quelconque des revendications 1 à 10, dans lequel le colorant sensibilisateur absorbe la lumière allant de 350 à 450 nm.

*FIG. 1*

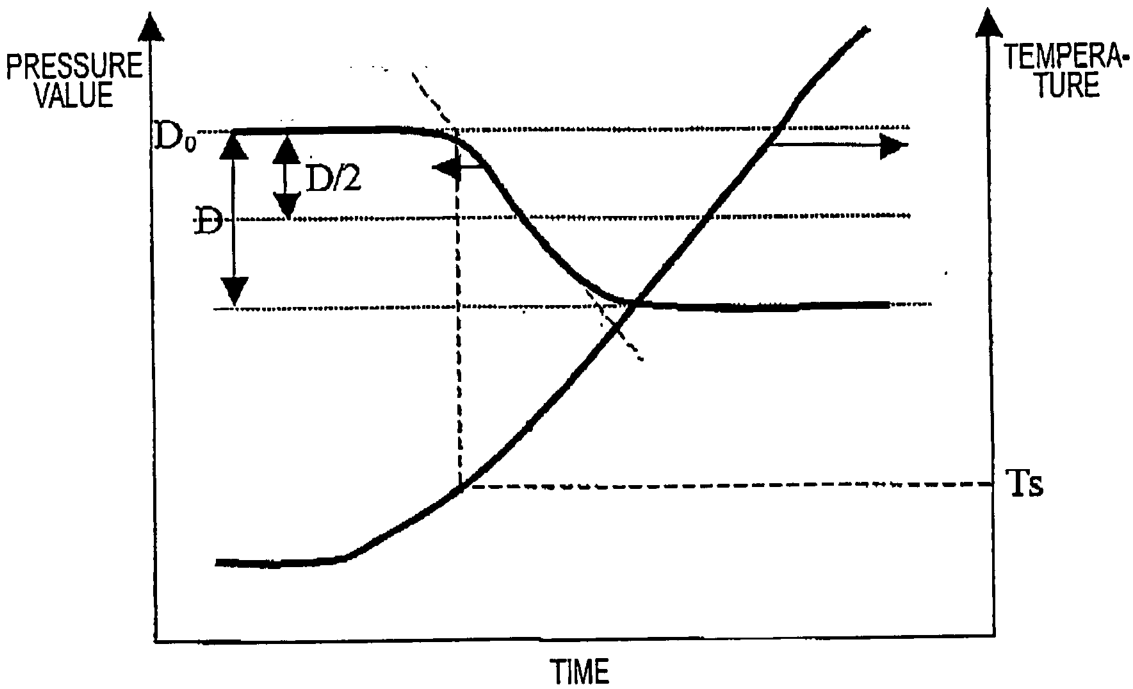

FIG. 2

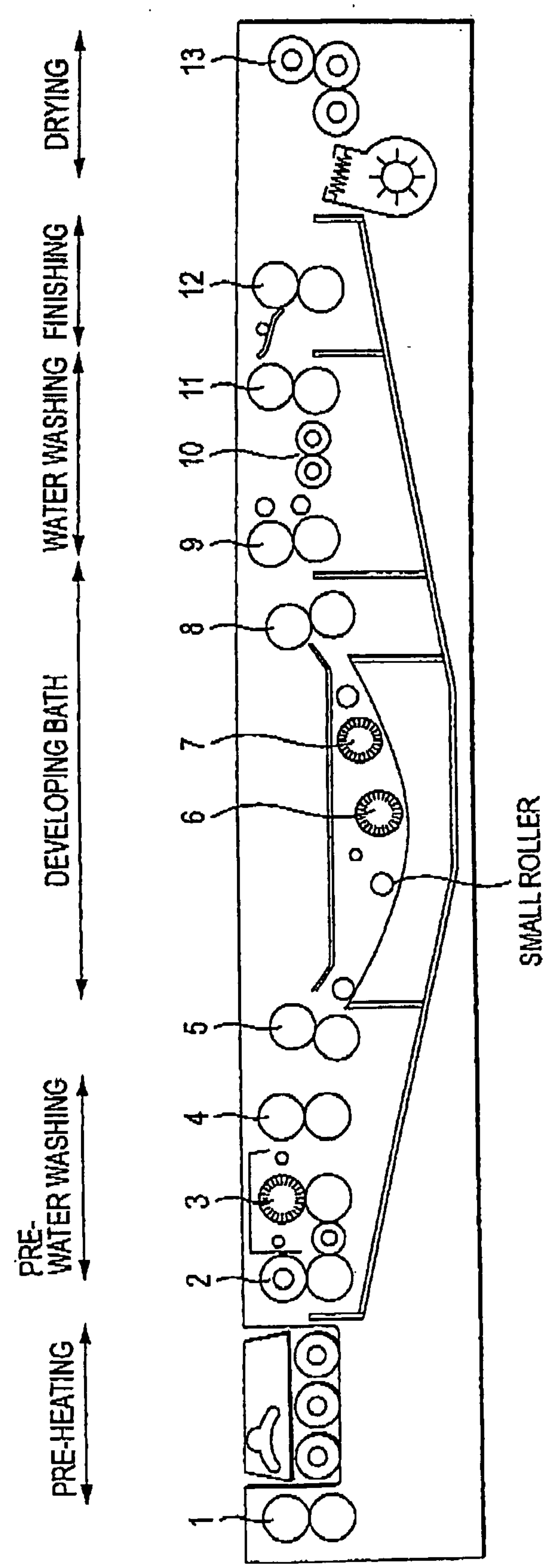
PRE-HEATING
PRE-WATER WASHING
DEVELOPING BATH
WATER WASHING
FINISHING
DRYING
1
2
3
4
5
6
7
8
9
10
11
12
13
SMALL ROLLER

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 4708925 A
- JP 8276558 A
- US 2850445 A
- JP 4420189 B
- JP 2938397 B
- JP 2000211262 A
- JP 2001277740 A
- JP 2002029162 A
- JP 2002046361 A
- JP 2002137562 A
- JP 2002326470 A
- WO 2006026229 A
- US 2002051931 A
- EP 1630618 A
- EP 1582347 A
- JP 2007283656 A
- JP 58125246 A
- JP 59084356 A
- JP 60078787 A
- JP 58173696 A
- JP 58181690 A
- JP 58194595 A
- JP 58112793 A
- JP 58224793 A
- JP 59048187 A
- JP 59073996 A
- JP 60052940 A
- JP 60063744 A
- JP 58112792 A
- GB 434875 A
- US 5156938 A
- US 3881924 A
- JP 57142645 A
- US 4327169 A
- JP 58181051 A
- JP 59220143 A
- JP 59041363 A
- JP 59084248 A
- JP 59084249 A
- JP 59146063 A
- JP 59146061 A
- JP 59216146 A
- US 4283475 A
- JP 5013514 B
- JP 5019702 B
- US 4756993 A
- JP 2002278057 A
- JP 2001133969 A
- JP 3296759 A
- JP 59028329 B
- US 3905815 A
- JP 46004605 B
- JP 48036281 A
- JP 53133428 A
- JP 55032070 A
- JP 60239736 A
- JP 61169835 A
- JP 61169837 A
- JP 62058241 A
- JP 62212401 A
- JP 63070243 A
- JP 63298339 A
- JP 8108621 A
- JP 59152396 A
- JP 61151197 A
- JP 63041484 A
- JP 2000249 A
- JP 2004705 A
- JP 5083588 A
- JP 1304453 A
- JP 1152109 A
- JP 6029285 B
- US 3479185 A
- US 4311783 A
- US 4622286 A
- JP 62143044 A
- JP 62150242 A
- JP 9188685 A
- JP 9188686 A
- JP 9188710 A
- JP 2000131837 A
- JP 2002107916 A
- JP 2764769 B
- JP 2002116539 A
- JP 6157623 A
- JP 6175564 A
- JP 6175561 A
- JP 6175554 A
- JP 6175553 A
- JP 6348011 A
- JP 7128785 A
- JP 7140589 A
- JP 7306527 A
- JP 7292014 A
- JP 61166544 A
- JP 2002328465 A
- JP 2000066385 A
- JP 2000080068 A

- US 4069055 A
- JP 4365049 A
- US 4069056 A
- EP 104143 A
- US 339049 A
- US 410201 A
- JP 2150848 A
- JP 2296514 A
- EP 370693 A
- EP 390214 A
- EP 233567 A
- EP 297443 A
- EP 297442 A
- US 4933377 A
- US 161811 A
- US 4760013 A
- US 4734444 A
- US 2833827 A
- DE 2904626
- DE 3604580
- DE 3604581
- JP 2001343742 A
- JP 2002148790 A
- JP 51047334 B
- JP 57196231 A
- JP 59005240 A
- JP 59005241 A
- JP 2226149 A
- JP 1165613 A
- JP 54021726 B
- JP 48041708 B
- JP 51037193 A
- JP 2032293 B
- JP 2016765 B
- JP 58049860 B
- JP 56017654 B
- JP 62039417 B
- JP 62039418 B
- JP 63277653 A
- JP 63260909 A
- JP 1105238 A
- JP 48064183 A
- JP 49043191 B
- JP 52030490 B
- JP 46043946 B
- JP 1040337 B
- JP 1040336 B
- JP 2025493 A
- JP 61022048 A
- JP 9236913 A
- JP 62170950 A
- JP 62226143 A
- JP 60168144 A
- JP 62293247 A
- JP 2002287334 A
- JP 2001277742 A
- US 2800457 A
- US 2800458 A
- US 3287154 A
- JP 3819574 B
- JP 42446 B
- US 3418250 A
- US 3660304 A
- US 3796669 A
- US 3914511 A
- US 4025445 A
- JP 369163 B
- JP 51009079 B
- GB 930422 A
- US 3111407 A
- GB 952807 A
- GB 967074 A
- JP 54063902 A
- JP 2001253181 A
- JP 2001322365 A
- US 2714066 A
- US 3181461 A
- US 3280734 A
- US 3902734 A
- JP 3622063 B
- US 3276868 A
- US 4153461 A
- US 4689272 A
- JP 2001199175 A
- JP 2002079772 A
- JP 10282679 A
- JP 2304441 A
- JP 2005125749 A
- JP 5045885 A
- JP 6035174 A
- US 3458311 A
- JP 55049729 B
- US 292501 A
- US 44563 A
- JP 2220061 A
- JP 60059351 A
- US 5148746 A
- US 5568768 A
- GB 2297719 A
- JP 58159533 A
- JP 3100554 A
- JP B62167253 U

**Non-patent literature cited in the description**

- Colour Index. Saishin Ganyo Binran. Pigment Technology Society of Japan, 1977
- Saishin Ganryo Oyou Giiutsu. CMC Publishing Co., Ltd, 1986

- Insatsu Ink Gijutsu. CMC Publishing Co., Ltd, 1984
- Kinzoku Sekken no Seishitsu to Oyo. **SAIWAI SHOBO.** Insatsu Ink Gijutsu. CMC Publishing Co., Ltd, 1984
- Saishin Ganryo Oyo Gijutsu. CMC Publishing Co., Ltd, 1986
- **L.G. BROOKER et al.** *J. Am. Chem. Soc.,* 1951, vol. 73, 5326-5358
- **WAKABAYASHI et al.** *Bull. Chem. Soc. Japan,* 1969, vol. 42, 2924
- **M. P. HUTT.** *Journal of Heterocyclic Chemistry,* 1970, vol. 1 (3
- **MARTIN KUNZ.** *Rad Tech '98, Proceeding,* 19 April 1998
- *J. C. S. Perkin II,* 1979, 1653-1660
- *J. C. S. Perkin II,* 1979, 156-162
- *Journal of Photopolymer Science and Technology,* 1995, 202-232
- **S. I. SCHLESINGER.** *Photogr. Sci. End.,* 1974, vol. 18, 387
- **T. S. BAL et al.** *Polymer,* 1980, vol. 21, 423
- **J.V. CRIVELLO et al.** *Macromolecules,* 1977, vol. 10 (6), 1307
- **J.V. CRIVELLO et al.** *J. Polymer Sci., Polymer Chem. Ed.,* 1979, vol. 17, 1047
- **C.S. WEN et al.** *Teh. Proc. Conf. Rad. Curing ASIA,* October 1988, 478
- **NIPPON.** *Secchaku Kyokaishi,* 1984, vol. 20 (7), 300-308